# EUROPEAN PATENT APPLICATION

(11) **EP 4 064 330 A1**
(43) Date of publication of application: **28.09.2022**
(21) Application number: 19953592.3
(22) Date of filing: 21.11.2019
(51) Int. Cl.: H01L 21/52, H01L 21/60, H01L 21/67, H05K 13/00, H05K 13/04

(54) **COMPONENT MOUNTING SYSTEM, COMPONENT FEEDER, AND COMPONENT MOUNTING METHOD**

(71) Applicant: Bondtech Co., Ltd., Minami-ku Kyoto-shi Kyoto 6018366 (JP)
(72) Inventor: YAMAUCHI, Akira, Kyoto-shi, Kyoto 601-8366 (JP)
(74) Representative: Rüger Abel Patentanwälte PartGmbB
(86) International application number: PCT/JP2019/045704
(87) International publication number: WO 2021/100185

(57) **Abstract**

A chip mounting system (1) includes: a chip feeder (11) to feed a chip (CP); a head (33H) having a chip support (432a) disposed at a tip portion of the head (33H); a first chip transporter (51) to transport the chip (CP) to a transfer position (Pos1) with a first chip holder (512) holding the chip (CP); and a support driver (432b) to transfer the chip (CP) from the first chip holder (512) to the head (33H) by moving the chip support (432a) to the vertically upper side of the first chip holder (512) with the first chip holder (512), which holds the chip (CP), located at the transfer position (PosI) and a central portion of the chip (CP) supported by the chip support (432a).

## Description

### Technical Field

The present disclosure relates to a component mounting system, a component feeding device, and a component mounting method.

### Background Art

Methods in which a stage to hold a wiring board and a bonder arranged directly above the stage are provided and a chip is bonded to the wiring board by lowering the bonder with the chip held on a head of the bonder have been proposed (see, for example, Patent Literature 1). In addition, methods of, by subjecting bonding surfaces of two objects to be bonded to plasma treatment and thereafter bringing the bonding surfaces into contact with each other, bonding the bonding surfaces of the two objects to be bonded to each other have also been proposed (see, for example, Patent Literature 2). Further, methods of, by subjecting a bonding surface of a chip, the bonding surface being to be bonded to a wiring board, to plasma treatment and thereafter bringing the bonding surface of the chip into contact with the wiring board, bonding the chip to the wiring board have been provided.

### Citation List

### Patent Literature

Patent Literature 1: Unexamined Japanese Patent Application Publication No. 2012-238775
Patent Literature 2: Unexamined Japanese Patent Application Publication (Translation of PCT Application) No. 2003-523627

### Summary of Invention

### Technical Problem

In the afore-described methods, when foreign objects adhere to a bonding surface of a chip or the bonding surface is damaged at the time of bonding the chip on a wiring board, a bonding defect between the chip and the wiring board is caused to occur. Therefore, when a chip the bonding surface of which was subjected to plasma treatment is transported to a head of a bonder, preventing adherence of foreign objects to the bonding surface of the chip and damage to the bonding surface of the chip caused by contact of, for example, a transportation jig or performing particle cleaning on the bonding surface of the chip are needed. In addition, since an activated bonding surface of a chip cannot be touched, a method for transporting a chip without contact with the bonding surface thereof has been required.

The present disclosure has been made in consideration of the above-described conditions, and an objective of the disclosure is to provide a component mounting system, a component feeding device, and a component mounting method that are capable of preventing adherence of foreign objects to a bonding surface of a component and damage to the bonding surface of the chip.

### Solution to Problem

In order to achieve the above-described objective, a component mounting system according to the present disclosure is
a component mounting system to mount a component on a wiring board and includes:
a component feeder to feed the component;
a head to hold, at a tip portion of the head, an opposite side to a bonding surface side of the component, the bonding surface being to be bonded to a mounting surface of the wiring board;
a first component transporter including a first component holder to hold, in a non-contact manner, the bonding surface side of the component fed from the component feeder and configured to, with the first component holder holding the component, transport the component to a transfer position at which the component is transferred to the head;
a wiring board holder to hold the wiring board; and
a head driver to mount the component on the mounting surface by, with the component, which has been transferred from the first component transporter, held at a tip portion of the head, moving the head relatively in a first direction, the first direction pointing from the head to the wiring board holder, and bringing a bonding surface of the component into contact with the mounting surface of the wiring board.

A component mounting method according to another aspect of the present disclosure is
a component mounting method for mounting a component on a wiring board and includes:
a step of feeding the component;
a step of, with the component held by a first component holder to hold a bonding surface side of the fed component in a non-contact manner, the bonding surface being to be bonded to a mounting surface of the wiring board, transporting the first component holder to a transfer position at which the component is transferred to a head; and
a step of mounting the component on the mounting surface by, with the component, which has been transferred to the head, held at a tip portion of the head, moving the head relatively in a first direction, the first direction pointing from the head to a wiring board holder holding the wiring board, and bringing a bonding surface of the component into contact with the mounting surface of the wiring board.

### Advantageous Effects of Invention

According to a component mounting system and a component mounting method according to the present disclosure, a component is transported to a transfer position at which the component is transferred to a head, with a first component holder, which holds the bonding surface side of a fed component in a non-contact manner, holding the component. Since this configuration enables a component to be transported without contact with the surface-activated bonding surface of the component and adherence of foreign objects to the bonding surface of the component and damage to the bonding surface of the component due to contact with the bonding surface of the component to be prevented, occurrence of a bonding defect between a component and a wiring board is prevented.

### Brief Description of Drawings

FIG. 1 is a schematic configuration diagram of a chip mounting system according to Embodiment 1 of the present disclosure;
FIG. 2 is a schematic plan view of a first chip holder of a chip transporter according to Embodiment 1;
FIGS. 3A and 3B are a schematic front view of a head according to Embodiment 1 and a schematic plan view of the head according to Embodiment 1, respectively;
FIGS. 4A and 4B are a diagram illustrating a manner in which a chip is fed from a chip feeder in the chip mounting system according to Embodiment 1 and a diagram illustrating a manner in which the chip transporter has received the chip from the chip feeder in the chip mounting system according to Embodiment 1, respectively;
FIGS. 5A and 5B are a diagram illustrating a manner in which the chip transporter transports the chip to a transfer position in the chip mounting system according to Embodiment 1 and a diagram illustrating a manner in which the chip is transferred from the chip transporter to the head in the chip mounting system according to Embodiment 1, respectively;
FIGS. 6A and 6B are diagram illustrating a manner in which the chip is transferred from the chip transporter to the head according to Embodiment 1 and a diagram illustrating a manner in which the chip is held by the head according to Embodiment 1, respectively;
FIG. 7 is a diagram illustrating a manner in which a chip mounting process is performed in the bonding device according to Embodiment 1;
FIG. 8 is a schematic configuration diagram of a chip mounting system according to Embodiment 2 of the present disclosure;
FIG. 9 is a schematic diagram of an inverter according to Embodiment 2;
FIGS. 10A and 10B are a diagram illustrating a manner in which a second chip transporter receives a chip in a chip feeder according to Embodiment 2 and a diagram illustrating a manner in which the second chip transporter transports the chip in the chip feeder according to Embodiment 2, respectively;
FIGS. 11A and 11B are a diagram illustrating a manner in which the chip is inverted by the inverter in the chip mounting system according to Embodiment 2 and a diagram illustrating a manner in which the chip is transferred from the chip feeder to the first chip transporter in the chip mounting system according to Embodiment 2, respectively;
FIGS. 12A and 12B are a diagram illustrating a manner in which the first chip transporter holds the chip in the chip mounting system according to Embodiment 2 and a diagram illustrating a manner in which the first chip transporter transports the chip to a transfer position in the chip mounting system according to Embodiment 2, respectively;
FIG. 13 is a schematic configuration diagram of a chip mounting system according to Embodiment 3 of the present disclosure;
FIG. 14 is a schematic diagram of a second chip transporter according to Embodiment 3;
FIGS. 15A and 15B are a diagram illustrating a manner in which the second chip transporter receives a chip in a chip feeder according to Embodiment 3 and a diagram illustrating a manner in which the second chip transporter transports the chip in the chip feeder according to Embodiment 3, respectively;
FIGS. 16A and 16B are a diagram illustrating a manner in which the chip is transferred from the chip feeder to a first chip transporter in the chip mounting system according to Embodiment 3 and a diagram illustrating a manner in which the chip has been transferred to the second chip transporter in the chip mounting system according to Embodiment 3, respectively;
FIG. 17 is a diagram illustrating a manner in which the first chip transporter transports the chip in the chip mounting system according to Embodiment 3;
FIG. 18 is a schematic configuration diagram of a chip mounting system according to a variation;
FIG. 19 is a schematic diagram of a head according to the variation;
FIGS. 20A, 20B, and 20C are a schematic front view illustrating a portion of a chip feeder according to the variation, a diagram illustrating a state where a chip is held to an adhesive sheet in the chip feeder according to the variation, and a diagram illustrating a manner in which the chip is detached from the adhesive sheet in the chip feeder according to the variation, respectively;
FIGS. 21A and 21B are a schematic front view illustrating a portion of a chip feeder according to another variation and a diagram illustrating a manner in which a chip is detached from an adhesive sheet in the chip feeder according to the another variation, respectively;
FIGS. 22A and 22B are a schematic front view illustrating a portion of a head of a bonding device according to still another variation and a diagram for a description of operation of the head of the bonding device according to the still another variation, respectively;
FIGS. 23A and 23B are a perspective view of a sheet according to still another variation and a diagram for a description of operation of a chip mounting system in the case where the sheet according to the still another variation is used, respectively;
FIGS. 24A and 24B are a schematic cross-sectional view illustrating a portion of a tray according to still another variation and a diagram illustrating a manner in which a chip is detached from the tray according to the still another variation, respectively;
FIGS. 25A and 25B are a schematic cross-sectional view illustrating a portion of a tray according to still another variation and a diagram illustrating a manner in which a chip is detached from the tray according to the still another variation, respectively;
FIG. 26 is a schematic plan view of a chip mounting system according to still another variation;
FIG. 27 is a cross-sectional view of a portion of a first chip transporter according to the still another variation;
FIG. 28 is a schematic side view of the chip mounting system according to the still another variation;
FIG. 29 is diagrams illustrating a manner in which a chip is fed from a chip feeder in the chip mounting system according to the still another variation, and FIGS. 29A and 29B are a schematic plan view and a schematic side view, respectively;
FIGS. 30A and 30B are a schematic plan view illustrating a manner in which a chip holder has been moved to a position vertically directly above a cleaner in the chip mounting system according to the still another variation and a schematic plan view illustrating a manner in which a chip stage is moved to a position vertically directly below a cleaning head in the chip mounting system according to the still another variation, respectively;
FIG. 31 is diagrams illustrating a manner in which the chip is handed over from a chip transporter to a head in the chip mounting system according to the still another variation, and FIGS. 31A and 31B are a schematic plan view and a schematic side view, respectively;
FIG. 32 is a schematic plan view illustrating a manner in which a chip is handed over from the chip transporter to a chip collector in the chip mounting system according to the still another variation;
FIG. 33 is a schematic configuration diagram of a portion of a chip feeder according to still another variation;
FIGS. 34A, 34B, and 34C are a schematic perspective view of a portion of a chip feeder according to still another variation, a schematic perspective view of a portion of a chip feeder according to still another variation, and a schematic plan view of a portion of the chip feeder illustrated in FIG. 34B, respectively;
FIG. 35 illustrates a portion of the chip feeder according to the still another variation, and FIGS. 35A and 35B are a schematic cross-sectional view illustrating a state where tip portions of chip support plates of a pickup mechanism are pressed against a sheet on which chips are stuck and a schematic cross-sectional view illustrating a manner in which the tip portions of the chip support plates of the pickup mechanism scrape the sheet on which the chips are stuck, respectively;
FIG. 36 illustrates a portion of the chip feeder according to the still another variation, and FIGS. 36A and 36B are a schematic cross-sectional view illustrating a manner in which the pickup mechanism sucks the sheet on which the chips are stuck and a schematic cross-sectional view illustrating a manner in which the pickup mechanism transfers a chip to a Bernoulli chuck, respectively;
FIG. 37 illustrates a portion of the chip feeder according to the still another variation, and FIGS. 37A and 37B are a schematic cross-sectional view illustrating a state where tip portions of chip support pins of a pickup mechanism are pressed against a sheet on which chips are stuck and a schematic cross-sectional view illustrating a manner in which the pickup mechanism presses tip portions of separation pins against the sheet on which the chips are stuck, respectively;
FIG. 38 illustrates a portion of the chip feeder according to the still another variation, and FIGS. 38A and 38B are a schematic cross-sectional view illustrating a manner in which the pickup mechanism sucks the sheet on which the chips are stuck and a schematic cross-sectional view illustrating a manner in which the pickup mechanism transfers a chip to a Bernoulli chuck, respectively;
FIGS. 39A, 39B, and 39C are a schematic perspective view of a portion of a chip feeder according to still another variation, a schematic plan view of heads of chip support plates according to the still another variation, and a schematic plan view of the heads when the chip support plates according to the still another variation come close to each other, respectively;
FIGS. 40A and 40B are a schematic cross-sectional view illustrating a manner in which tip portions of the chip support plates of a pickup mechanism according to the still another variation scrape a sheet on which chips are stuck and an enlarged view of the tip portions of the chip support plates in FIG. 40A, respectively;
FIG. 41 illustrates a portion of a chip feeder according to still another variation, and FIGS. 41A and 41B are a schematic cross-sectional view illustrating a manner in which tip portions of separation members of a pickup mechanism are brought close to a sheet on which chips are stuck and a schematic cross-sectional view illustrating a manner in which the separation members of the pickup mechanism scrape the sheet on which the chips are stuck, respectively;
FIG. 42 illustrates a portion of the chip feeder according to the still another variation, and FIGS. 42A and 42B are a schematic cross-sectional view illustrating a manner in which the separation members of the pickup mechanism are moved away from the sheet on which the chips are stuck and a schematic cross-sectional view illustrating a manner in which the pickup mechanism transfers a chip to a Bernoulli chuck, respectively;
FIGS. 43A and 43B are a plan view illustrating a Bernoulli chuck and guides according to still another variation and a plan view illustrating a Bernoulli chuck and guides according to still another variation, respectively;
FIG. 44 is a schematic cross-sectional view illustrating a portion of a Bernoulli chuck and a chip feeder according to still another variation; and
FIG. 45 is a partially broken schematic side view of a non-contact chuck according to still another variation.

### Description of Embodiments

### Embodiment 1

A chip mounting system that is a component mounting system according to an embodiment of the present disclosure is described below, referring to the drawings.

The chip mounting system according to the present embodiment is a system to mount a component on a wiring board. Examples of the component include a semiconductor chip (hereinafter, simply referred to as "chip") supplied from a diced substrate. Conventionally, it has been difficult to prevent particle contamination into a bonding interface at the time of bonding of a chip and a wiring board. Therefore, it has been difficult to bond the whole of a surface of a chip to a wiring board, and influence of particles on bonding has been attempted to be reduced by forming a gap by use of solder bumps, incorporating particles into solder, or the like. However, in the method using solder bumps, there is a lower limit for the size of solder bumps and it has therefore been necessary to set pitch between electrodes formed on the wiring board to approximately 50 µm. In contrast, in a method of, for example, surface-bonding electrodes and an insulator layer, which are formed on a bonding surface, on an identical surface without using a bump, the afore-described electrode pitch can be reduced to several µm, and the use of this method is therefore preferable. In the case where, as described above, no bump is formed on a side to be bonded of a chip and the chip is bonded by bringing the bonding surface thereof into surface contact with a mounting surface of a wiring board, the chip mounting system according to the present embodiment is particularly effective. On the other hand, in a method of surface-activating at least a bonding surface of a chip and thereafter bonding the chip, the method does not allow the bonding surface of the chip to be touched, and particles mounted on the bonding surface may become a cause of generating a void because the method is a method of performing bonding in the solid phase. In the surface activated bonding method, after activation of a bonding surface of a chip through Ar irradiation of, for example, Au or Cu existing on the bonding surface, the chip is bonded in the atmosphere at room temperature or low temperature. In a hydrophilic bonding method, a chip is bonded by temporarily bonding a mounting surface of a wiring board and a bonding surface of the chip to each other by, after hydrophilizing the bonding surface of the chip by subjecting the bonding surface to plasma treatment, bringing the mounting surface and the bonding surface into contact with each other, and thereafter changing the temporary bond to a rigid covalent bond by performing heat treatment. The chip mounting system according to the present embodiment is also suitable for a case where, when, for example, an insulator and Cu electrodes exist on a bonding surface of a chip, the bonding surface is planarized by subjecting the bonding surface to CMP polishing and thereafter the bonding surface is surface-bonded. The chip mounting system according to the present embodiment is capable of transporting a chip to a head of a bonding device without contact with the bonding surface of the chip and preventing adherence of particles to the bonding surface of the chip and a mounting surface of a wiring board. As used herein, the "mounting surface of a wiring board" means a surface on which a chip is mounted.

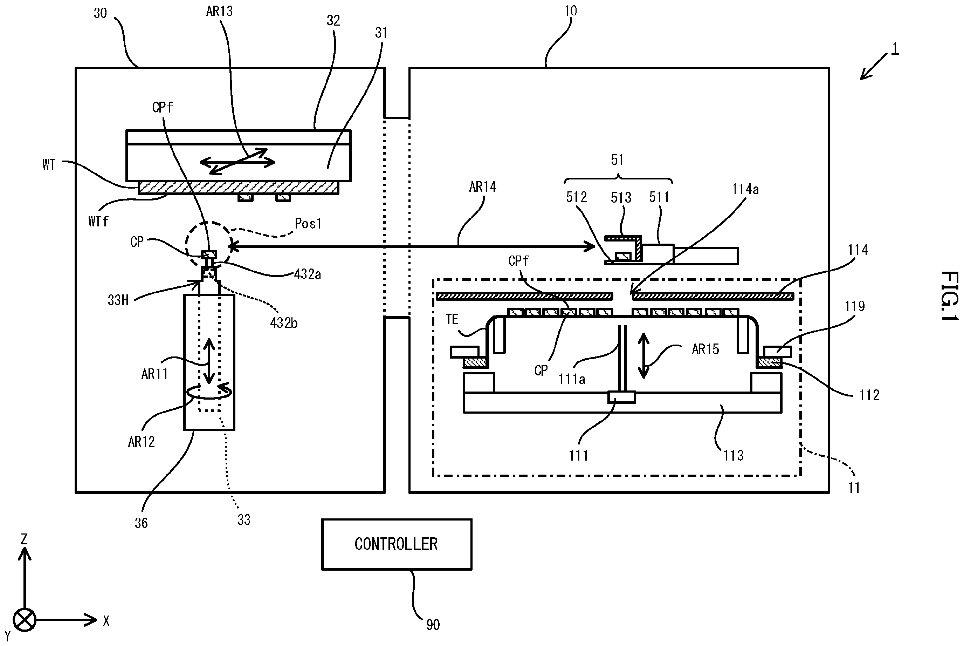

As illustrated in FIG. 1, a chip mounting system 1 according to the present embodiment includes a chip feeding device 10, a bonding device 30, and a controller 90. Note that the following description is made assuming that the ±Z-directions and an XY-direction in FIG. 1 are the vertical direction and a horizontal direction, respectively. The chip feeding device 10 is a component feeding device that acquires a chip CP from among a plurality of chips CP stuck on a sheet TE, which is held by a sheet holding frame 112, and feeds the bonding device 30 with the acquired chip CP. In this configuration, for example, an adhesive sheet that holds a plurality of chips CP on one surface side having adhesion can be employed as the sheet TE. The chip feeding device 10 includes a chip feeder 11 and a first chip transporter 51 to transport a chip CP fed from the chip feeder 11 to a head 33H of the bonding device 30, which is described later.

The chip feeder 11 is a component feeder that includes a frame holder 119 to hold the sheet holding frame 112, a pickup mechanism 111 to pick up a chip CP from among a plurality of chips CP, and a cover 114. The chip feeder 11 also includes a holding frame driver 113 to drive the sheet holding frame 112 in an XY direction or in a rotational direction about the Z-axis. The frame holder 119 holds the sheet holding frame 112 in such an attitude that a surface of the sheet TE on which the plurality of chips CP are stuck faces the verticallyupper (+Z-direction) side. The sheet holding frame 112 and the frame holder 119 constitute a sheet holder that holds the sheet TE, which is stuck on the opposite side to the bonding surface CPf side of each of the plurality of chips CP, in such an attitude that the bonding surfaces CPf face the vertically upper side, which is a first direction side.

The pickup mechanism 111 brings one chip CP among the plurality of chips CP into a state of being detached from the sheet TE by cutting out (pushing out) the one chip CP from the opposite side to the side of the sheet TE on which the plurality of chips CP are stuck. In this processing, the pick-up mechanism 111 cuts out the chip CP while holding a peripheral portion of the opposite side to the bonding surface CPf side of the chip CP, the peripheral portion, which is a third part, being different from a central portion, which is a first part, of the opposite side that is to be held by the head 33H, which is described later. Note that the third part may be the same as the first part. The pickup mechanism 111 includes needles 111a and is configured to be movable in the vertical direction, as illustrated by an arrow AR15 in FIG. 1. The cover 114 is arranged to cover the vertically upper side of the plurality of chips CP and has a hole 114a disposed at a portion facing the pick-up mechanism 111. The needles 111a are, for example, provided in a number of four. However, the number of the needles 111a may be three or five or more. The pickup mechanism 111 feeds a chip CP by sticking the needles 111a into the sheet TE from the vertically lower (-Z-direction) side of the sheet TE and raising the chip CP vertically upward (+Z-direction). The respective chips CP stuck on the sheet TE are pushed out to the upper side of the cover 114 through the hole 114a of the cover 114 one by one by the needles 111a and handed over to the first chip transporter 51. The holding frame driver 113 changes the position of the chip CP located vertically directly below the needles 111a by driving the sheet holding frame 112 in an XY direction or a rotational direction about the Z-axis.

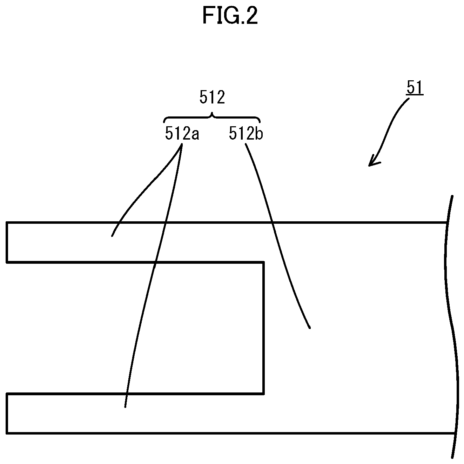

The first chip transporter 51 is a first component transporter that transports a chip CP fed from the chip feeder 11 to a transfer position Pos1 at which the chip CP is to be transferred to the head 33H. The first chip transporter 51 includes a main body 511, a first chip holder 512, which is a first component holder, and a chip cover 513. The main body 511 moves the first chip holder 512 between a preset standby position and the transfer position Pos1, as illustrated by an arrow AR14 in FIG. 1. The first chip holder 512 includes a main piece 512b and two leg pieces 512a extending from the main piece 512b in the same direction, as illustrated in, for example, FIG. 2. In this configuration, interval between the two leg pieces 512a is set to be shorter than a minimum width in plan view of a chip CP. The first chip holder 512 holds a peripheral portion, which is a second part, of a chip CP with the chip CP suspended between the two leg pieces 512a. Returning to FIG. 1, the chip cover 513 is a component cover that is disposed on the first chip holder 512 and that covers the bonding surface CPf side of the chip CP with the first chip holder 512 holding the chip CP.

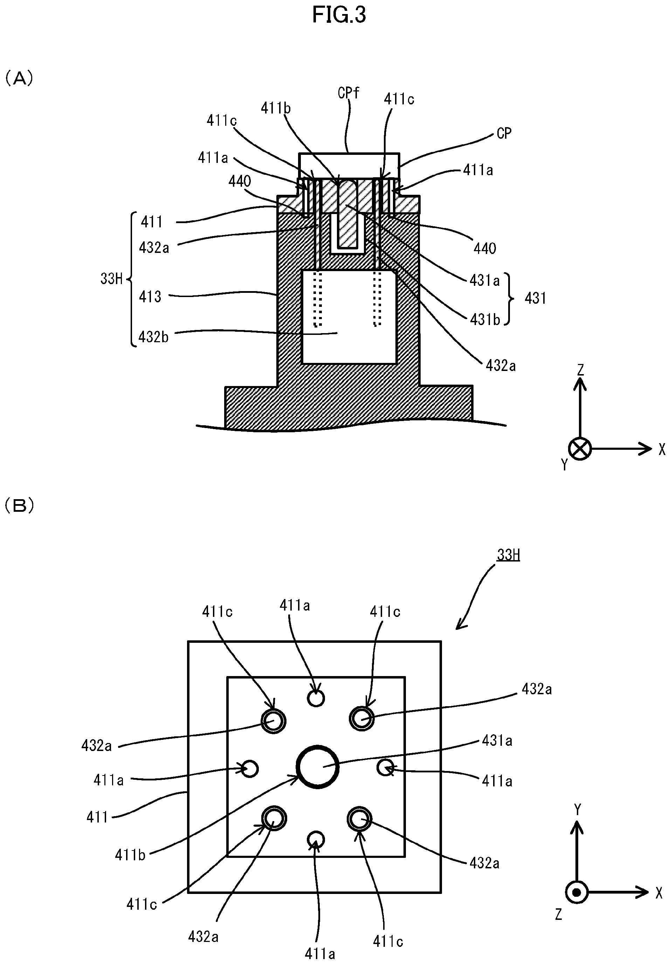

The bonding device 30 includes a stage 31, a bonder 33 including the head 33H, and a head driver 36 to drive the head 33H. The head 33H includes a chip tool 411, a head body 413, chip supports 432a, and a support driver 432b, as illustrated in, for example, FIG. 3A. The chip tool 411 is formed of, for example, silicon (Si). The head body 413 includes holding mechanisms 440 including suckers to cause a chip CP to be sucked and held to the chip tool 411 and a pressing mechanism 431 to press a central portion of the chip CP. The holding mechanisms 440 hold a peripheral portion of a chip CP via the chip tool 411. The pressing mechanism 431 includes a pressing rod 431a that is movable in the vertical direction at a central portion of a tip surface of the head body 413 and that is configured to press a central portion of the chip CP vertically upward and a pressing driver 431b to drive the pressing rod 431a. The head body 413 also includes suckers (not illustrated) to fix the chip tool 411 to the head body 413 by means of vacuum suction. When the pressing driver 431b moves the pressing rod 431a vertically upward with the peripheral portion of the chip CP held to the chip tool 411, the central portion of the chip CP is pressed vertically upward (+Z-direction) and the chip CP is brought into a state where the central portion thereof bends and protrudes to the vertically upper side than the peripheral portion thereof. The chip tool 411 includes through-holes 411a formed at positions corresponding to the holding mechanisms 440 of the head body 413, a through-hole 411b into the inside of which the pressing rod 431a is inserted, and through-holes 411c into the insides of which the chip supports 432a are inserted.

The chip supports 432a are component supports that have, for example, pin-like shapes, are disposed at a tip portion of the head 33H, and are freely movable in the vertical direction. The chip supports 432a support the central portion, which is the first part, of the opposite side to the bonding surface CPf side of a chip CP. As illustrated in, for example, FIG. 3B, the chip supports 432a are disposed in a number of four in such a manner as to surround the pressing rod 431a.

The support driver 432b drives the chip supports 432a in the vertical direction. The support driver 432b moves the chip supports 432a to the vertically upper side of the first chip holder 512 with the first chip holder 512, which is holding a chip CP, located at the transfer position Pos1 and the central portion of the chip CP supported by the chip supports 432a. This movement causes the chip CP to be transferred from the first chip holder 512 of the first chip transporter 51 to the head 33H.

Returning to FIG. 1, the head driver 36 drives the bonder 33 in the Z-axis direction (see an arrow AR11 in FIG. 1) and also rotationally drives the bonder 33 about a rotation axis along the Z-axis direction (see an arrow AR12 in FIG. 1). The head driver 36 brings the head 33H, which is holding a chip CP received from the first chip transporter 51, close to the stage 31 by moving the head 33H vertically upward (+Z-direction) and mounts the chip CP on a mounting surface WTf of a wiring board WT. On this occasion, the mounting surface WTf of the wiring board WT and the bonding surface CPf of the chip CP have been hydrophilized by being subjected to plasma treatment, as described afore. Thus, bringing the bonding surface CPf of the chip CP into contact with the mounting surface WTf of the wiring board WT causes the chip CP to be bonded to the wiring board WT through so-called hydrophilic bonding.

The stage 31 is a wiring board holder that holds a wiring board WT in such an attitude that the mounting surface WTf of the wiring board WT, on which a chip CP is mounted, faces vertically downward (-Z-direction). The stage 31 is driven in the X-direction and the Y-direction by a stage driver 32 (see arrows AR13 in FIG. 1). This configuration enables a relative positional relationship between the bonder 33 and the stage 31 to be changed and a mounting position of each chip CP on the wiring board WT to be thereby adjusted.

The controller 90 includes, for example, a micro processing unit (MPU), a main storage, an auxiliary storage, an interface, and a bus connecting the components to one another and controls the head driver 36, the stage driver 32, the holding mechanism 440, and the pressing mechanism 431 of the bonding device 30 and the chip feeder 11 and the first chip transporter 51 of the chip feeding device 10. The MPU of the controller 90, by reading programs stored in the auxiliary storage into the main storage and executing the programs, respectively outputs control signals to the head driver 36, the stage driver 32, the holding mechanism 440, the pressing mechanism 431, the chip feeder 11, and the first chip transporter 51 via the interface.

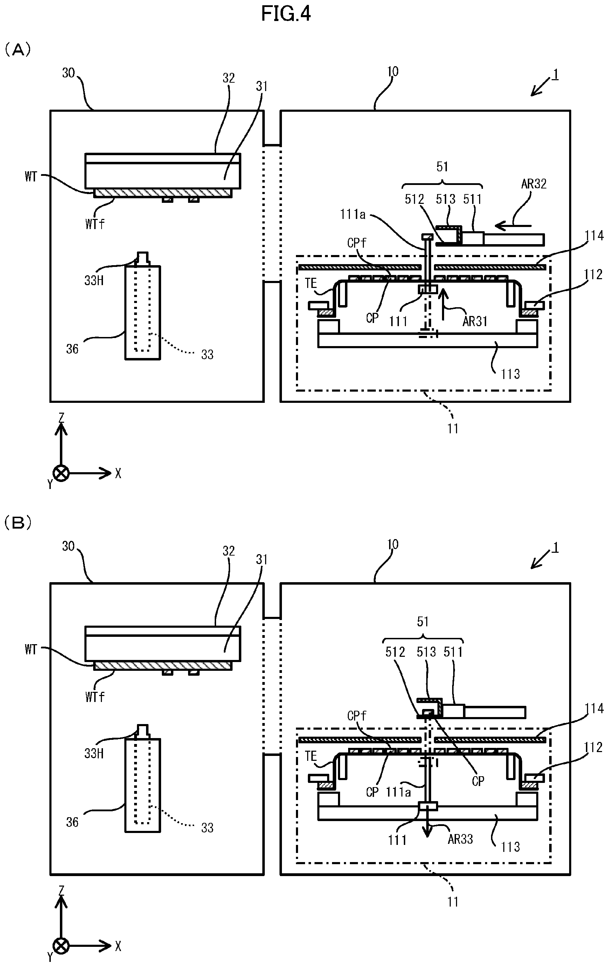

Next, operation of the chip mounting system 1 according to the present embodiment is described, referring to FIGS. 4 to 7. First, in the chip mounting system 1, the pickup mechanism 111, by moving vertically upward, pushes out one chip CP from the opposite side to the side of the sheet TE on which a plurality of chips CP are stuck and brings the one chip CP into a state of being detached from the sheet TE, as illustrated by an arrow AR31 in FIG. 4A. Next, the first chip transporter 51 comes close to the chip CP, which has been pushed out in the vertical direction by the pickup mechanism 111, from a lateral side of the chip CP, as illustrated by an arrow AR32 in FIG. 4A. As a result, the chip feeding device 10 is brought into a state where the needles 111a of the pickup mechanism 111 are arranged between the two leg pieces 512a of the first chip holder 512 (see FIG. 2).

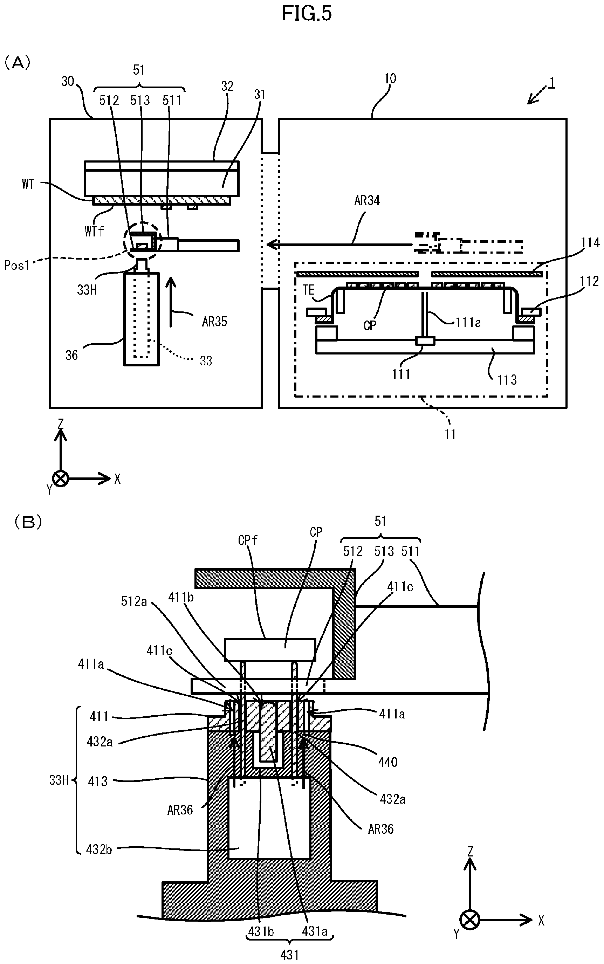

Succeedingly, when the pickup mechanism 111 has moved vertically downward to the standby position, as illustrated by an arrow AR33 in FIG. 4B, the chip feeding device 10 is brought into a state where the chip CP is held by the first chip holder 512, as illustrated in FIG. 4B. Subsequently, the first chip transporter 51 moves the first chip holder 512 to the transfer position Pos1, at which the chip CP is transferred to the head 33H, as illustrated by an arrow AR34 in FIG. 5A. After the first chip holder 512 has been moved to the transfer position Pos1, the head driver 36 moves the bonder 33 vertically upward and brings the head 33H close to the first chip holder 512, as illustrated by an arrow AR35 in FIG. 5A.

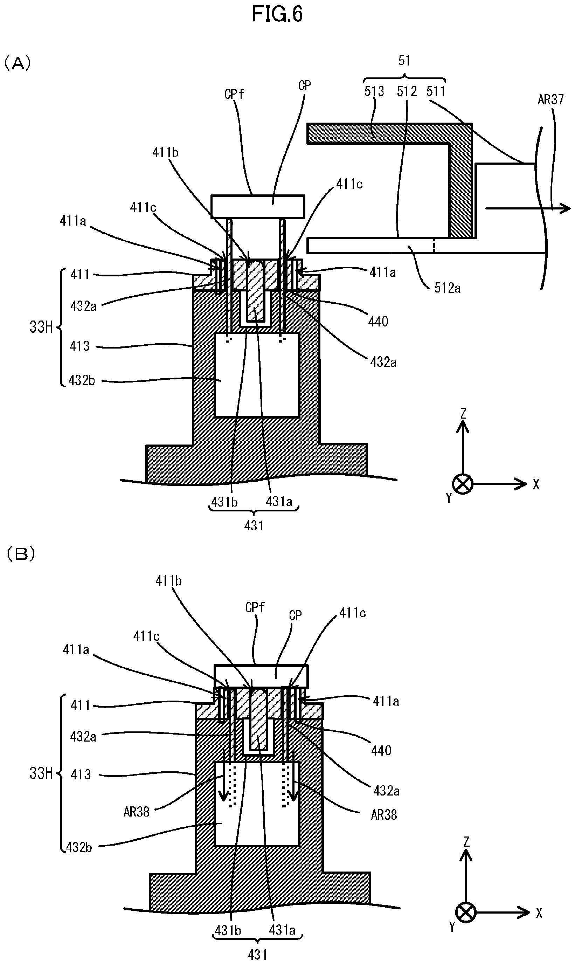

Next, the support driver 432b moves the chip supports 432a vertically upward, as illustrated by arrows AR36 in FIG. 5B. This movement causes the chip CP held by the first chip holder 512 to be arranged on the vertically upper side of the first chip holder 512 while being supported on the top ends of the chip supports 432a. Succeedingly, the first chip transporter 51 moves the first chip holder 512 to a lateral side of the chip CP, as illustrated by an arrow AR37 in FIG. 6A. Subsequently, the support driver 432b moves the chip supports 432a vertically downward, as illustrated by arrows AR38 in FIG. 6B. The holding mechanism 440 sucks the peripheral portion of the chip CP to the chip tool 411. This processing brings the chip CP into a state of being held on the tip portion of the head 33H. As described above, after the chip CP has been transferred to the tip portion of the head 33H, the chip CP is in a state of being held by the head 33H also at a part other than the central portion, which is the first part, of the opposite side to the bonding surface CPf side of the chip CP.

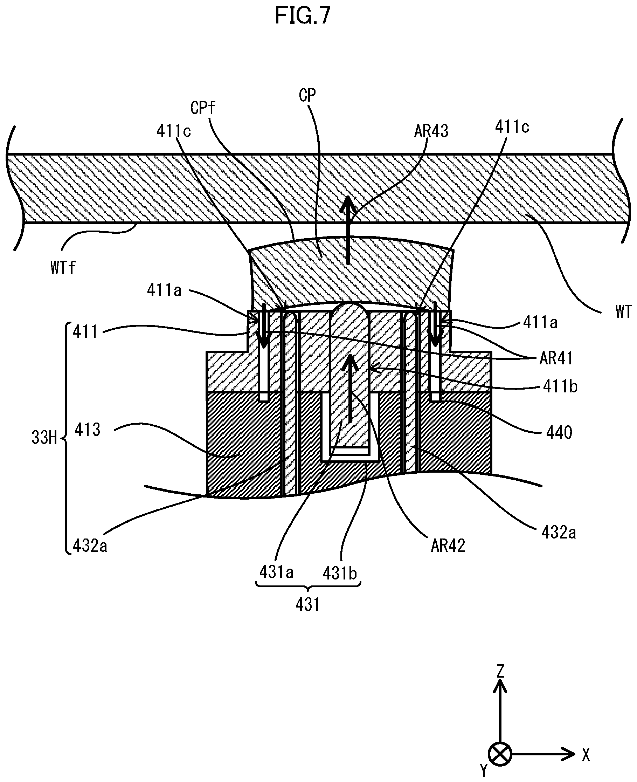

Next, the chip mounting system 1, by driving the stage 31 and also rotating the bonder 33, performs alignment to correct relative misalignment between the chip CP and the wiring board WT. Succeedingly, the chip mounting system 1, by causing the head 33H to ascend, mounts the chip CP on the wiring board WT. On this occasion, the bonding device 30 presses the central portion of the chip CP by driving the pressing rod 431a vertically upward as illustrated by an arrow AR42 in FIG. 7 with the peripheral portion of the chip CP sucked and held to the chip tool 411 by the holding mechanisms 440 as illustrated by arrows AR41 in FIG. 7. As a result, the chip CP is brought into a state of being bent in such a manner that the central portion of the chip CP protrudes to the mounting surface WTf side of the wiring board WT compared with the peripheral portion of the chip CP, as illustrated by an arrow AR43 in FIG. 7. The head driver 36, by bringing the head 33H close to the wiring board WT with the chip CP bent as illustrated in FIG. 7, brings the central portion of the chip CP into contact with the mounting surface WTf of the wiring board WT. Subsequently, the bonding device 30, by bringing the head 33H closer to the wiring board WT while causing the pressing rod 431a to retract vertically downward, enlarges contact area between the wiring board WT and the chip CP. The head driver 36, after bringing the peripheral portion of the chip CP into contact with the mounting surface of the wiring board WT by bringing the head 33H closer to the mounting surface WTf of the wiring board WT, bonds the entire bonding surface CPf of the chip CP to the mounting surface WTf of the wiring board WT by pressing the head 33H toward the wiring board WT side. Note that the bonding device 30 may first bring the head 33H close to a preset distance from the wiring board WT by moving the head 33H in the vertical direction and thereafter bring the central portion of the chip CP into contact with the mounting surface WTf of the wiring board WT by causing the chip CP to be bent. In this case, it may also be configured such that, subsequently, the bonding device 30, by bringing the head 33H closer to the wiring board WT while causing the pressing rod 431a to retract vertically downward, brings the peripheral portion of the chip CP into contact with the mounting surface of the wiring board WT while enlarging contact area between the wiring board WT and the chip CP and thereafter bonds the entire bonding surface CPf of the chip CP to the mounting surface WTf of the wiring board WT by pressing the head 33H toward the wiring board WT side. As a result, advancing bonding from a central portion of the bonding surface CPf of a chip CP enables a void caused by drawing-in of air into an interspace between the wiring board WT and the chip CP in the atmosphere to be prevented from occurring.

As described in the foregoing, according to the chip mounting system 1 according to the present embodiment, a chip CP is transported to the transfer position Pos1 with the chip CP held by the first chip holder 512, which holds a peripheral portion of the opposite side to the bonding surface CPf side of a fed chip CP. Since this configuration enables the chip CP to be transported without contact with the bonding surface CPf of the chip CP, adherence of foreign objects onto the bonding surface CPf of the chip CP and damage to the bonding surface CPf of the chip CP can be prevented. In addition, since the first chip transporter 51 transports a chip CP with the bonding surface CPf of the chip CP facing vertically downward, it is possible to prevent foreign objects (for example, particles) from falling on the bonding surface CPf of the chip CP. Therefore, occurrence of a bonding defect between a chip CP and a wiring board WT can be prevented.

When so-called bump bonding, in which a chip CP is bonded to a wiring board WT with bumps interposed therebetween, is performed, a portion other than the bumps within a surface of the chip CP on which the bumps are formed can be handled. On the other hand, when the so-called hydrophilic bonding, in which, after the bonding surface CPf of the chip CP has been subjected to hydrophilic treatment, the chip CP is bonded to the wiring board WT by bringing the bonding surface CPf of the chip CP into contact with the mounting surface WTf of the wiring board WT, is performed, the bonding surface CPf side of the chip CP cannot be handled. In contrast, since, as described afore, the chip mounting system 1 according to the present embodiment is capable of transporting a chip CP without contact with the bonding surface CPf of the chip CP, the chip mounting system 1 is advantageous in the case where the chip CP is bonded to the wiring board WT by means of the so-called hydrophilic bonding.

In addition, the first chip transporter 51 according to the present embodiment includes the chip cover 513, which covers the bonding surface CPf side of a chip CP held by the first chip holder 512. Since this configuration enables foreign objects to be prevented from adhering to the bonding surface CPf of the chip CP during transportation of the chip CP by the first chip transporter 51, occurrence of a bonding defect between the chip CP and the wiring board WT is prevented. The cover 114 according to the present embodiment is arranged to cover a space vertically above a plurality of chips CP. Therefore, adherence of particles onto the bonding surface CPf of each of the plurality of chips CP held to the sheet TE is prevented.

Further, according to the chip mounting system 1 according to the present embodiment, the sheet holding frame 112 and the frame holder 119 hold the sheet TE, which is stuck on the opposite side to the bonding surface CPf side of each of the plurality of chips CP, in such an attitude that the bonding surfaces CPf face vertically upward. Since this configuration makes unnecessary a mechanism to invert the direction that the bonding surface CPf of a chip CP faces, there is an advantage that the configuration of the chip feeder 11 is simplified accordingly.

In addition, the head 33H according to the present embodiment includes the pressing mechanism 431, which, by pressing a central portion of a chip CP, causes the chip CP to be bent in such a way that a central portion of the bonding surface CPf of the chip CP protrudes to the mounting surface WTf side of the wiring board WT compared with a peripheral portion of the bonding surface CPf of the chip CP. Since this configuration enables drawing-in of air into an interspace between the the chip CP and the wiring board WT to be prevented, it is possible to bond the chip CP to the wiring board WT excellently.

Further, in the chip feeder 11 according to the present embodiment, an adhesive sheet can be employed as the sheet TE to hold chips CP. In this case, since a chip CP becomes less likely to relatively move with respect to the sheet TE even when an external force is applied to the sheet TE, adjacent chips CP held to the sheet TE are prevented from coming into contact with each other. Therefore, there is an advantage that damage to chips CP and generation of particles from the chips CP in the case where an external force is applied to the sheet TE are prevented.

In addition, according to the chip mounting system 1 according to the present embodiment, the stage 31 holds a wiring board WT in such an attitude that the mounting surface, on which a chip CP is mounted, of the wiring board WT faces vertically downward. Since this configuration enables adherence of particles onto the mounting surface of the wiring board WT to be reduced, occurrence of a bonding defect between the chip CP and the wiring board WT can be prevented.

### Embodiment 2

A chip mounting system 2 of the present embodiment differs from Embodiment 1 in that a chip feeder holds a sheet TE, on which the opposite side to a bonding surface CPf side of each of a plurality of chips CP is stuck, in such an attitude that the bonding surfaces CPf face in the direction toward the vertically lower side, which is a second direction.

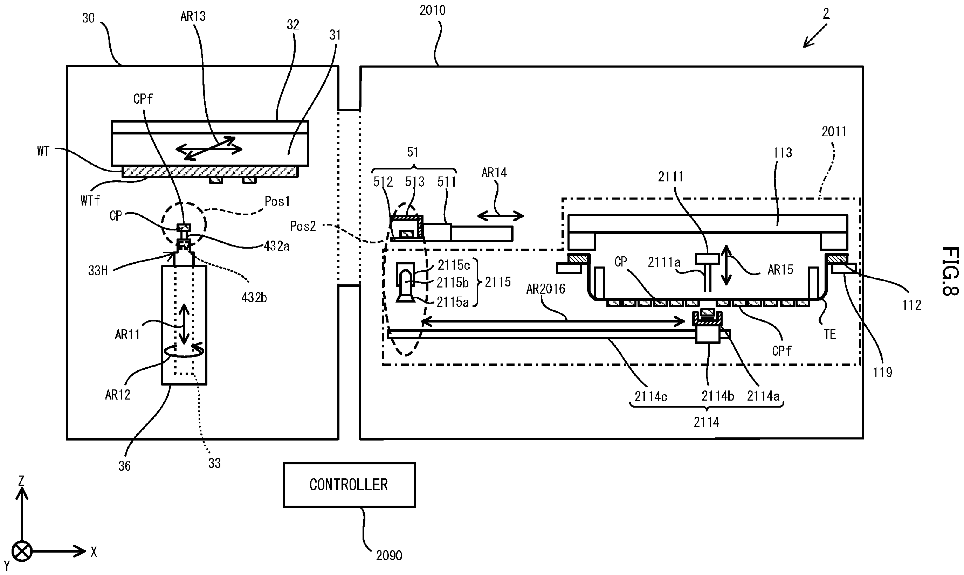

As illustrated in FIG. 8, the chip mounting system 2 according to the present embodiment includes a chip feeding device 2010, a bonding device 30, and a controller 2090. Note that, in FIG. 8, the same reference signs as those in FIG. 1 are assigned to the same constituent components as those in Embodiment 1. The chip feeding device 2010 includes a chip feeder 2011 and a first chip transporter 51. The chip feeder 2011 includes a frame holder 119 to hold a sheet holding frame 112, a pickup mechanism 2111 to pick up a chip CP from among a plurality of chips CP, a second chip transporter 2114, and an inverter 2115. The chip feeder 2011 also includes a holding frame driver 113 to drive the sheet holding frame 112 in an XY direction or in a rotational direction about the Z-axis. The frame holder 119 holds the sheet holding frame 112 in such an attitude that a surface of the sheet TE on which the plurality of chips CP are stuck faces the vertically lower (-Z-direction) side. The sheet holding frame 112 and the frame holder 119 constitute a sheet holder that holds the sheet TE, which is stuck on the opposite side to the bonding surface CPf side of each of the plurality of chips CP, in such an attitude that the bonding surfaces CPf face the vertically lower side, which is the second direction side.

The pickup mechanism 2111 includes needles 2111a and is configured to be movable in the vertical direction, as illustrated by an arrow AR15 in FIG. 8. The needles 2111a are, for example, provided in a number of four. However, the number of the needles 2111a may be three or five or more. The pickup mechanism 2111 feeds a chip CP by sticking the needles 2111a into the sheet TE from the vertically upper (+Z-direction) side of the sheet TE and cutting out (pushing out) the chip CP vertically downward (-Z-direction). The respective chips CP stuck on the sheet TE are pushed out vertically downward by the needles 2111a and handed over to the second chip transporter 2114.

The second chip transporter 2114 is a second component transporter that includes a second chip holder 2114a, a guide rail 2114c, and a sliding body 2114b to which the second chip holder 2114a is fixed, the sliding body 2114b being configured to slide on the guide rail 2114c. The second chip holder 2114a is a second component holder, which is a Bernoulli chuck, that holds a chip CP, which is pushed out by the pickup mechanism 2111, in a non-contact state with the bonding surface CPf of the chip CP. The Bernoulli chuck is a chuck that, by generating negative pressure on the inside thereof and also discharging gas to the outside thereof, holds a chip CP in a non-contact manner with a gas layer formed between the Bernoulli chuck and the chip CP. The second chip transporter 2114 also includes a sliding body driver (not illustrated) to move the sliding body 2114b along the guide rail 2114c as illustrated by an arrow 2016 in FIG. 8. The second chip transporter 2114 transports the second chip holder 2114a to a receipt position Pos2 of the first chip transporter 51 with the second chip holder 2114a holding a chip CP.

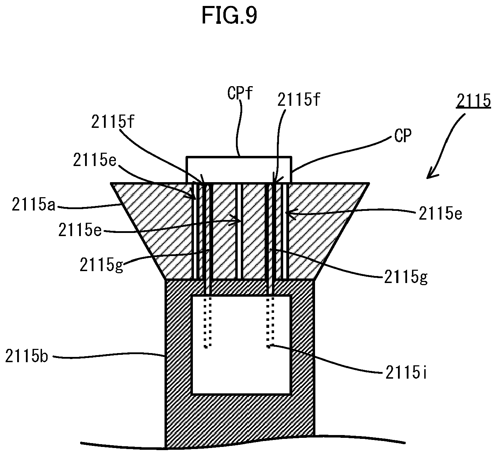

The inverter 2115 holds the opposite side to the bonding surface CPf side of a chip CP held by the second chip holder 2114a and inverts the chip CP in such a way that the chip CP comes to have such an attitude that the bonding surface CPf faces vertically upward. The inverter 2115 includes a suction head 2115a, an arm 2115b to the tip portion of which the suction head 2115a is fixed, and an arm driver 2551c to turn or move in the vertical direction the arm 2115b. The inverter 2115 also includes chip supports 2115g, a support driver 2115i, and suckers 2115e to suck and hold a chip CP, as illustrated in, for example, FIG. 9. At portions of the suction head 2115a corresponding to the respective chip supports 2115g, through-holes 2115f into the insides of which the chip supports 2115g are inserted are formed. The respective chip supports 2115g have, for example, pin-like shapes and are freely movable in the vertical direction. The chip supports 2115g are, for example, provided in a number of four. However, the number of the chip supports 2115g may be three or five or more. The support driver 2115i drives the chip supports 2115g in the vertical direction.

The first chip transporter 51 transports a chip CP fed from the chip feeder 2011 at the receipt position Pos2 to a transfer position Pos1 at which the chip CP is to be transferred to the head 33H. The controller 2090 is similar to the controller 90, which was described in Embodiment 1, and controls the chip feeder 2011 and the first chip transporter 51 in the chip feeding device 2010.

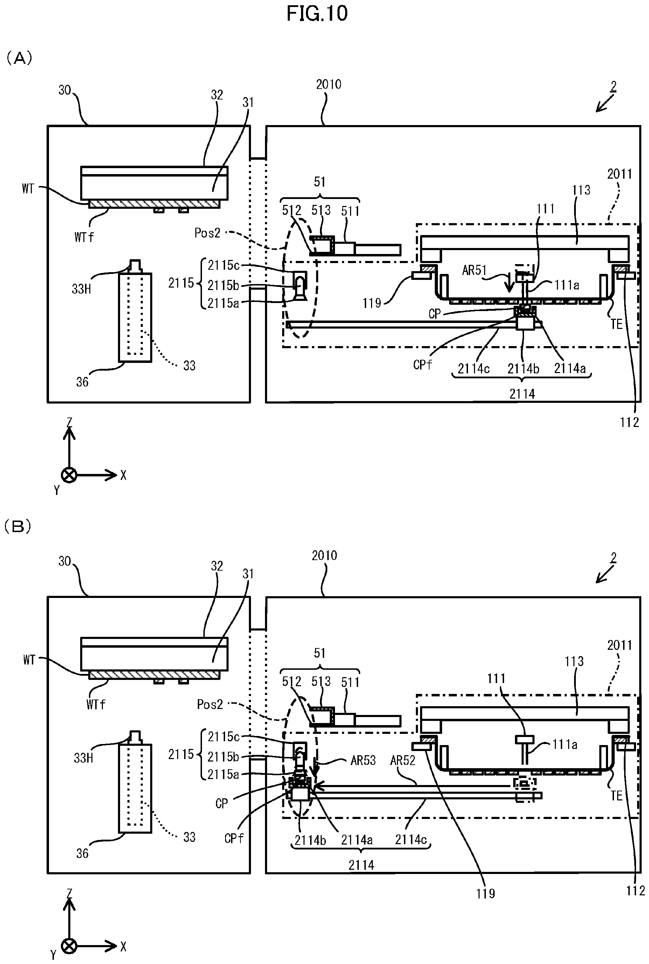

Next, operation of the chip mounting system 2 according to the present embodiment is described, referring to FIGS. 10 to 12. First, in the chip mounting system 2, the pickup mechanism 2111, by moving vertically downward, pushes out one chip CP from the opposite side to the side of the sheet TE on which a plurality of chips CP are stuck, and detaches the one chip CP from the sheet TE and hands over the one chip CP to the second chip transporter 2114, as illustrated by an arrow AR51 in FIG. 10A. On this occasion, the second chip transporter 2114 holds the handed-over chip CP by use of the second chip holder 2114a in a non-contact state with the bonding surface CPf of the chip CP.

Next, the second chip transporter 2114 transports the second chip holder 2114a, which is holding the chip CP, to a position facing the inverter 2115 in the vertical direction, as illustrated by an arrow AR52 in FIG. 10B. Succeedingly, when the second chip holder 2114a has been transported to the position facing the inverter 2115, the arm driver 2115c of the inverter 2115 moves the arm 2115b vertically downward, as illustrated by an arrow AR53 in FIG. 10B. The suction head 2115a sucks and holds the opposite side to the bonding surface CPf side of the chip CP, which is held by the second chip holder 2114a.

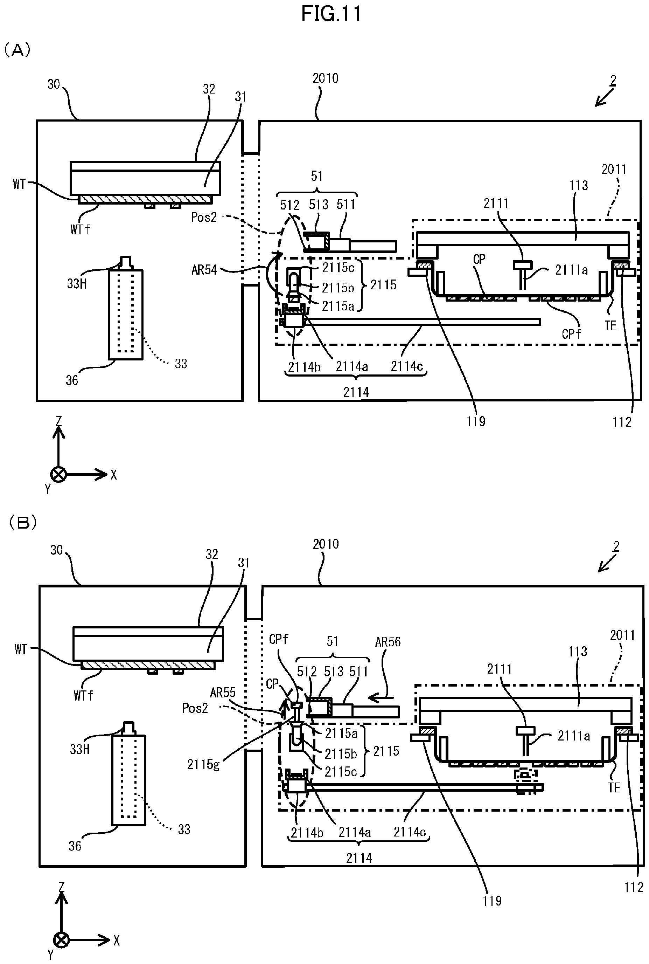

Subsequently, the arm driver 2551c moves the arm 2115b vertically upward with the chip CP sucked and held by the suction head 2115a. Next, the arm driver 2551c turns the arm 2115b, as illustrated by an arrow AR54 in FIG. 11A. As a result, the inverter 2115 is brought into a state of holding the chip CP in such an attitude that the bonding surface CPf of the chip CP faces vertically upward. Succeedingly, the inverter 2115 stops the suction head 2115a from sucking the chip CP. Subsequently, the support driver 2115i, by moving the chip supports 2115g vertically upward, pushes out the chip CP vertically upward from the suction head 2115a, as illustrated by an arrow AR55 in FIG. 11B. Next, the first chip transporter 51 comes close to the chip CP, which has been pushed out vertically upward by the chip supports 2115g, from a lateral direction of the chip CP, as illustrated by an arrow AR56 in FIG. 11B. As a result, the first chip transporter 51 and the inverter 2115 are brought into a state where the chip supports 2115g are arranged between two leg pieces 512a of the first chip holder 512 (see FIG. 2).

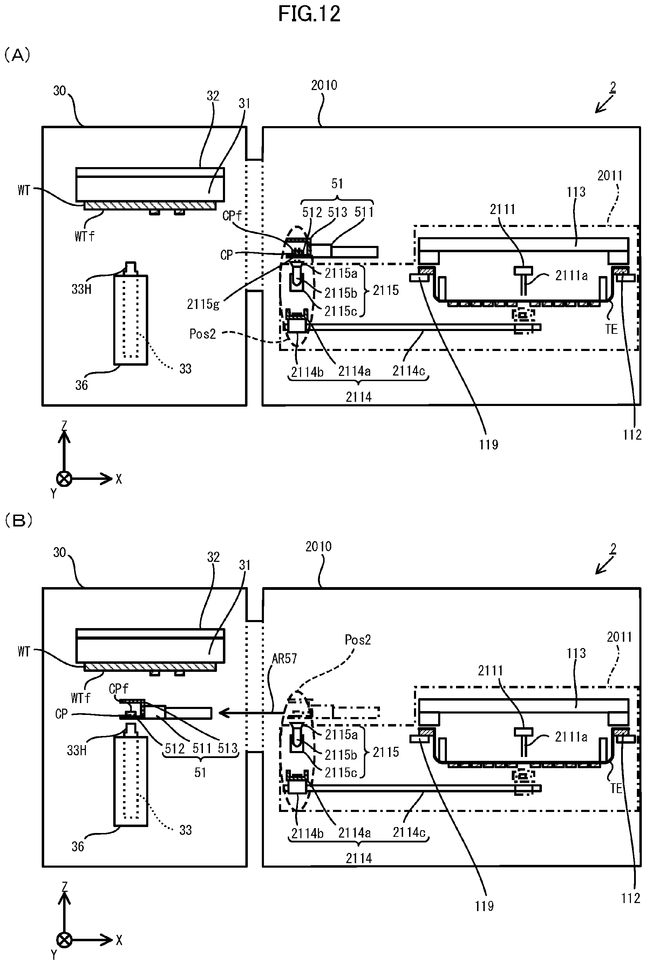

Succeedingly, when the support driver 2115i has moved the chip supports 2115g vertically downward to a standby position, the first chip transporter 51 is brought into a state where the chip CP is held by the first chip holder 512, as illustrated in FIG. 12A. Subsequently, the first chip transporter 51 moves the first chip holder 512 to the transfer position Pos1, at which the chip CP is to be transferred to the head 33H, as illustrated by an arrow AR57 in FIG. 12B. The succeeding operations of the chip mounting system 2 are the same as those in Embodiment 1.

As described in the foregoing, since the chip mounting system 2 according to the present embodiment is, as with the chip mounting system 1 according to Embodiment 1, capable of transporting a chip CP without contact with the bonding surface CPf of the chip CP, adherence of foreign objects onto the bonding surface CPf of the chip CP or damage to the bonding surface CPf of the chip CP can be prevented. In addition, since the first chip transporter 51 transports a chip CP with the bonding surface CPf of the chip CP facing vertically downward, it is possible to prevent foreign objects from falling on the bonding surface CPf of the chip CP. Therefore, occurrence of a bonding defect between a chip CP and a wiring board WT can be prevented. Further, according to the chip mounting system 2 according to the present embodiment, the sheet holding frame 112 and the frame holder 119 hold the sheet TE, which is stuck on the opposite side to the bonding surface CPf side of each of the plurality of chips CP, in such an attitude that the bonding surfaces CPf face vertically downward. Since, when a plurality of chips CP is held to the sheet TE, this configuration enables foreign objects to be prevented from adhering to the bonding surfaces CPf of the chips CP, occurrence of a bonding defect between a chip CP and a wiring board WT can be prevented.

### Embodiment 3

A chip mounting system 3 of the present embodiment differs from Embodiment 1 in that a chip feeder holds a sheet TE, on which a bonding surface CPf side of each of a plurality of chips CP is stuck, in such an attitude that the bonding surfaces CPf face vertically upward.

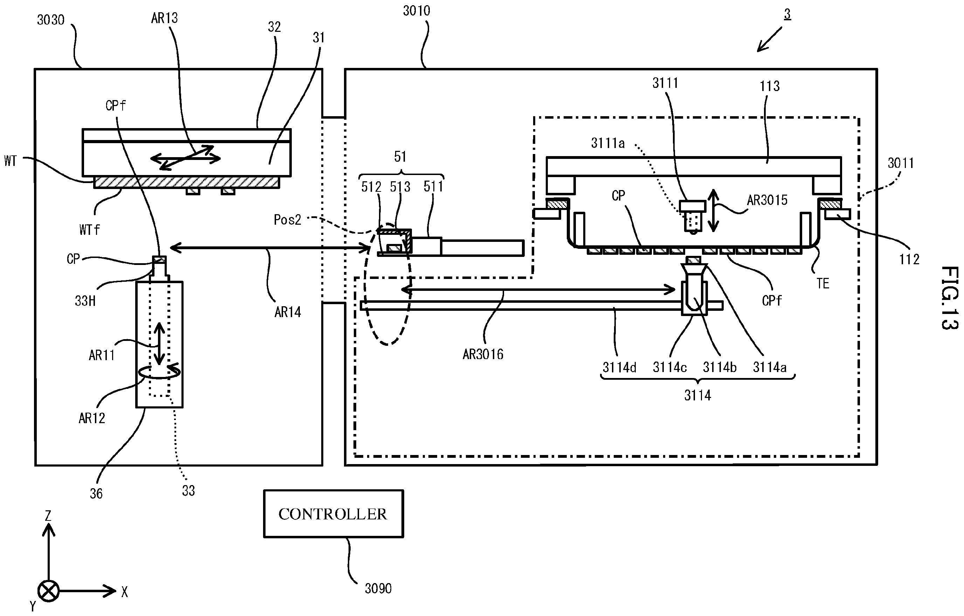

As illustrated in FIG. 13, the chip mounting system 3 according to the present embodiment includes a chip feeding device 3010, a bonding device 3030, and a controller 3090. Note that, in FIG. 13, the same reference signs as those in FIGS. 1 and 8 are assigned to the same constituent components as those in Embodiments 1 and 2. The chip feeding device 3010 includes a chip feeder 3011 and a first chip transporter 51. The chip feeder 3011 includes a frame holder 119 to hold a sheet holding frame 112, a pickup mechanism 3111 to pick up a chip CP from among a plurality of chips CP, and a third chip transporter 3114. The chip feeder 3011 also includes a holding frame driver 113 to drive the sheet holding frame 112 in an XY direction or in a rotational direction about the Z-axis. The frame holder 119 holds the sheet holding frame 112 in such an attitude that a surface of the sheet TE on which the plurality of chips CP isstuck faces the vertically lower (-Z-direction) side. The sheet holding frame 112 and the frame holder 119 constitute a sheet holder that holds the sheet TE, on which the bonding surface CPf side of each of the plurality of chips CP is stuck, in such an attitude that the bonding surfaces CPf of the chips CP face the vertically upper side, which is a first direction side. In addition, when the sheet TE is an adhesive sheet, an adhesive sheet that, when a chip CP is separated from the adhesive sheet, does not allow impurities to be left on a portion of the chip CP that has been stuck to the adhesive sheet is preferable as the adhesive sheet of which the sheet TE is made.

The pickup mechanism 3111 includes needles 3111a and is configured to be movable in the vertical direction, as illustrated by an arrow AR3015 in FIG. 13. The pickup mechanism 3111 feeds a chip CP by poking out the needles 3111a vertically downward (-Z-direction) from the vertically upper (+Z-direction) side of the sheet TE and thereby pushing out the chip CP vertically downward (-Z-direction). The respective chips CP stuck on the sheet TE are pushed out downward by the needles 3111a one by one and handed over to the third chip transporter 3114.

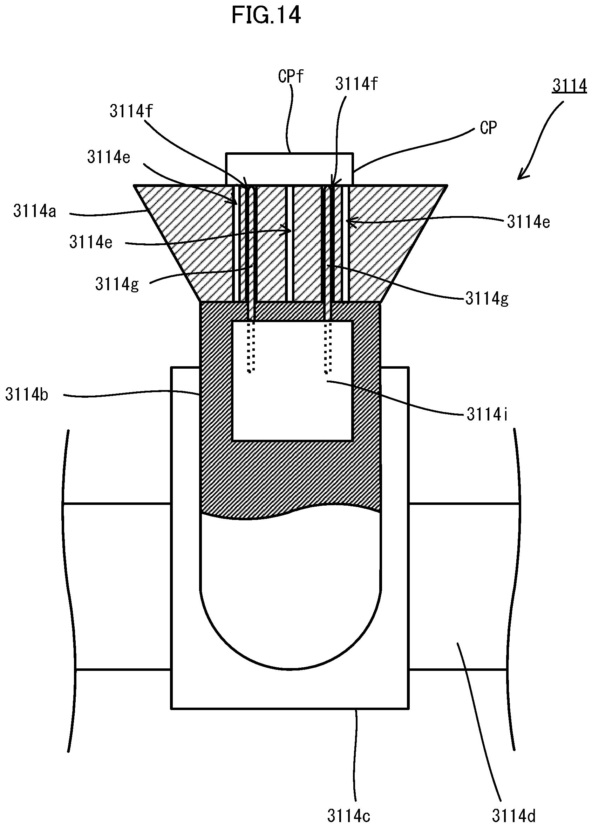

The third chip transporter 3114 is a third component transporter that includes a third chip holder 3114a, an arm 3114b, a guide rail 3114d, and a sliding body 3114c to support the arm 3114b in a freely turnable manner and slide on the guide rail 3114d. The third chip holder 3114a is a third component holder that is disposed at one end of the arm 3114b and sucks and holds the opposite side to the bonding surface CPf side of a chip CP, which is pushed out by the pickup mechanism 3111. The third chip holder 3114a and the arm 3114b include chip supports 3114g, a support driver 3114i, and suckers 3114e to suck and hold a chip CP, as illustrated in FIG. 14. In the third chip holder 3114a, through-holes 3114f into the insides of which the chip supports 3114g are inserted are formed. The chip supports 3114g have, for example, pin-like shapes and are freely movable in the vertical direction. The chip supports 3114g are, for example, provided in a number of four. However, the number of the chip supports 3114g may be three or five or more. The support driver 3114i drives the chip supports 3114g in the vertical direction. The sliding body 3114c includes an arm driver (not illustrated) to turn one end of the arm 3114b at which the third chip holder 3114a is disposed with the other end of the arm 3114b as a fulcrum. The third chip transporter 3114 also includes a sliding body driver (not illustrated) to move the sliding body 3114c along the guide rail 3114d as illustrated by an arrow 3016 in FIG. 13. The third chip transporter 3114 moves the third chip holder 3114a to a receipt position Pos2 of the first chip transporter 51 with the third chip holder 3114a holding a chip CP.

The first chip transporter 51 transports a chip CP fed from the chip feeder 3011 at the receipt position Pos2 to a transfer position Pos1 at which the chip CP is to be transferred to a head 33H. The controller 3090 is similar to the controller 90, which was described in Embodiment 1, and controls the chip feeder 3011 and the first chip transporter 51 in the chip feeding device 3010.

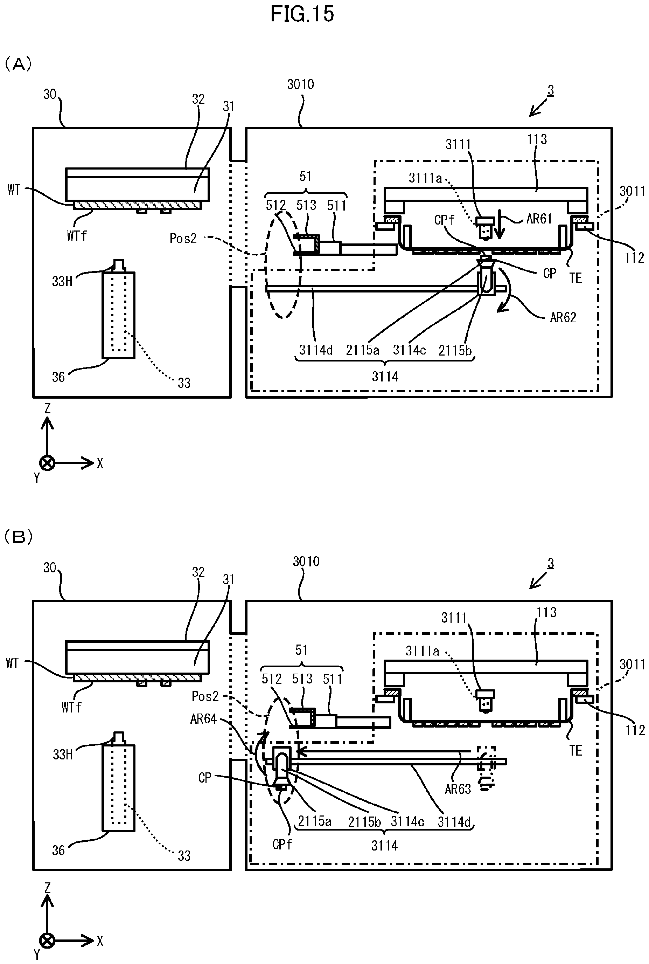

Next, operation of the chip mounting system 3 according to the present embodiment is described, referring to FIGS. 15 to 18. First, in the chip mounting system 3, the pickup mechanism 3111, by moving vertically downward, cuts out (pushes out) one chip CP from the opposite side to the side of the sheet TE on which a plurality of chips CP are stuck, as illustrated by an arrow AR61 in FIG. 15A. On this occasion, the third chip transporter 3114 sucks and holds the pushed-out chip CP while sucking the opposite side to the bonding surface CPf side of the chip CP. Next, after the pickup mechanism 3111 has moved to a standby position, the arm 3114b turns with the chip CP sucked and held by the third chip holder 3114a, as illustrated by an arrow AR62 in FIG. 15A.

Next, the third chip transporter 3114 moves the third chip holder 3114a, which is holding the chip CP, to the receipt position Pos2, as illustrated by an arrow AR63 in FIG. 15B. Succeedingly, when the third chip holder 3114a has been transported to the receipt position Pos2, the arm 3114b turns as illustrated by an arrow AR64 in FIG. 15B.

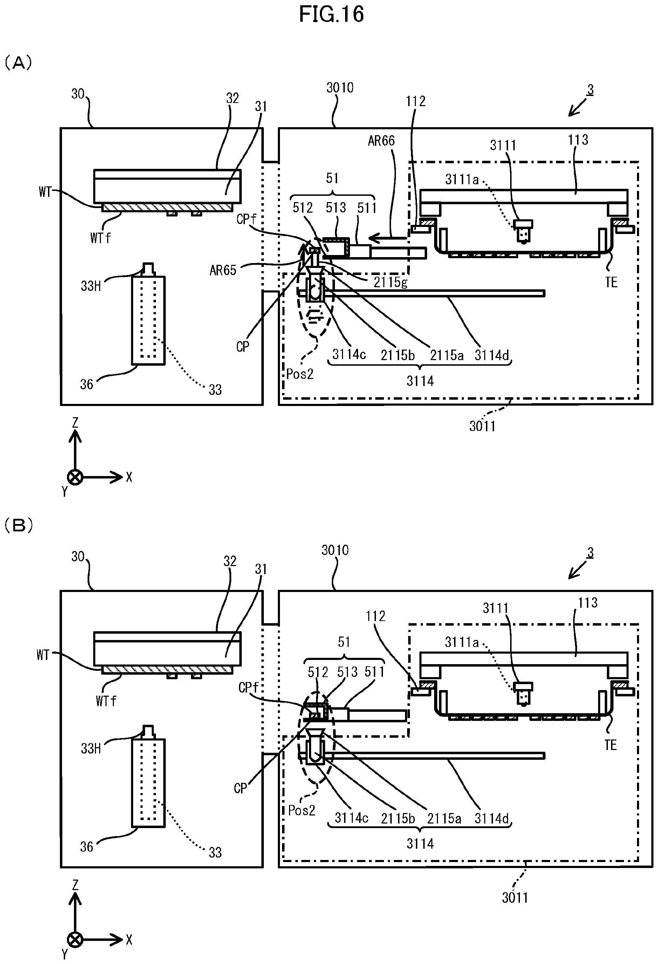

Subsequently, the third chip transporter 3114 stops the third chip holder 3114a from sucking the chip CP. Next, the support driver 3114i, by moving the chip supports 3114g vertically upward, pushes out the chip CP to vertically directly above the third chip holder 3114a, as illustrated by an arrow AR65 in FIG. 16A. Succeedingly, the first chip transporter 51 comes close to the chip CP, which has been pushed out vertically upward by the chip supports 3114g, from a lateral direction of the chip CP, as illustrated by an arrow AR66 in FIG. 16A. As a result, the first chip transporter 51 and the third chip transporter 3114 are brought into a state where chip supports 2115g are arranged between two leg pieces 512a of the first chip holder 512 (see FIG. 2).

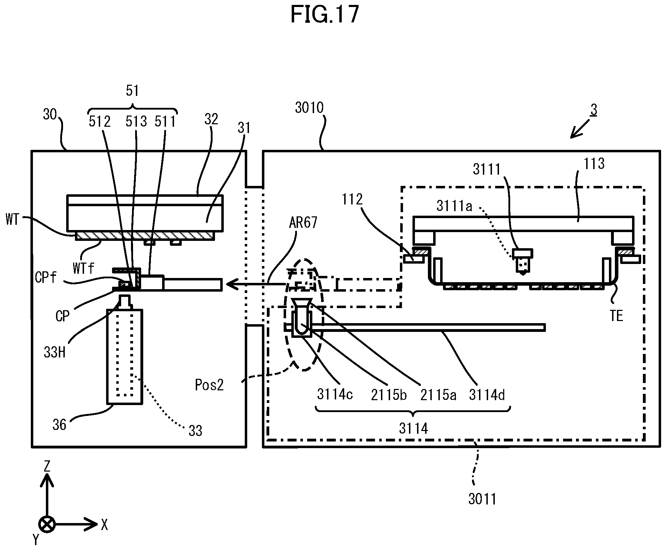

Subsequently, when the support driver 3114i has moved the chip supports 2115g vertically downward to a standby position, the first chip transporter 51 is brought into a state where the chip CP is held by the first chip holder 512, as illustrated in FIG. 16B. Subsequently, the first chip transporter 51 moves the first chip holder 512 to the transfer position Pos1, at which the chip CP is transferred to the head 33H, as illustrated by an arrow AR67 in FIG. 17. The succeeding operations of the chip mounting system 3 are the same as those in Embodiment 1.

As described in the foregoing, since the chip mounting system 3 according to the present embodiment is, as with the chip mounting system 1 according to Embodiment 1, capable of transporting a chip CP without contact with the bonding surface CPf of the chip CP, adherence of foreign objects onto the bonding surface CPf of the chip CP or damage to the bonding surface CPf of the chip CP can be prevented. In addition, since the first chip transporter 51 transports a chip CP with the bonding surface CPf of the chip CP facing vertically downward, it is possible to prevent foreign objects from falling on the bonding surface CPf of the chip CP. Therefore, occurrence of a bonding defect between a chip CP and a wiring board WT can be prevented. In addition, according to the chip mounting system 2 according to the present embodiment, the sheet holding frame 112 and the frame holder 119 hold the sheet, on which the bonding surface CPf side of each of the plurality of chips CP is stuck, in such an attitude that the bonding surfaces CPf face vertically upward. Since, when a plurality of chips CP are held to the sheet TE, this configuration enables foreign objects to be prevented from adhering to the bonding surfaces CPf of the chips CP, occurrence of a bonding defect between a chip CP and a wiring board WT can be prevented.

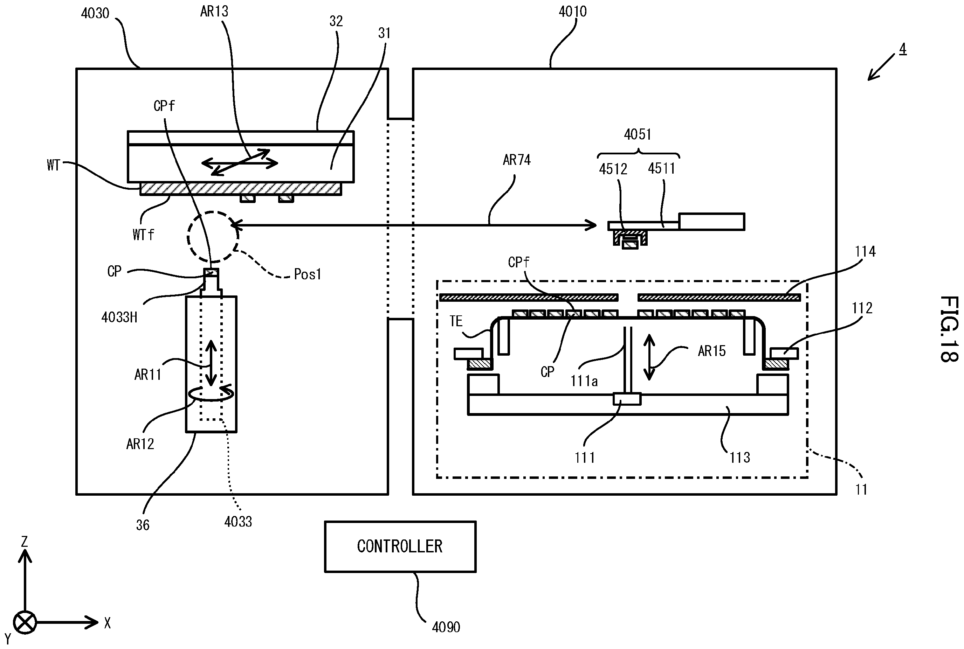

Although the respective embodiments of the present disclosure were described above, the present disclosure is not limited to the configurations of the afore-described embodiments. For example, a chip mounting system according to the present disclosure may be a chip mounting system in which, as in a chip mounting system 4 illustrated in FIG. 18, a first chip transporter 4051 of a chip feeding device 4010 includes a first chip holder 4512, which is a Bernoulli chuck, that holds the bonding surface CPf side of a chip CP, which is fed from the chip feeder 3011, in a non-contact manner. The first chip transporter 4051 includes a main body 4511 and the first chip holder 4512. The first chip holder 4512 holds a chip CP on the vertically lower side thereof. In addition, the main body 4511 moves the first chip holder 4512 between a preset standby position and transfer position Pos1, as illustrated by an arrow AR74 in FIG. 18.

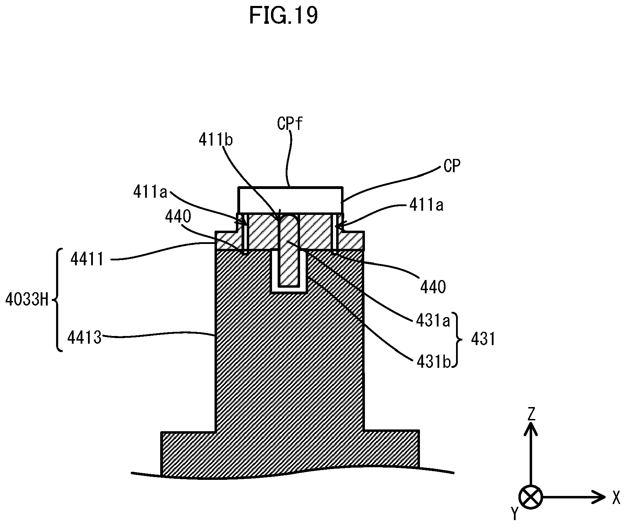

A bonding device 4030 according to the present variation includes a stage 31, a bonder 4033 including a head 4033H, and a head driver 36 to drive the head 4033H. The head 4033H includes a chip tool 4411 and a head body 4413, as illustrated in, for example, FIG. 19. Note that, in FIG. 19, the same reference signs as those in FIG. 3A are assigned to the same constituent components as those in Embodiment 1. Returning to FIG. 18, a controller 4090 is similar to the controller 90, which was described in Embodiment 1, and controls the head driver 36, a stage driver 32, a holding mechanism 440, and a pressing mechanism 431 in the bonding device 4030 and the chip feeder 11 and the first chip transporter 4051 in the chip feeding device 4010.

In the chip mounting system 4 according to the present variation, the first chip transporter 4051 moves the first chip holder 4512, which is holding a chip CP, to the transfer position Pos1, at which the chip CP is to be transferred to the head 33H. The head driver 36 moves the bonder 4033 vertically upward and thereby brings the head 4033H close to the chip CP, which is held by the first chip holder 4512. Next, the head driver 36 moves the head 4033H vertically upward to a position at which a tip portion of the head 4033H comes into contact with the opposite side to the bonding surface CPf side of the chip CP. The holding mechanism 440 sucks the peripheral portion of the chip CP to the chip tool 411. This processing brings the chip CP into a state of being held on the tip portion of the head 33H. The succeeding operations of the chip mounting system 4 are the same as those in Embodiment 1. Note that, in the chip mounting system 4 according to the present variation, an attitude of a chip CP held by the first chip holder 4512, which is a Bernoulli chuck, is not fixed. Thus, in the chip mounting system 4 according to the present variation, the first chip holder 4512 is preferably a chip holder that includes an alignment mechanism (not illustrated) that aligns the attitude of a chip CP before the chip CP is handed over to the head 4033H.

According to the present configuration, a chip CP is transported to the transfer position Pos1, at which the chip CP is transferred to the head 4033H, with the chip CP held by the first chip holder 4512, which is a Bernoulli chuck, that holds the bonding surface CPf side of the chip CP in a non-contact manner. Since this configuration enables the chip CP to be transported without contact with the bonding surface CPf of the chip CP, adherence of foreign objects onto the bonding surface CPf of the chip CP and damage to the bonding surface CPf of the chip CP can be prevented. In addition, since the first chip transporter 51 transports a chip CP with the bonding surface CPf of the chip CP facing vertically downward, it is possible to prevent foreign objects from falling on the bonding surface CPf of the chip CP. Therefore, occurrence of a bonding defect between a chip CP and a wiring board WT can be prevented. In addition, there is an advantage that, since, as the head 4033H, a configuration that includes neither the chip supports 432a nor the support driver 432b, both of which the head 33H according to Embodiment 1 includes, can be employed, the configuration of the head 4033H is simplified.

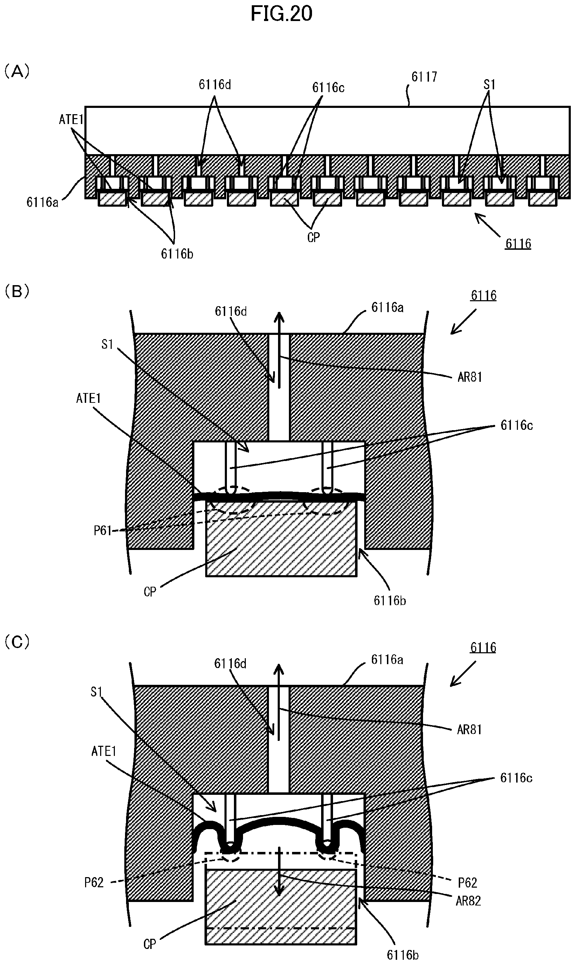

In the respective embodiments, the chip feeder may be a chip feeder that includes a tray 6116 and a sucker 6117 as illustrated in, for example, FIG. 20A. In this configuration, the tray 6116 includes a tray body 6116a on which a plurality of recesses 6116b, inside which chips CP are arranged, is disposed, supports 6116c provided on the bottoms of the recesses 6116b in a protruding manner and having, for example, pin-like shapes, and adhesive sheets ATE1 stretched at positions separated from the bottoms in the recesses 6116b. The supports 6116c are, for example, provided in a number of four for each of the recesses 6116b. However, the number of the supports 6116c may be three for each of the recesses 6116b or five or more for each of the recesses 6116b. Each of the adhesive sheets ATE1 holds a chip CP on a surface having adhesion on the opposite side to the bottom side of one of the recesses 6116b of the tray body 6116a. In this configuration, the chip CP may have the opposite side to the bonding surface CPf stuck on the adhesive sheet ATE1 or the bonding surface CPf side stuck on the adhesive sheet ATE1. In addition, in the bottom of each of the recesses 6116b of the tray body 6116a, a communication hole 6116d communicating with a space S1 formed between the bottom of the recess 6116b and the adhesive sheet ATE1 in the recess 6116b is bored. The sucker 6117 includes a vacuum pump (not illustrated) and, at the time of feeding a chip CP with the chip CP held to an adhesive sheet ATE1, sucks air existing in an afore-described space S1 through a communication hole 6116d in the tray 6116.

The chip feeder according to the present variation, with a chip CP held to an adhesive sheet ATE1, sucks air existing in an afore-described space S1 through a communication hole 6116d in the tray 6116 by the sucker 6117, as illustrated in, for example, FIG. 20B. This processing causes contact area, which is area of contact portions P61 between the adhesive sheet ATE1 and the chip CP, to be reduced. When the chip feeder according to the present variation further sucks the air existing in the afore-described space S1 by the sucker 6117, area of contact portions P62 between the adhesive sheet ATE and the chip CP is further reduced and the chip is detached from the adhesive sheet ATE1, as illustrated in FIG. 20C.

The present configuration has an advantage that, even when a chip CP is not stuck to a sheet TE, the present configuration enables the chip CP to be fed to the bonding device 30 or 4030. In addition, on the tray 6116, each chip CP is stuck to an adhesive sheet ATE1 inside a recess 6116b at a position at which the peripheral portion of the chip CP does not come into contact with an inner wall of the recess 6116b. Since, because of this configuration, the chip CP does not come into contact with the inner wall of the recess 6116b even when vibration is applied to the tray 6116, generation of particles from the chip CP caused by a contact of the chip CP with the inner wall of the recess 6116b can be prevented.

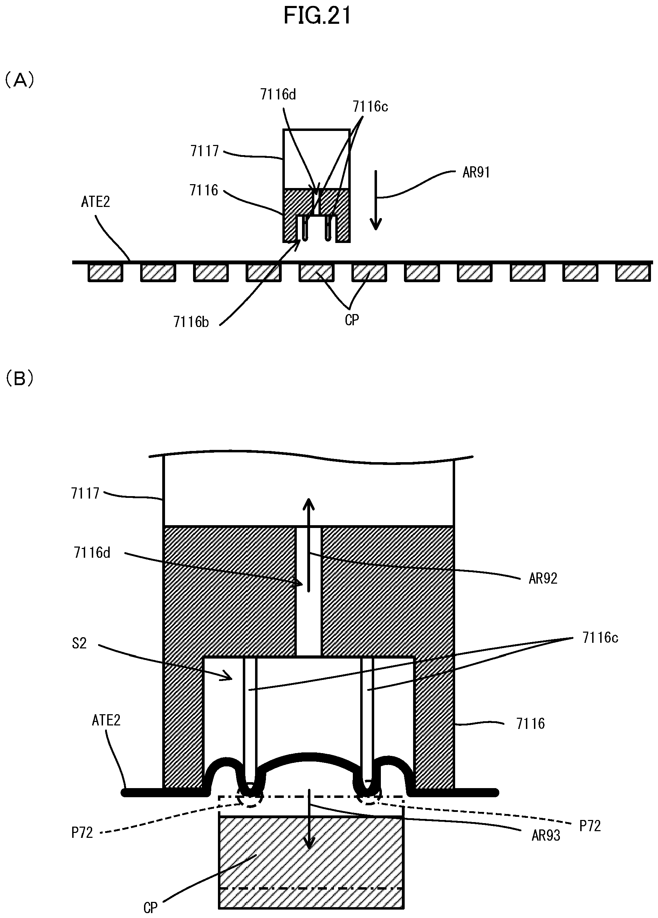

In the respective embodiments, the chip feeder may be a chip feeder that includes a chip feeding head 7116 and a sucker 7117 as illustrated in, for example, FIG. 21A. The chip feeding head 7116 includes a head body 7116a on which a recess 7116b is formed and supports 7116c provided on the bottom of the recess 7116b in a protruding manner and having, for example, pin-like shapes. The supports 7116c are, for example, provided in a number of four. However, the number of the supports 7116c may be three or five or more. In addition, in the bottom of the recess 7116b of the head body 7116a, a suction hole 7116d to suck gas existing inside the recess 7116b is formed. The sucker 7117 includes a vacuum pump (not illustrated) and sucks gas existing inside the recess 7116b through the suction hole 7116d.

The chip feeder according to the present variation, at the time of feeding a chip CP, brings the chip feeding head 7116 close to a portion of an adhesive sheet ATE2 corresponding to one chip CP among a plurality of chips CP stuck on the adhesive sheet ATE2, as illustrated by, for example, an arrow AR91 in FIG. 21A and brings the chip feeding head 7116 into contact with the adhesive sheet ATE2. In this configuration, the adhesive sheet ATE2 holds a plurality of chips CP on a surface having adhesion. In addition, each of the chips CP may have the opposite side to the bonding surface CPf stuck on the adhesive sheet ATE2 or the bonding surface CPf side stuck on the adhesive sheet ATE2. The chip feeder brings the chip feeding head 7116 close to a surface of the adhesive sheet ATE2 on the opposite side to the surface of the adhesive sheet ATE2 holding the plurality of chips CP.

Next, the chip feeder, with the chip feeding head 7116 in contact with the adhesive sheet ATE2, sucks air existing in a space S2 formed inside the recess 7116b through the suction hole 7116d, as illustrated in FIG. 21B. This processing causes area of contact portions P72 between the adhesive sheet ATE2 and the chip CP to be reduced and the chip CP to be detached from the adhesive sheet ATE2.

The present configuration has an advantage that, since the present configuration enables a chip CP to be fed without damaging the adhesive sheet ATE2, adherence of foreign objects generated from the adhesive sheet ATE2 onto the chip CP can be prevented.

The respective embodiments may have a configuration in which a plurality of chips CP is held to an adhesive sheet the adhesion of which is reduced by, for example, being irradiated with ultraviolet rays. In this case, a chip feeder may be configured to include a chip feeding head including an ultraviolet ray irradiator (not illustrated) and, at the time of feeding a chip CP, irradiate a portion of the adhesive sheet at which a chip CP to be fed is stuck with ultraviolet rays by the ultraviolet ray irradiator. Note that, as the afore-described adhesive sheets ATE1 and ATE2, which were described using FIGS. 20 and 21, respectively, an adhesive sheet the adhesion of which is reduced by being irradiated with ultraviolet rays may be employed. In this case, the chip feeder is only required to have a configuration to, at the time of feeding a chip CP, irradiate the adhesive sheet ATE1 or ATE2 with ultraviolet rays as well as sucking the adhesive sheet ATE1 or ATE2 by the sucker 6117 or 7117.

Although, in the respective embodiments, an example in which, in the bonding device 30, the stage 31 holds a wiring board WT in such an attitude that the mounting surface WTf of the wiring board WT faces vertically downward was described, the attitude of the held wiring board WT is not limited thereto. For example, the stage may be a stage that holds a wiring board WT in such an attitude that the mounting surface WTf of the wiring board WT faces vertically upward.

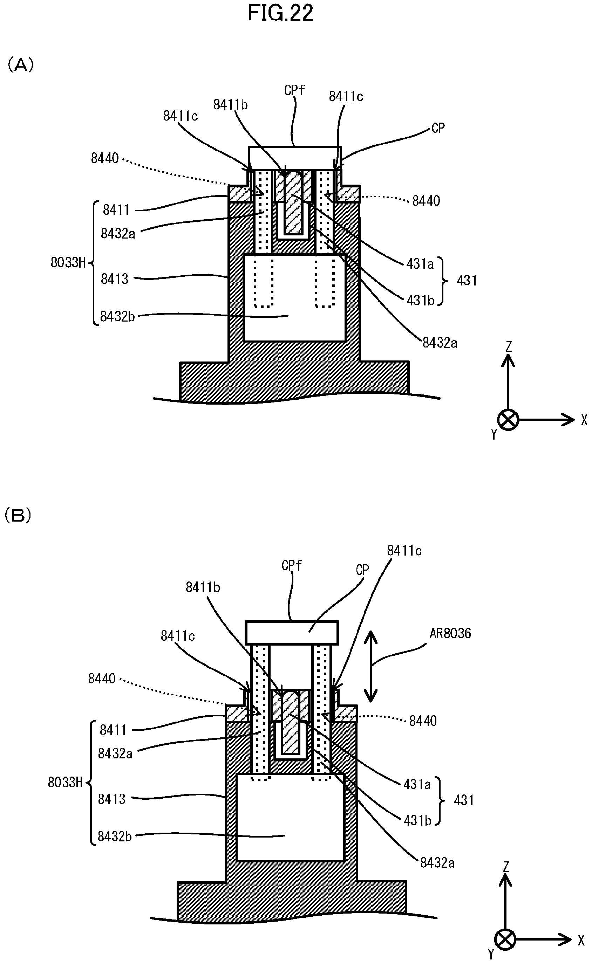

In the respective embodiments, the bonding device 30 may be a bonding device that includes a head including a suction post. For example, as illustrated in FIG. 22A, a head 8033H may be a head that includes a chip tool 8411, a head body 8413, suction posts 8432a, and a suction post driver 8432b. Note that, in FIG. 22, the same reference signs as those in FIG. 3A are assigned to the same constituent components as those in the respective embodiments. In this configuration, the head body 8413, as with the head body 413 according to the respective embodiments, includes a pressing mechanism 431 to press a central portion of a chip CP. The pressing mechanism 431 includes a pressing rod 431a and a pressing driver 431b to drive the pressing rod 431a. The chip tool 8411 includes through-holes 8411c formed at positions corresponding to the suction posts 8432a of the head body 8413 and a through-hole 8411b into the inside of which the pressing rod 431a is inserted.

The suction posts 8432a are component supports each of which has, for example, a long cylindrical shape, on the inside of which a suction hole 8440 is formed, is disposed at a tip portion of the head 4033H, and is freely movable in the vertical direction. The suction posts 8432a are, for example, provided in a number of four. However, the number of the suction posts 8432a may be three or five or more. The suction posts 8432a support a chip CP while sucking the opposite side to the bonding surface CPf side of the chip CP. The suction post driver 8432b drives the suction posts 8432a in the vertical direction, as illustrated by an arrow AR8036 in FIG. 22B. In addition, the suction post driver 8432b includes a vacuum pump (not illustrated) and sucks a chip CP by decompressing the inside of the suction holes 8440 with the chip CP placed at tip portions of the suction posts 8432a. The suction post driver 8432b moves the suction posts 8432a to the vertically upper side of the first chip holder 512 with the first chip holder 512, which is holding a chip CP, located at a transfer position (for example, Pos1 in FIG. 1) and a central portion of the chip CP supported by the tip portions of the suction posts 8432a. This movement causes the chip CP to be transferred from the first chip holder 512 of the first chip transporter 51 to the head 8033H. Note that the shape of each suction post is not limited to a pin-like shape and the suction posts may be suction posts that have a cylindrical shape and are arranged in such a way as to surround the pressing mechanism 431.

In the respective embodiments, an example in which a chip CP is transferred from the first chip holder 512 to the head 33H by moving the chip supports 432a supporting a central portion of the chip CP to the vertically upper side of the first chip holder 512 with the first chip holder 512, which is holding the chip CP, located at the transfer position Pos1 was described. However, without being limited to the above example, a chip CP may, for example, be transferred from the first chip holder 512 to the head 33H by moving the first chip holder 512 vertically downward with the first chip holder 512, which is holding the chip CP, located at the transfer position Pos1 and a central portion of the chip CP supported by the chip supports 432a.

In the respective embodiments, an example in which the bonding device 30 or 4030, by moving the head 33H in the direction toward the stage 31, mounts a chip CP on the wiring board WT was described. However, without being limited to the above example, the bonding device 30 or 4030 may be a bonding device that, for example, by moving the stage 31 in a direction in which the stage 31 is brought close to the head 33H, mounts a chip CP on the wiring board WT.

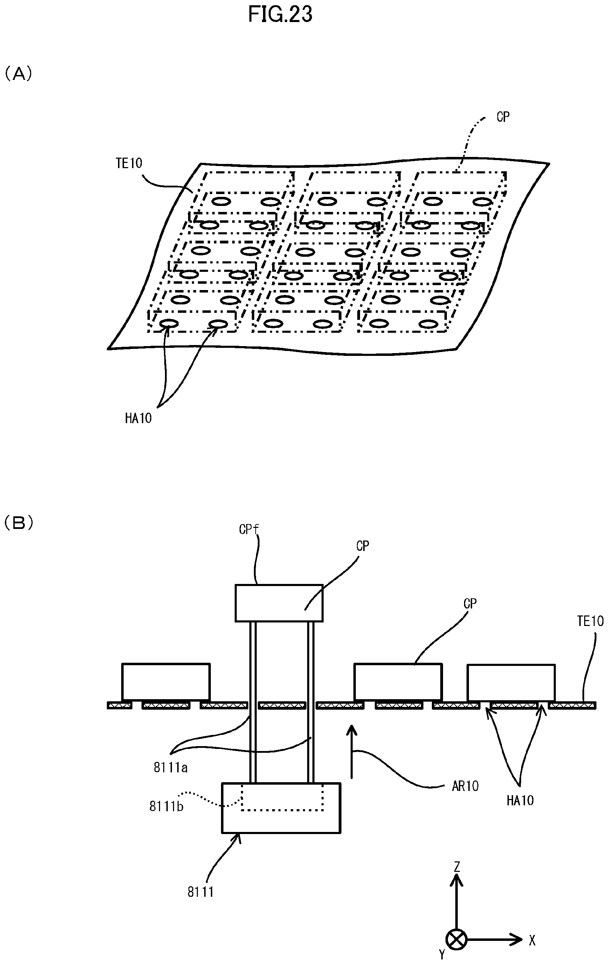

In Embodiment 1, the sheet holding frame 112 may be a sheet holding frame that holds a sheet TE10 that is an adhesive sheet to hold a plurality of chips CP on a surface having adhesion and in which holes HA10 are formed in each of regions in which a plurality of chips CP is respectively stuck, as illustrated in, for example, FIG. 23A. In addition, a pickup mechanism 8111 may be a pickup mechanism that includes suction posts 8111a and a suction post driver 8111b, as illustrated in FIG. 23B. The suction posts 8111a are chip support pins (component support pins) each of which has, for example, a long cylindrical shape and on the inside of each of which a suction hole (not illustrated) is formed. The suction posts 8111a are, for example, provided in a number of four. However, the number of the suction posts 8111a may be three or five or more. The suction posts 8111a are chip support pins to support a chip CP while sucking the opposite side to the bonding surface CPf side of the chip CP. The suction post driver 8111b includes a vacuum pump (not illustrated) and sucks a chip CP by decompressing the insides of the suction holes with the chip CP placed at tip portions of the suction posts 8111a. The pickup mechanism 8111 may be a pickup mechanism that brings one chip CP into a state of being detached from the sheet TE10 by inserting the suction posts 8111a into the holes HA10 from the vertically lower (-Z-direction) side of the sheet TE10, as illustrated by an arrow AR10 in FIG. 23B. In this configuration, when the pickup mechanism 111 moves vertically upward (+Z-direction), the suction posts 8111a are inserted into the holes HA10. Note that the chip support pins that the pickup mechanism 8111 includes are not limited to the suction posts 8111a and may be the needles 111a that were described in Embodiment 1. In addition, the chip mounting system according to the present variation may be a chip mounting system that includes a borer (not illustrated) that produces the sheet TE10 in which the holes HA10 are formed by boring the holes HA10 in a sheet (not illustrated) in which no hole has been bored and that is held by the sheet holding frame 112.

The present configuration has an advantage that a possibility that foreign objects are generated from the sheet TE10 is low compared with, for example, a configuration in which the needles 111a pierce the sheet TE. In addition, in the case of the configuration that includes the pickup mechanism 8111 including the suction posts 8111a, there is an advantage that, since a chip CP is sucked and held to the tip portions of the suction posts 8111a, misalignment of the chip CP is prevented.

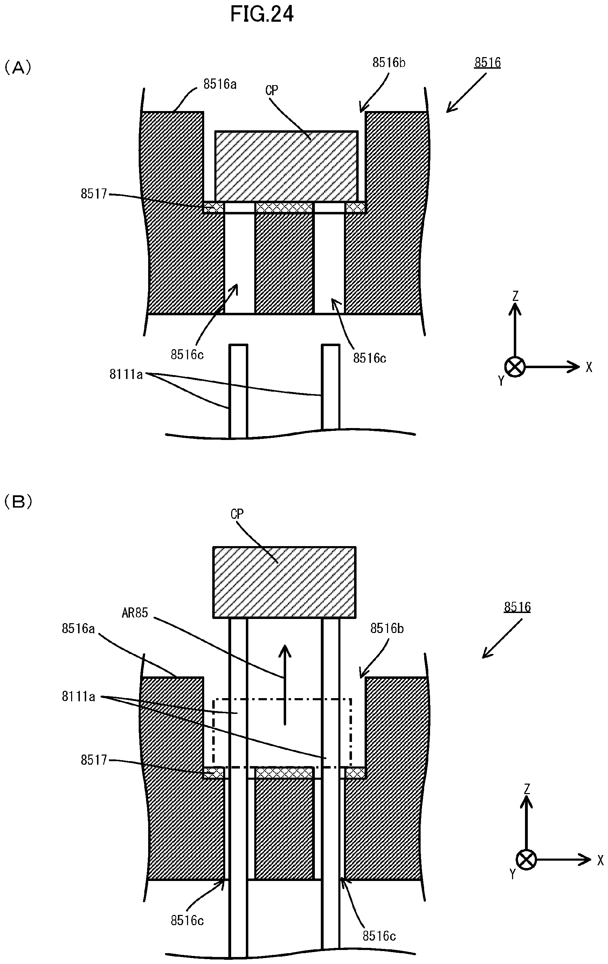

In the respective embodiments, the chip feeder may be a chip feeder that includes a tray 8516 as illustrated in, for example, FIG. 24A. In this configuration, the tray 8516 includes a tray body 8516a on which recesses 8516b, inside each of which a chip CP is arranged, are disposed and an adhesive member 8517 disposed on the bottom of each of the recesses 8516b. Each of the adhesive member 8517 is, for example, a gel-type adhesive sheet. In the bottom of each of the recesses 8516b of the tray body 8516a, through-holes 8516c penetrating the tray body 8516a in the thickness direction are formed. Each of the through-holes 8516c has cross-sectional area that allows, for example, one of the suction posts 8111a of the afore-described pickup mechanism 8111 to be inserted. In this configuration, the tray 8516 is arranged in such an attitude that, for example, the recess 8516b side of the tray body 8516a faces vertically upward. As illustrated in FIG. 24B, the pickup mechanism 8111, by inserting the suction posts 8111a into the through-holes 8516c of the tray 8516 from the vertically lower side of the tray 8516 and raising a chip CP vertically upward, causes the chip CP to be detached from the tray 8516 (see an arrow AR85 in FIG. 24B).

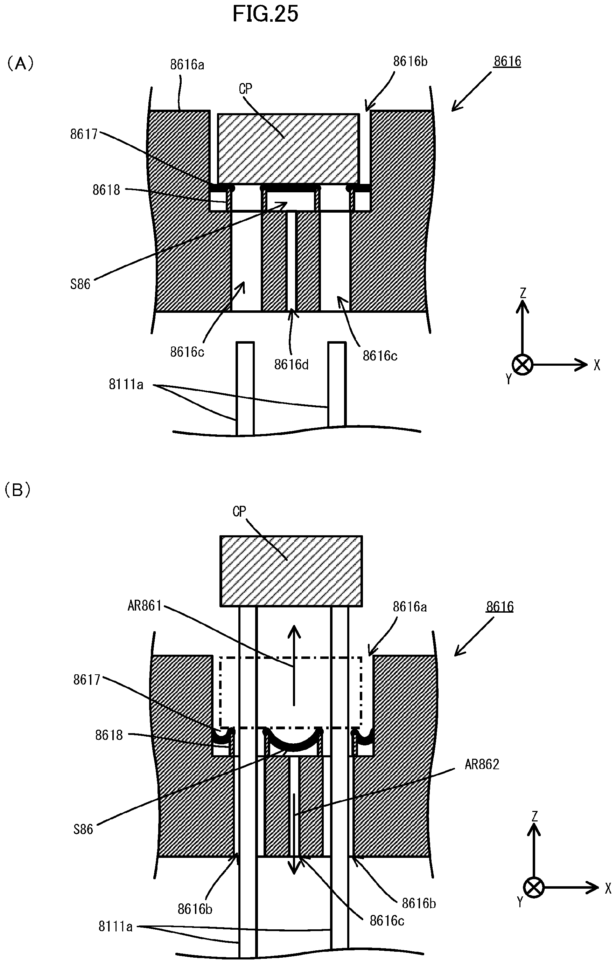

Alternatively, the chip feeder may be a chip feeder that includes a tray 8616 as illustrated in, for example, FIG. 25A and a sucker (not illustrated) including a vacuum pump (not illustrated). In this configuration, the tray 8616 includes a tray body 8616a on which recesses 8616b, inside each of which a chip CP is arranged, are disposed, partition walls 8618 provided on the bottom of each of the recesses 8616b in a protruding manner, and adhesive sheets 8617 each of which is stretched at tip portions of the partition walls 8618. In the bottom of each of the recesses 8616b of the tray body 8616a, through-holes 8616c penetrating the tray body 8616a in the thickness direction are formed. Each of the through-holes 8616c, as with the afore-described through-holes 8516c, has cross-sectional area that allows, for example, one of the suction posts 8111a of the afore-described pickup mechanism 8111 to be inserted. The partition walls 8618 are disposed in such a way as to surround the through-holes 8616c at the bottom of each of the recesses 8616b. Each of the adhesive sheets 8617 holds a chip CP on a surface having adhesion on the opposite side to the bottom side of one of the recesses 8616b of the tray body 8616a. In this configuration, the chip CP may have the opposite side to the bonding surface CPf stuck on the adhesive sheet 8617 or the bonding surface CPf side stuck on the adhesive sheet 8617. In addition, in the bottom of each of the recesses 8616b of the tray body 8616a, a communication hole 8616d communicating with a space S86 formed between the bottom of the recess 8616b and the adhesive sheet 8617 in the recess 8616b is bored.

In this configuration, the tray 8616 is arranged in such an attitude that, for example, the recess 8616b side of the tray body 8616a faces vertically upward. As illustrated in FIG. 25B, the pickup mechanism 8111, by inserting the suction posts 8111a into the through-holes 8616c of the tray 8616 from the vertically lower side of the tray 8616 and raising a chip CP vertically upward, causes the chip CP to be detached from the tray 8516 (see an arrow AR861 in FIG. 25B). On this occasion, the sucker, at the time of feeding a chip CP with the chip CP held to an adhesive sheet 8617, sucks air existing in an afore-described space S86 through a communication hole 8616d of the tray 8616 (an arrow AR862 in FIG. 25B). Since this configuration causes area of a contact portion between the adhesive sheet 8617 and the chip CP to be reduced, it is possible to, when the chip CP is raised vertically upward by the pickup mechanism 8111, smoothly detach the chip CP from the adhesive sheet 8617.

There is an advantage that, even when a chip CP is not stuck to a sheet TE, the present configuration enables the chip CP to be fed to the bonding device 30 or 4030.

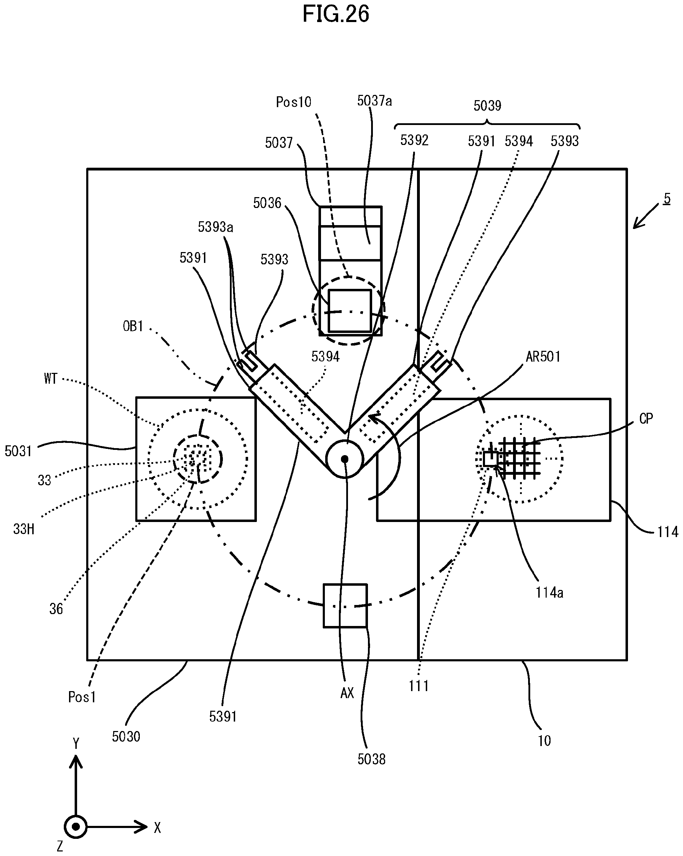

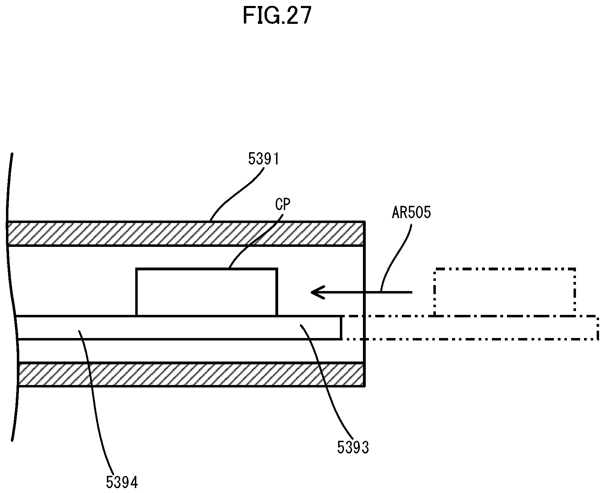

In Embodiment 1, the first chip transporter to transport a chip CP may be a first chip transporter (also referred to as a turret) 5039 as illustrated in, for example, FIG. 26. Note that, in FIG. 26, the same reference signs as those in FIG. 1 are assigned to the same constituent components as those in Embodiment 1. The first chip transporter 5039 transports a chip CP fed from a chip feeder 11 to a transfer position Pos1 at which the chip CP is to be handed over to a head 33H of a bonder 33. The first chip transporter 5039 includes, for example, two plates 5391, two arms 5394, two first chip holders 5393 each of which is disposed at a tip portion of one of the arms 5394, and a plate driver 5392 to rotation-drive the two plates 5391 at the same time. Each of the plates 5391 is formed in a long rectangular box shape, and one end of the plate 5391 turns with the other end (axis AX) thereof, which is located at the middle between a chip feeder 5011 and the head 33H, as a fulcrum. Note that the number of the plates 5391 is not limited to two and may be three or more. Each of the arms 5394 has a long length and protrudes or retracts along the longitudinal direction of one of the plates 5391. Each of the first chip holders 5393 is disposed at a tip portion of one of the arms 5394 and includes two leg pieces 5393a to hold a chip CP. In this configuration, each of the plates 5391 is configured to be capable of housing the first chip holder 5393 at the tip portion of one of the arms 5394 on the inside thereof, as illustrated in FIG. 27. When the first chip transporter 5039 turns the plates 5391, the first chip transporter 5039, by causing the arms 5394 to retract into the plates 5391, houses the first chip holders 5393 on the insides of the plates 5391, as illustrated by an arrow AR508 in FIG. 27. This configuration enables adherence of particles onto a chip CP at the time of transportation to be prevented. Note that suction grooves (not illustrated) may be disposed on the two leg pieces 5393a. In this case, since a chip CP is sucked and held by the leg pieces 5392a, it is possible to transport the chip CP without misalignment. In order to prevent a chip CP from being thrown out due to centrifugal force induced when the plates 5391 turn, protrusions (not illustrated) may be disposed at the tip portions of the leg pieces 5393a.

In this configuration, the pickup mechanism 8111 and the head 33H of the bonder 33 are arranged at positions that overlap, in the Z-axis direction, an orbit OB1 drawn by the tip portions of the arms 5394 when the sheet plates 391 turn. When the chip transporter 5039 receives a chip CP from the chip feeder 5011 in a chip feeding device 5010, the chip transporter 5039, through rotational motion about the central axis AX, transports the chip CP to the transfer position Pos1, which overlaps the head 33H in a bonding device 5030, as illustrated by an arrow AR501 in FIG. 1.

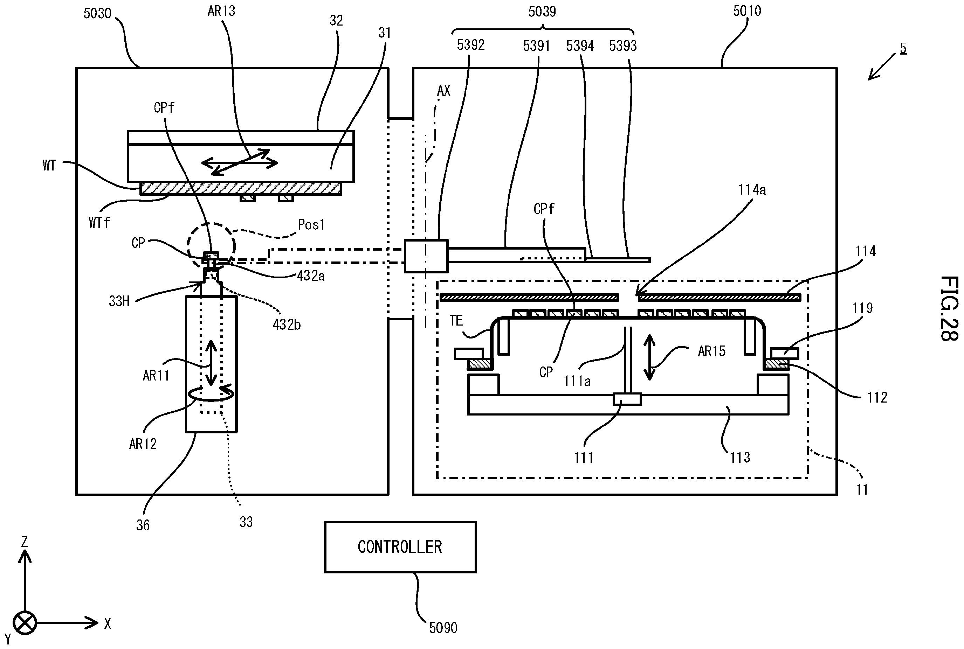

The chip feeder 5011 includes a frame holder 119 to hold a sheet holding frame 112, a pickup mechanism 111, and a cover 114, as illustrated in FIG. 28. Note that, in FIG. 28, the same reference signs as those in FIG. 1 are assigned to the same constituent components as those in Embodiment 1. The bonding device 5030 includes a stage 31, the bonder 33 including the head 33H, and a head driver 36 to drive the head 33H. The head 33H includes chip supports 432a and a support driver 432b.

In addition, the chip mounting system 5 according to the present embodiment includes, in addition to the chip feeder 11 and the bonder 33, a cleaner 5037 to clean a chip CP and a chip collector 5038, as illustrated in FIG. 26. The cleaner 5037 includes a chip stage 5036 to support a chip CP, an XY-direction driver (not illustrated) to drive the chip stage 5036 in two directions (XY-directions) that are orthogonal to the vertical direction and are orthogonal to each other, and a cleaning head 5037a that discharges water to which ultrasonic waves or megasonic vibration is applied or cleaning fluid reducing electrode surfaces. The cleaner 5037 also includes a rotation driver (not illustrated) to rotate the chip stage 5036 within a plane that is orthogonal to the vertical direction. In this configuration, the cleaner 5037, by causing the chip stage 5036 supporting the chip CP to scan in XY directions while spraying water, to which ultrasonic waves are applied, on a chip CP by use of the cleaning head 5037a, cleans the entire bonding surface CPf of the chip CP. The cleaner 5037 stops the cleaning head 5037a from discharging water and thereafter spin-dries the chip CP by rotating the chip stage 5036.

Since a chip CP has a rectangular plate shape, there is a possibility that rotating the chip CP while spraying water thereon causes an edge portion of the chip CP to be damaged. In contrast, the cleaner 5037 according to the present variation causes the chip stage supporting the chip CP to move back and forth in an XY direction while spraying water, to which ultrasonic waves are applied, on the chip CP by use of a water discharger. This configuration enables damage to an edge portion of a chip CP to be prevented. Note that the cleaner 5037 may be a cleaner that, by blowing, for example, inert gas, such as N2, in place of water on the chip CP, removes particles having adhered to the chip CP.

The chip stage 5036 adjusts the attitude of a chip CP held by the chip holder 5393 after the cleaning of the chip CP by the cleaner 5037. This configuration enables a chip CP to be aligned at the chip stage 5036 even when misalignment of the chip CP occurred at the time of cutting-out of the chip CP at the chip feeder 11. Therefore, it is possible to transfer the chip CP to the head 33H of the bonder 33 without misalignment. In particular, since misalignment is likely to occur when a chip CP is cut out by piercing the sheet TE with the needles 111a, the configuration of the present variation is effective. Note that, when a chip feeder transporting a chip CP with a Bernoulli chuck is included in place of the chip feeder 11, misalignment of a chip CP is likely to occur because the chip CP is held by the Bernoulli chuck in a non-contact manner. Therefore, it is effective to include a mechanism to adjust the attitude of a chip CP immediately before the chip CP is handed over to the head 33H, as the chip stage 5036.

The chip collector 5038 is a component collector that is arranged at a stage succeeding the head 33H in the turning direction of the sheet plates 5391 when viewed from the axis AX (fulcrum) of the plates 5391.

The controller 5090 includes, for example, a micro processing unit (MPU), a main storage, an auxiliary storage, an interface, and a bus connecting the components to one another and controls the head driver 36, the stage driver 32, the holding mechanism 440, and the pressing mechanism 431 of the bonding device 30 and the chip feeder 11 and the chip transporter 5039 of the chip feeding device 10. The MPU of the controller 90, by reading programs stored in the auxiliary storage into the main storage and executing the programs, respectively outputs control signals to the head driver 36, the stage driver 32, the holding mechanism 440, the pressing mechanism 431, the chip feeder 11, and the chip transporter 5039 via the interface.

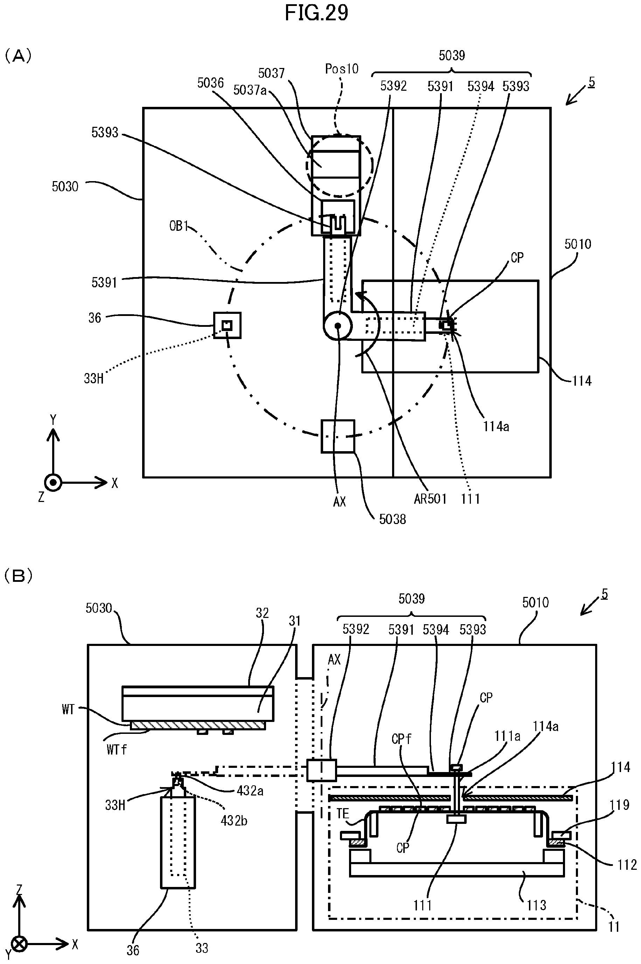

Next, operation of the chip mounting system 5 according to the present variation is described, referring to FIGS. 29 to 32. First, the chip mounting system 5 is set to a state where one plate 5391 is directed toward the chip feeder 11. Next, the pickup mechanism 111, by moving vertically upward, pushes out one chip CP from the opposite side to the side of the sheet TE on which a plurality of chips CP are stuck and brings the one chip CP into a state of being detached from the sheet TE. While the chip CP is in this state, the chip transporter 5039 protrudes the arm 5394 out of the plate 5391. On this occasion, the first chip holder 5393 and the pickup mechanism 111 are brought into a state where the needles 111a of the pickup mechanism 111 are arranged between the two leg pieces 5393a of the first chip holder 5393. In this way, the first chip holder 5393 and the chip CP are brought into a state where the chip CP can be handed over to the first chip holder 5393, as illustrated in FIGS 29A and 29B. When the pickup mechanism 111 is moved vertically downward while the first chip holder 5393 and the chip CP are in this state, the chip CP is handed over to the first chip holder 5393.

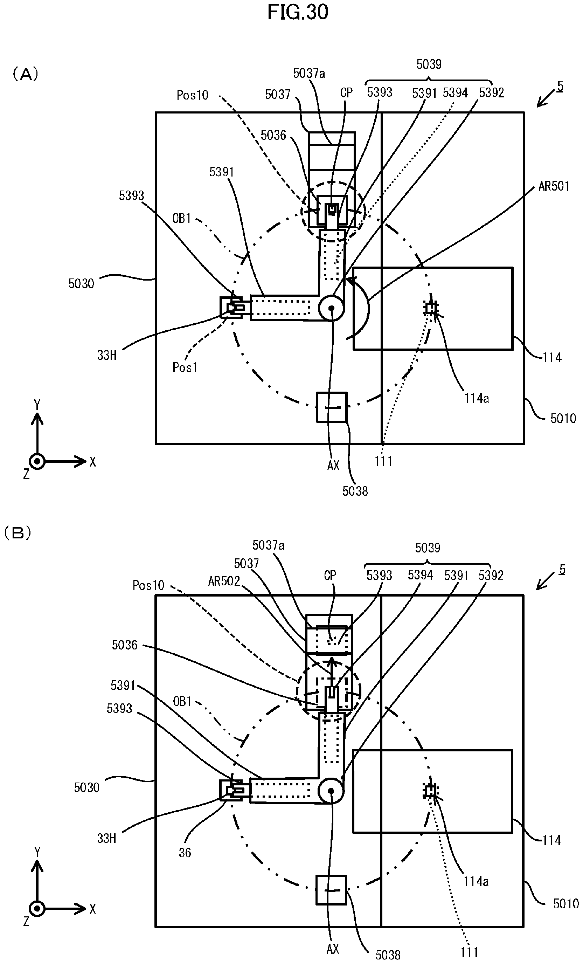

Succeedingly, when the chip mounting system 5 turns the plate 5391 90 degrees in the direction of the arrow AR501 in FIG. 29A, the plate 5391 is arranged at a cleaner handover position Pos10 illustrated in FIG. 30A. That is, the first chip transporter 5039 transports the first chip holder 5393 holding the chip CP fed from the chip feeder 11 to the cleaner handover position Pos10 at which the chip CP is to be handed over to the cleaner 5037. While the first chip holder 5393 is in this state, the first chip transporter 5039 transfers the chip CP from the first chip holder 5393 to the chip stage 5036 of the cleaner 5037. The cleaner 5037 moves the chip stage 5036 supporting the chip CP to a position directly below the cleaning head 5037a of the cleaner 5037, as illustrated by an arrow AR502 in FIG. 30B. The cleaner 5037 cleans the chip CP with water discharged from the cleaning head 5037. Subsequently, the cleaner 5037 moves the chip stage 5036 supporting the chip CP to the cleaner handover position Pos10 again. Next, the chip stage 5036 adjusts the attitude of the chip CP. Succeedingly, the chip CP is handed over from the chip stage 5036 to the first chip holder 5393 again.

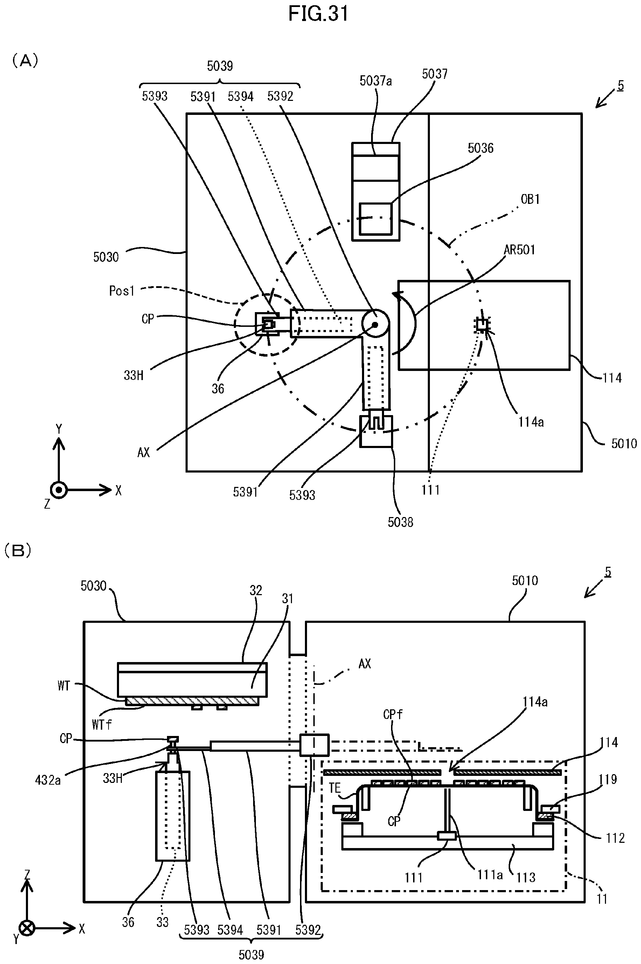

Subsequently, when the chip mounting system 5 turns the plate 5391 90 degrees in the direction of the arrow AR501 in FIG. 30A, the plate 5391 is arranged at a position illustrated in FIG. 31A. On this occasion, the first chip holder 5393 at the tip portion of the arm 5394 of the first chip transporter 5039 is arranged at the transfer position Pos1 vertically directly above the head 33H of the bonder 33. That is, the first chip transporter 5039 transports the first chip holder 5393 holding the chip CP received at the cleaner handover position Pos10 to the transfer position Pos1 at which the chip CP is to be transferred to the head 33H. The head driver 36 moves the bonder 33 vertically upward and brings the head 33H close to the first chip holder 5393. Next, the support driver 432b moves the chip supports 432a vertically upward. This movement causes the chip CP having been held by the first chip holder 5393 to be arranged on the vertically upper side of the first chip holder 5393 while being supported on the top ends of the chip supports 432a, as illustrated in FIG. 31B. Succeedingly, the first chip transporter 5039 causes the arm 5394 to retract into the plate 5391. Subsequently, the support driver 432b moves the chip supports 432a vertically downward. This processing brings the chip CP into a state of being held on the tip portion of the head 33H.

Next, the chip mounting system 5, by driving the stage 31 and also rotating the bonder 33, performs alignment to correct relative misalignment between the chip CP and a wiring board WT. Succeedingly, the chip mounting system 5, by causing the head 33H to ascend, mounts the chip CP on the wiring board WT.

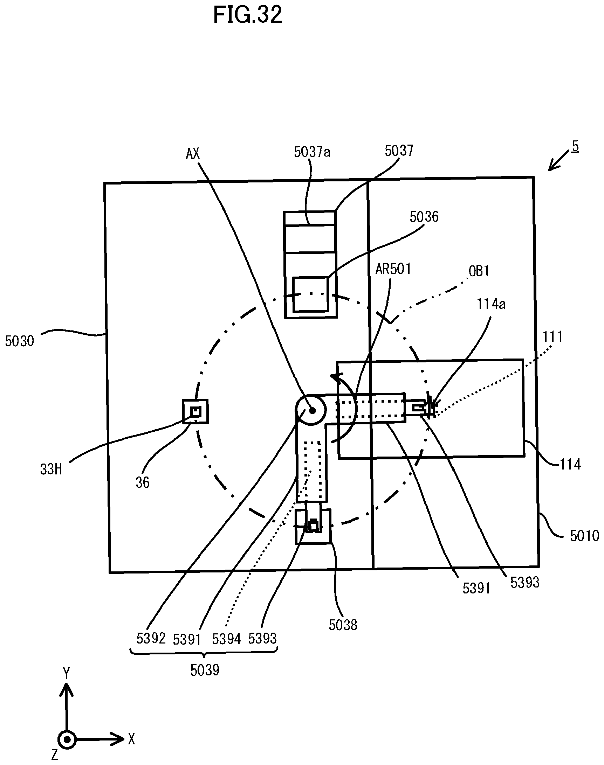

In this operation, when, despite an attempt to bond the chip CP to the wiring board WT, the chip mounting system 5 is not able to bond the chip CP to the wiring board WT, the chip mounting system 5 causes the first chip holder 5393 at the tip portion of the arm 5394 of the first chip transporter 5039 to hold the chip CP again. Subsequently, when the chip mounting system 5 turns the plate 5391 90 degrees in the direction of the arrow AR501 in FIG. 31A, the plate 5391 is arranged at a position illustrated in FIG. 32. On this occasion, the first chip holder 5393 at the tip portion of the arm 5394 of the first chip transporter 5039 is arranged vertically directly above the chip collector 5038. Subsequently, the chip CP held by the first chip holder 5393 is handed over to the chip collector 5038. In this configuration, whether or not the chip CP was able to be bonded to the wiring board WT can be determined based on whether or not the chip CP exists when misalignment of the chip CP is measured by use of an infrared transmission camera (not illustrated) on the wiring board WT side. In addition, whether or not the chip CP is left on the head 33H side can be determined based on whether or not the chip CP can be recognized by an infrared transmission camera (not illustrated) on the bonder 33 side. The chip mounting system 5 may also be configured such that, when a chip CP is left on the head 33H, the chip CP is ejected into a collection box (not illustrated) that is disposed in the bonding device 30.

Note that, although, in the present variation, an example in which the first chip holder 5393 is a chip holder having the two leg pieces 5393a to hold a chip CP at tip portions thereof was described, the present variation is not limited thereto, and the first chip holder 5393 may be a chip holder at the tip portion of which a Bernoulli chuck is disposed.

According to the present configuration, since cleaning of a chip CP can be performed at the cleaner 5037 while the chip CP is being transported from the chip feeder 11 to the bonder 33, it becomes easier to maintain the bonding surface CPf of the chip CP in a clean state. Therefore, occurrence of a defect in bonding of a chip CP on a wiring board WT can be prevented.

It has been conventionally common practice to clean a substrate before being diced into individual chips CP, and, in this case, it has been difficult to prevent particles generated from a sheet TE at the time of dicing the substrate into individual chips CP from adhering to the chips CP. In addition, when a chip CP is transported with a tray, particles generated by the chip CP contained in the tray coming into contact with the inner wall of the tray sometimes adhere to the chip CP. Therefore, bonding of the entire bonding surface CPf of a chip CP to a wiring board WT has been difficult, and influence of particles having adhered to the chip CP on bonding has been tried to be reduced by forming a gap between the chip CP and the wiring board WT by use of solder bumps, incorporating particles into solder, or the like. However, since there is a lower limit for the size of solder bumps, it has been necessary to enlarge pitch between electrodes on the wiring board WT, to which a chip CP is to be bonded, to approximately 50 µm. Therefore, in order to achieve a narrow inter-electrode pitch, bonding a chip CP to a wiring board WT without bump has been requested. In this case, it is necessary to clean a chip CP for removal of particles at some point in the process from feeding of the chip CP from the chip feeder 11 until bonding of the chip CP to the wiring board WT.

In contrast, according to the present configuration, a series of processing including feeding of a chip CP, cleaning of the chip CP, and bonding of the chip CP to the wiring board WT is performed within the single chip mounting system 5. Since this configuration enables adherence of particles to a chip CP to be prevented, it is possible to bond the chip CP to the wiring board WT excellently.

In addition, according to the present configuration, the first chip transporter 5039 includes two first chip holders 5393. Since this configuration enables cleaning of a chip CP and bonding of a chip CP to the wiring board WT to be performed in parallel, there is an advantage that loss of tact time is reduced.

Note that, in the afore-described first chip transporter 5039, the first chip holder 5393 may be a chip holder including a Bernoulli chuck.

Alternatively, the afore-described chip mounting system 5 may be a chip mounting system that includes a second chip transporter including a second chip holder that is a Bernoulli chuck and configured to hand over a chip CP fed from the chip feeder 1 1 to the first chip transporter 5039. In this case, the first chip transporter 5039, before handing over a chip CP received from the second chip transporter to the head 33H, hands over the chip CP to an aligner (not illustrated) that performs alignment of the chip CP. The first chip transporter 5039 receives a chip CP having been subjected to alignment in the aligner and transports the chip CP to the head 33H. This configuration enables the first chip transporter 5039 to hand over a chip CP to the head 33H with the chip CP aligned.

In addition, in the afore-described chip mounting system 5, the head 33H may be a head that aligns a position of a chip CP before receiving the chip CP from the first chip transporter 5039 and thereafter receives the chip CP. In particular, when, in the first chip transporter 5039, the first chip holder 5393 is a Bernoulli chuck, this configuration is preferable.

In the respective embodiments, the chip mounting system may be a chip mounting system that includes a cleaner to clean a chip CP. In this case, the first chip transporter 51 or 4051 may be a chip transporter that transports the first chip holder 512 or 4512 holding a chip CP fed from the chip feeder 11, 2011, or 3011 to a cleaner handover position at which the chip CP is to be handed over to the cleaner. The first chip transporter 51 or 4051 may also be a chip transporter that transports the first chip holder 512 or 4512 holding a chip CP received at the afore-described cleaner handover position to a transfer position at which the chip CP is to be transferred to the head 33H. In addition, the chip cleaner may be a cleaner that is disposed inside the bonding device 30 or 4030 and that cleans a chip CP with the chip CP placed on the head 33H.

In the respective embodiments, the chip mounting system may be a chip mounting system that includes an activation processor (not illustrated) to activate the bonding surface CPf of a chip CP by subjecting the bonding surface CPf of the chip CP to sheet plasma treatment or irradiating the bonding surface CPf of the chip CP with a particle beam before the chip CP is transferred to the head 33H. Note that, when metal electrodes and an insulator layer are formed on the bonding surface CPf of a chip CP, performing plasma treatment causes all ions contained in plasma to collide with the bonding surface CPf, as a result of which there is a possibility that particles of the insulator adhere to the metal electrodes. Therefore, activating the bonding surface CPf by irradiating the bonding surface CPf with a particle beam by use of a fast atom beam (FAB) or an ion gun (IG) is more preferable because this activation method prevents the re-adherence of particles.

According to the present configuration, since subjecting the bonding surface CPf of a chip CP to the sheet plasma treatment or irradiating the bonding surface CPf of the chip CP with a particle beam causes the bonding surface CPf to be activated, water molecules to be likely to adhere to the bonding surface CPf, and OH groups to be thus likely to be generated, it is possible to improve bonding strength between a chip CP and a wiring board WT.

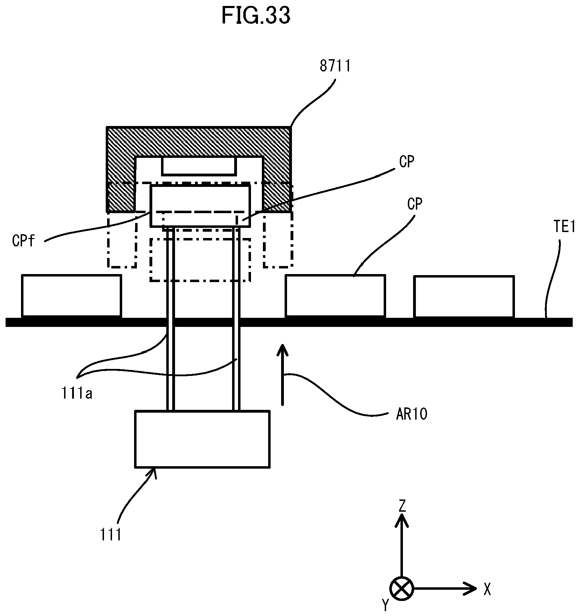

In Embodiment 1, the chip feeder may be a chip feeder that includes a Bernoulli chuck 8711 that moves in synchronization with movement of the pickup mechanism 111 in the vertical direction and that is arranged vertically directly above a chip CP pushed up by the needles 111a, as illustrated in FIG. 33. Alternatively, in the afore-described variation, the chip feeder may be a chip feeder that includes a Bernoulli chuck 8711 that moves in synchronization with movement of the pickup mechanism 8111 in the vertical direction and that is arranged vertically directly above a chip CP pushed up by the suction posts 8111a. According to the present configuration, it is possible to prevent flying-off or misalignment of a chip CP at the time of pushing-up of the chip CP by the pickup mechanism 111. Since, when no opening is provided in a sheet TE, it is necessary to pierce the sheet TE with the needles 111a and push up a chip CP upward with the needles 111a, the present variation is particularly effective for preventing flying-off of the chip CP.

In Embodiment 1, the chip feeder may be a chip feeder that includes a pickup mechanism to detach a chip CP stuck on a sheet TE from the sheet TE by use of suction force of a Bernoulli chuck and hand over the chip CP to the first chip transporter 51.

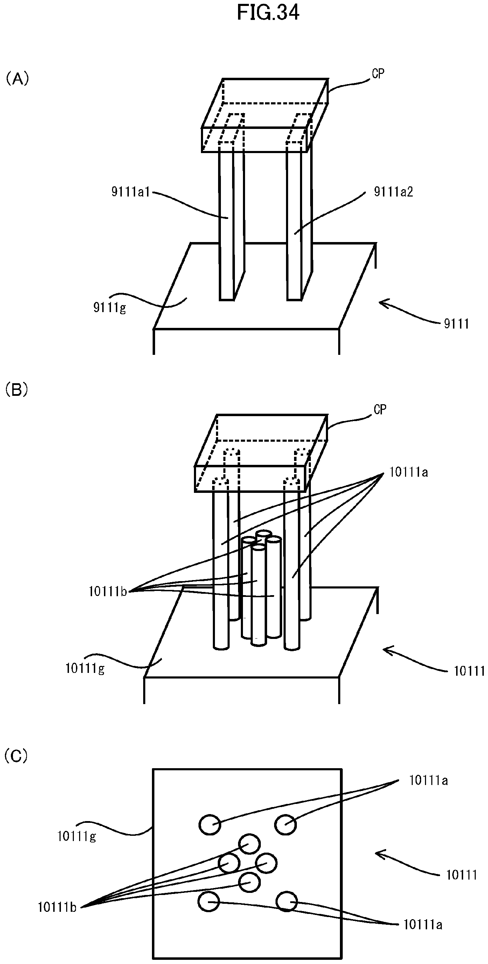

In Embodiment 1, when the chip feeder is a chip feeder including a Bernoulli chuck arranged vertically directly above a chip CP, the pickup mechanism may be a pickup mechanism that includes a plurality of long plate-shaped chip support plates (component support plates) to, with tip portions thereof in contact with a chip CP, support the chip CP in such an attitude that the bonding surface CPf of the chip CP is parallel with a plane orthogonal to the vertical direction. For example, as illustrated in FIG. 34A, a pickup mechanism 9111 may be a pickup mechanism that includes two long plate-shaped chip support plates 9111a1 and 9111a2. In this configuration, the pickup mechanism 9111 includes a support plate driver 9111g to, by moving the two chip support plates 9111a1 and 9111a2 in a direction orthogonal to an extending direction thereof, bring the two chip support plates 9111a1 and 9111a2 close to each other. The pickup mechanism 9111 also includes a sucker (not illustrated) to suck air in an interspace between the chip support plates 9111a1 and 9111a2 with a sheet stretched at tip portions of the chip support plates 9111a1 and 9111a2.

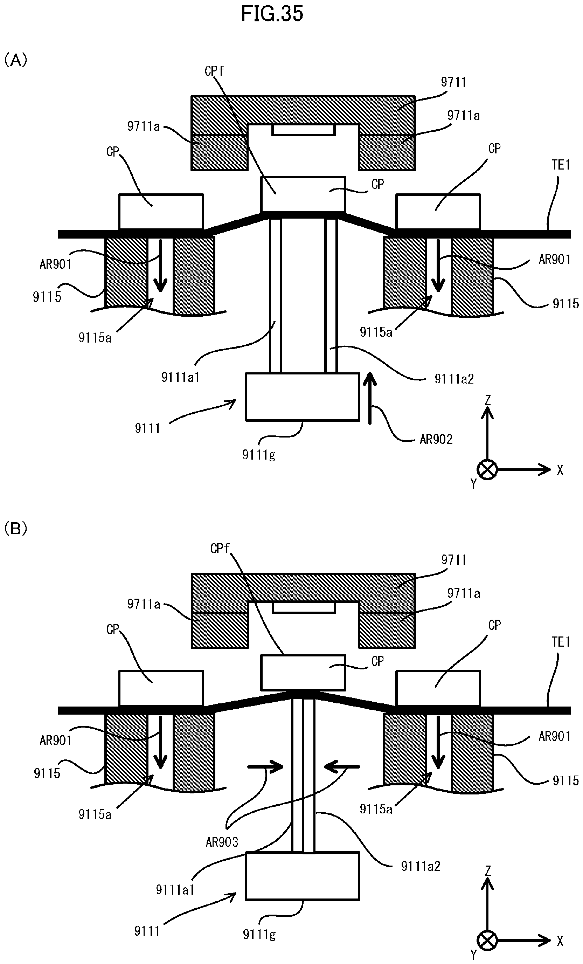

In addition, the chip feeder according to the present variation includes suction units 9115 each of which includes a sucker 9115a to suck a portion of a sheet TE1 at which a chip CP adjacent to a chip CP facing a Bernoulli chuck 9711 is stuck, as illustrated in, for example, FIG. 35A. In this configuration, the Bernoulli chuck 9711 is, for example, a Bernoulli chuck that the first chip transporter, which transports a chip CP to the transfer position at which the chip CP is to be transferred to the head 33H, includes. Note that the Bernoulli chuck 9711 may be a Bernoulli chuck that the second chip transporter, which transports a chip CP to the receipt position of the first chip transporter, includes. The Bernoulli chuck 9711 does not define the position in a horizontal direction of a chip CP. Therefore, on the Bernoulli chuck 9711, a guide 9711a to prevent misalignment of a chip CP is disposed. The guide 9711a is, for example, a rectangular frame-shaped guide that is disposed on a part of the Bernoulli chuck 9711 surrounding a chip CP with the chip CP held by the Bernoulli chuck 9711. In addition, the chip CP facing the Bernoulli chuck 9711 is equivalent to a chip CP cut out by the pickup mechanism 9111. Further, the chips CP adjacent to the chip CP facing the Bernoulli chuck 9711 are equivalent to chips CP other than the chip CP cut out by the pickup mechanism 9111. Each of the suction units 9115, by sucking a portion of the sheet TE1 at which a chip CP adjacent to a chip CP facing the Bernoulli chuck 9711 is stuck from the opposite side to the side of the sheet TE1 on which the chips CP are stuck, enables the chip CP facing the Bernoulli chuck 9711 to be raised to a position at which suction force of the Bernoulli chuck 9711 acts on the chip CP without the guide 9711a coming into contact with the chip CP adjacent to the chip CP facing the Bernoulli chuck 9711.

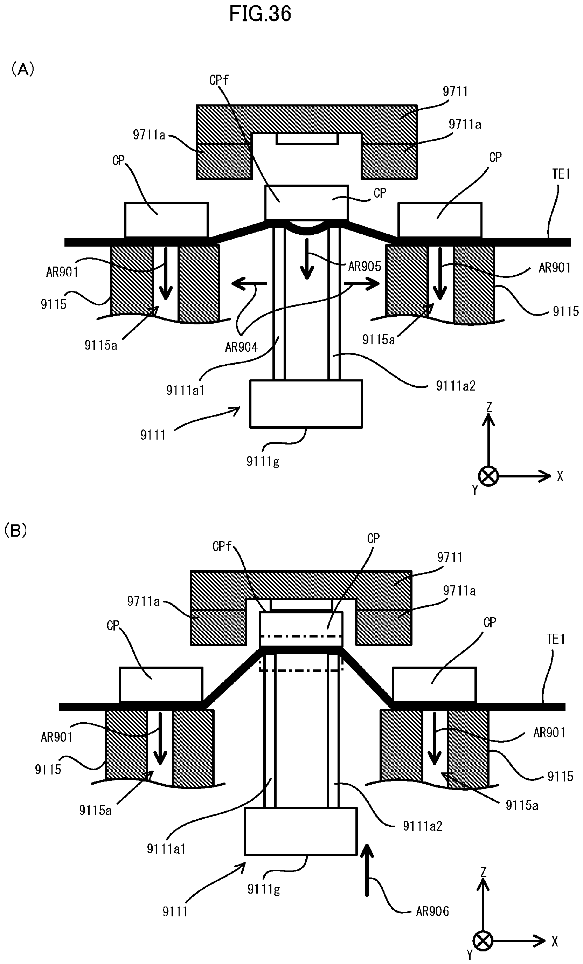

Operation of the chip feeder according to the present variation is now described, referring to FIGS. 35 and 36. First, when the chip feeder hands over a chip CP to the Bernoulli chuck 9711 by use of the pickup mechanism 9111, the chip feeder sucks portions at which chips CP adjacent to a chip CP facing the Bernoulli chuck 9711 are stuck by use of the suction units 9115, as illustrated in by arrows R901 in FIG. 35A. The pickup mechanism 9111 presses the tip portions of the chip support plates 9111a1 and 911a2 against a portion of the sheet TE1 at which the chip CP facing the Bernoulli chuck 9711 is stuck. Next, the support driver 9111g, by moving the chip support plates 9111a1 and 9111a2 in the direction in which the chip support plates 9111a1 and 9111a2 are brought close to each other as illustrated by arrows AR903 in FIG. 35B, causes the tip portions of the chip support plates 9111a1 and 911a2 to scrape the portion of the sheet TE1 at which the chip CP facing the Bernoulli chuck 9711 is stuck. On this occasion, since the sheet TE1 is slightly raised and an angle is formed between the sheet TE1 and a contact surface between the chip CP and the sheet TE1, moving the tip portions of the chip support plates 9111a1 and 9111a2 from the outer side to the inner side of the chip CP causes the sheet TE1 to be separated from the chip CP, following the movement of the chip support plates 9111a1 and 9111a2. Succeedingly, the pickup mechanism 9111 returns the positions of the chip support plates 9111a1 and 9111a2 to the original positions, as illustrated by arrows AR904 in FIG. 36A. Subsequently, the sucker sucks a portion of the sheet TE1 between the chip support plates 9111a1 and 9111a2, as illustrated by an arrow AR905 in FIG. 36A. In this processing, the pickup mechanism 9111 may return the positions of the chip support plates 9111a1 and 9111a2 to the original positions while the sucker is sucking the portion of the sheet TE1 between the chip support plates 9111a1 and 9111a2. This processing brings the chip CP facing the Bernoulli chuck 9711 into a state of being easily separated from the sheet TE1. Next, the pickup mechanism 9111, by moving the chip support plates 9111a1 and 9111a2 vertically upward as illustrated by an arrow AR906 in FIG. 36B, pushes up the portion of the sheet TE1 at which the chip CP facing the Bernoulli chuck 9711 is stuck vertically upward. On this occasion, since portions at which chips CP adjacent to the chip CP facing the Bernoulli chuck 9711 are stuck are sucked by the suction units 9115, the chips CP adjacent to the pushed-up chip CP are prevented from coming into contact with the Bernoulli chuck 9711. In addition, the Bernoulli chuck 9711 cannot generate sufficient suction force to suck a chip CP unless the chip CP comes close to a vicinity of the Bernoulli chuck 9711 to some extent with the chip CP kept in a horizontal attitude. On the other hand, the Bernoulli chuck 9711 needs the guide 9711a in order to define a position in horizontal directions of a chip CP. In contrast, in the present variation, it is possible to bring only a chip CP to be sucked by the Bernoulli chuck 9711 close to the Bernoulli chuck 9711 from the inner side of the guide 9711a with the chip CP kept in the horizontal attitude. Therefore, it is possible to cause the Bernoulli chuck 9711 to suck a chip CP even when the guide 9711a is disposed on the Bernoulli chuck 9711. The pushed-up chip CP is handed over to the Bernoulli chuck 9711. That is, the pickup mechanism 9111 pushes up a portion of the sheet TE1 at which a chip CP is stuck in such a way that the chip CP is kept in such an attitude that the bonding surface CPf of the chip CP is parallel with a plane orthogonal to the vertical direction, by use of only the chip support plates 9111a1 and 9111a2 without supporting the chip CP from the vertically upper side of the chip CP. Because of this configuration, when a portion of the sheet TE1 at which a chip CP is stuck is pushed up, the chip CP is prevented from coming into contact with the guide 9711a of the Bernoulli chuck 9711. Note that timing at which the sucker sucks the sheet TE1 may be a timing after the chip support plates 9111a1 and 9111a2 have pushed up a portion of the sheet TE1 at which a chip CP is stuck or may be a timing before the chip support plates 9111a1 and 9111a2 are moved in the direction in which the chip support plates 9111a1 and 9111a2 are brought close to each other or during the movement.

In addition, the pickup mechanism may be a pickup mechanism that includes three or more chip support pins to support a chip CP in such an attitude that the bonding surface CPf of the chip CP is parallel with a plane orthogonal to the vertical direction and separation pins that are separation members to separate a chip CP from a sheet. For example, as illustrated in FIG. 34B, a pickup mechanism 10111 includes four chip support pins 10111a and four separation pins 10111b. In this configuration, the pickup mechanism 10111 includes a pin driver 10111g to move the four chip support pins 10111a and the four separation pins 10111b independently of one another in extending directions thereof. The pickup mechanism 9111 also includes a sucker (not illustrated) to suck air in a space surrounded by the chip support pins 10111a with a sheet stretched at tip portions of the chip support pins 10111a.

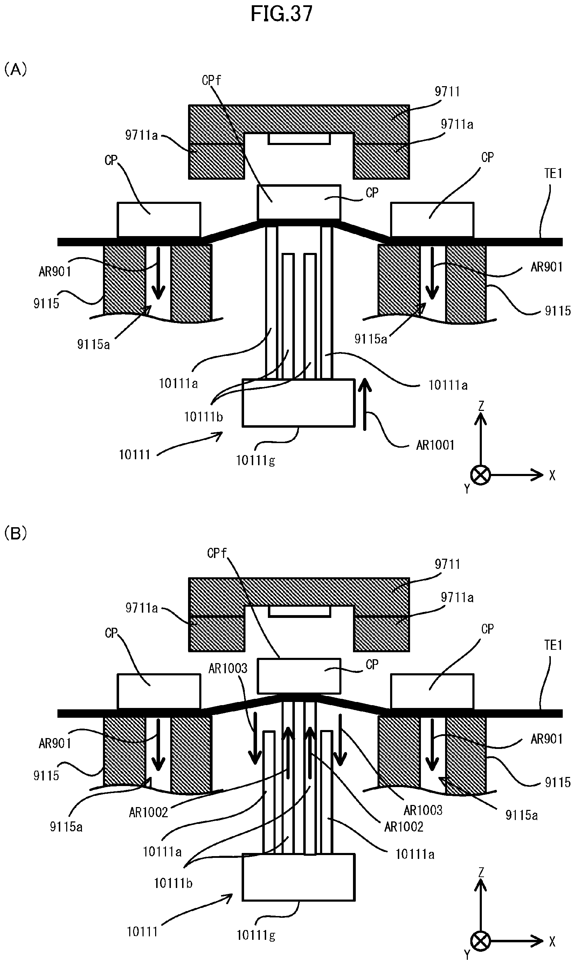

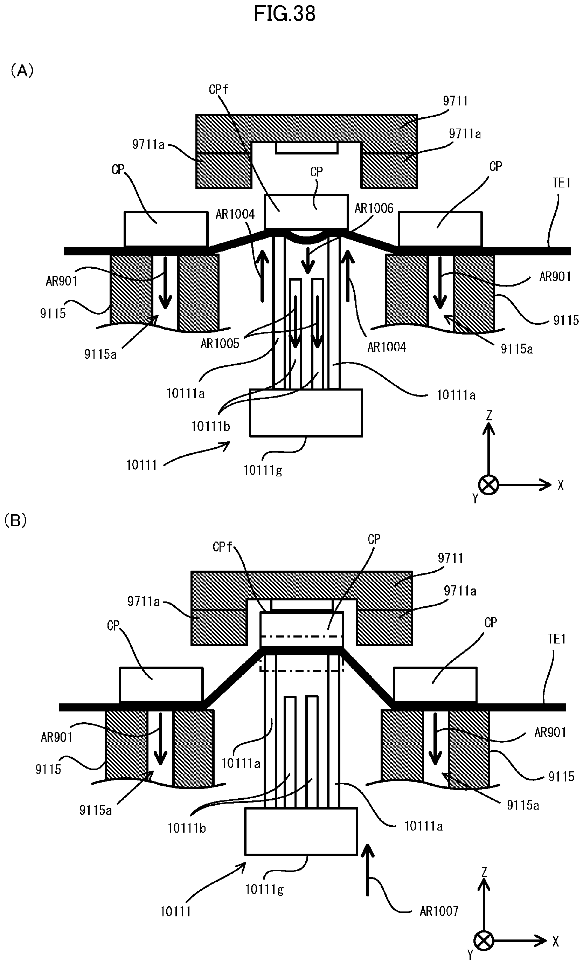

Operation of a chip feeder according to the present variation is now described, referring to FIGS. 37 and 38. Note that, in FIGS. 37 and 38, the same reference signs as those in FIGS. 35 and 36 are assigned to the same constituent components as those in the afore-described variation. First, when the chip feeder hands over a chip CP to the Bernoulli chuck 9711 by use of the pickup mechanism 10111, the chip feeder sucks portions at which chips CP adjacent to a chip CP facing the Bernoulli chuck 9711 are stuck, by use of the suction units 9115, as illustrated in by an arrow AR1001 in FIG. 37A. The pickup mechanism 9111 presses tip portions of the chip support pins 10111a against a portion of the sheet TE1 at which the chip CP facing the Bernoulli chuck 9711 is stuck. Next, the support driver 10111g presses tip portions of the separation pins 10111b against the portion of the sheet TE1 at which the chip CP facing the Bernoulli chuck 9711 is stuck, as illustrated by arrows AR1002 in FIG. 37B. On the other hand, the support driver 10111g detaches the tip portions of the chip support pins 10111a from the sheet TE1, as illustrated by arrows AR1003 in FIG. 37B. On this occasion, within a portion of the sheet TE1 stuck on the chip CP, a portion on the outer side of a portion with which the tip portions of the four separation pins 10111b come into contact is separated from the chip CP. Succeedingly, the pickup mechanism 10111 presses again the tip portions of the chip support pins 10111a against the portion of the sheet TE1 at which the chip CP facing the Bernoulli chuck 9711 is stuck, as illustrated by arrows AR1004 in FIG. 38A. On the other hand, the support driver 10111g detaches the tip portions of the separation pins 10111b from the sheet TE1, as illustrated by arrows AR1005 in FIG. 38A. Subsequently, the sucker sucks a portion of the sheet TE1 between the chip support plates 9111a1 and 9111a2, as illustrated by an arrow AR1006 in FIG. 38A. Next, the pickup mechanism 10111, by moving the chip support pins 10111a vertically upward as illustrated by an arrow AR1007 in FIG. 38B, pushes up the portion of the sheet TE1 at which the chip CP facing the Bernoulli chuck 9711 is stuck vertically upward. The pushed-up chip CP is handed over to the Bernoulli chuck 9711. That is, the pickup mechanism 10111 pushes up a portion of the sheet TE1 at which a chip CP is stuck in such a way that the chip CP is kept in such an attitude that the bonding surface CPf of the chip CP is parallel with a plane orthogonal to the vertical direction, by use of only the chip support pins 10111a without supporting the chip CP from the vertically upper side of the chip CP. Because of this configuration, when a portion of the sheet TE1 at which a chip CP is stuck is pushed up, the chip CP is prevented from coming into contact with the guide 9711a of the Bernoulli chuck 9711. Note that timing at which the sucker sucks the sheet TE1 may be a timing after the chip support pins 10111a have pushed up a portion of the sheet TE1 at which a chip CP is stuck.

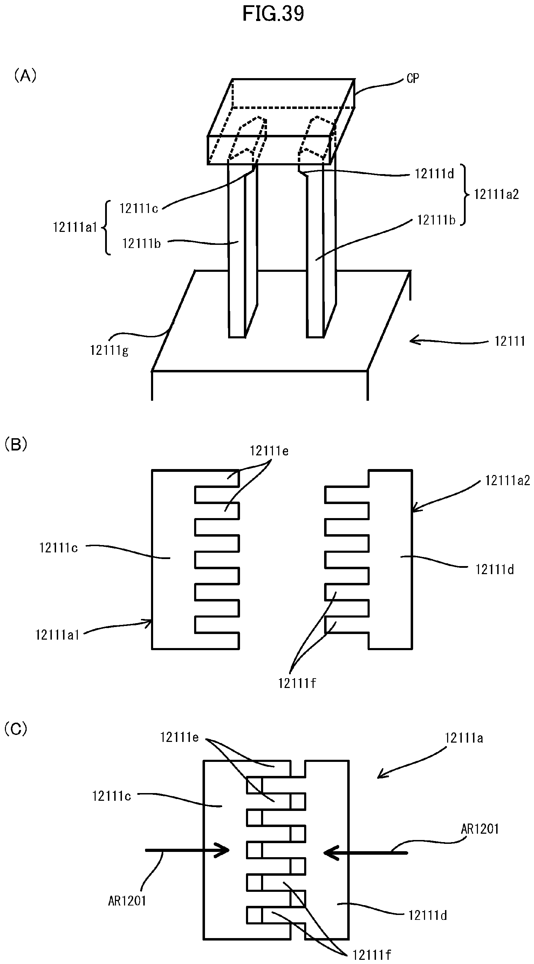

In Embodiment 1, as illustrated in, for example, FIG. 39A, a pickup mechanism 12111 may be a pickup mechanism that includes two chip support plates 12111a1 and 12111a2 including hook-shaped heads 12111c and 12111d at tip portions thereof, respectively. In this configuration, the chip support plates 12111a1 and 12111a2 include long plate-shaped bodies 12111b and the heads 12111c and 12111d, respectively. In addition, the pickup mechanism 12111 includes a support plate driver 12111g to, by moving the two chip support plates 12111a1 and 12111a2 in a direction orthogonal to an extending direction thereof, bring the two chip support plates 12111a1 and 12111a2 close to each other.

The heads 12111c and 12111d include protrusions 12111e and 12111f, respectively, which are formed in long plate shapes and protrude to the sides opposite to each other, as illustrated in FIG. 39B. In this configuration, when the support plate driver 12111g moves the chip support plates 12111a1 and 12111a2 in the direction in which the chip support plates 12111a1 and 12111a2 come close to each other as illustrated by arrows AR1201 in FIG. 39C, the chip support plates 12111a1 and 12111a2 are brought into a state where one of the protrusions 12111e and 12111f are fitted between the other thereof. Note that the shapes of the heads 12111c and 12111d are not limited to the shapes illustrated in FIGS. 39A to 39C and may be any other shapes as long as the shapes allow portions of one of the heads 12111c and 12111d to be fitted between portions of the other thereof.

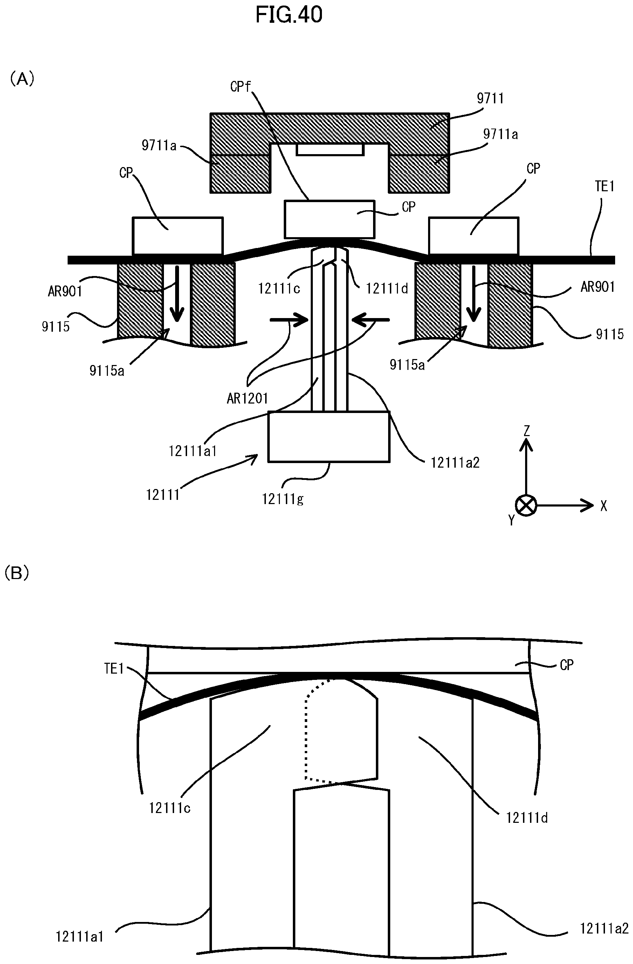

The pickup mechanism 12111 according to the present variation presses the heads 12111c and 12111d at the tip portions of the chip support plates 12111a1 and 12111a2 against a portion of the sheet TE1 at which the chip CP facing the Bernoulli chuck 9711 is stuck, as illustrated in FIG. 40A. The support driver 12111g, by moving the chip support plates 12111a1 and 12111a2 in the direction in which the chip support plates 12111a1 and 12111a2 are brought close to each other as illustrated by arrows AR1201 in FIG. 40A, causes the heads 12111c and 12111d to scrape the portion of the sheet TE1 at which the chip CP facing the Bernoulli chuck 9711 is stuck. On this occasion, the support driver 12111g moves the chip support plates 12111a1 and 12111a2 until the heads 12111c and 12111d come to overlap each other when viewed from the Y-axis direction, as illustrated in FIG. 40B. This processing brings the chip CP facing the Bernoulli chuck 9711 into a state of being easily separated from the sheet TE1. The pickup mechanism 12111 returns the chip support plates 12111a1 and 12111a2 to the original positions and thereafter moves the chip support plates 12111a1 and 12111a2 vertically upward. Through this processing, the portion of the sheet TE1 at which the chip CP facing the Bernoulli chuck 9711 is stuck is pushed up vertically upward, and the pushed-up chip CP is handed over to the Bernoulli chuck 9711.

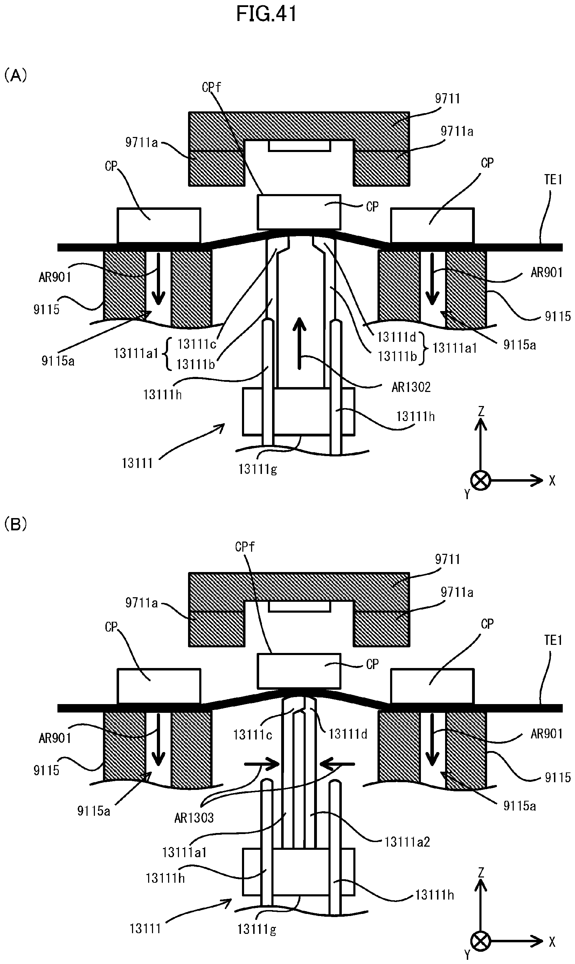

In addition, the chip feeder may be a chip feeder that includes a pickup mechanism 13111 including, in conjunction with chip support pins 13111h, separation members 13111a1 and 13111a2 to scrape the portion of the sheet TE1 at which the chip CP facing the Bernoulli chuck 9711 is stuck and thereby separate the chip CP from the sheet TE1 and a separation member driver 13111g, as illustrated in FIG. 41A. The chip support pins 13111h are, for example, provided in a number of four. However, the number of the chip support pins 13111h may be three or five or more. The chip support pins 13111h support a chip CP in such an attitude that the bonding surface CPf of the chip CP is parallel with a plane orthogonal to the vertical direction. The separation members 13111a1 and 13111a2 have similar configurations to those of the afore-described chip support plates 12111a1 and 12111a2 and include long plate-shaped main bodies 13111b and the heads 13111c and 13111d at tip portions thereof, respectively. Note that the shapes of the heads 13111c and 13111d are not limited to the shapes illustrated in FIG. 41A and may be any other shapes as long as the shapes allow portions of one of the heads 13111c and 13111d to be fitted between portions of the other thereof.

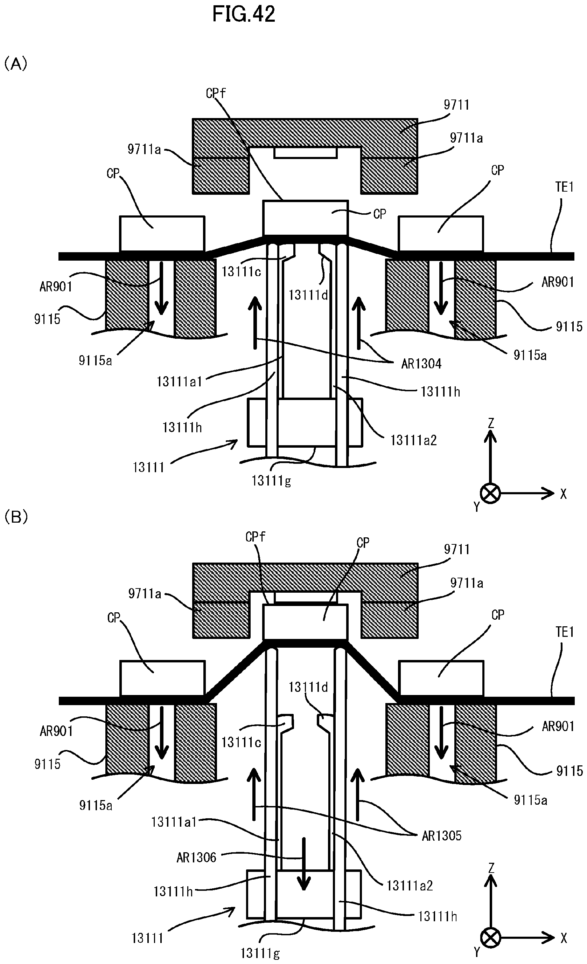

Operation of the chip feeder according to the present variation is now described, referring to FIGS. 41 and 42. First, the pickup mechanism 13111 bring the heads 13111c and 13111d of the separation members 13111a1 and 13111a2 from standby positions close to the portion of the sheet TE1 at which the chip CP facing the Bernoulli chuck 9711 is stuck, as illustrated by an arrow AR1302 in FIG. 41A. Next, the pickup mechanism 13111, by moving the separation members 13111a1 and 13111a2 in the direction in which the separation members 13111a1 and 13111a2 are brought close to each other with the heads 13111c and 13111d pressed against the sheet TE1 as illustrated by arrows AR1303 in FIG. 41B, causes the heads 13111c and 13111d to scrape the portion of the sheet TE1 at which the chip CP facing the Bernoulli chuck 9711 is stuck. Note that, in the state illustrated in FIG. 41B, tip portions of the chip support pins 13111h may be arranged in a vicinity of the sheet TE1. This configuration enables the attitude of the chip CP to be stabilized. Succeedingly, the pickup mechanism 13111 returns the positions of the separation members 13111a1 and 13111a2 to standby positions, as illustrated in FIG. 42A. Subsequently, the chip feeder, by moving the chip support pins 13111h vertically upward, brings the tip portions of the chip support pins 13111h into contact with the sheet TE1, as illustrated by arrows AR1304 in FIG. 42A. Subsequently, the chip feeder, by use of the chip support pins 13111h, pushes up the portion of the sheet TE1 at which the chip CP facing the Bernoulli chuck 9711 is stuck vertically upward, as illustrated by arrows AR1305 in FIG. 42B. The pushed-up chip CP is transferred to the Bernoulli chuck 9711. On this occasion, the chip feeder, by moving the separation members 13111a1 and 13111a2 vertically downward, returns the separation members 13111a1 and 13111a2 to the standby positions, as illustrated by an arrow AR1306 in FIG. 42B.

According to the present configuration, the pickup mechanism 9111 or 12111, by use of the chip support plates 9111a1 and 9111a2 or 12111a1 and 12111a2, supports a chip CP in such an attitude that the bonding surface CPf of the chip CP is parallel with a plane orthogonal to the vertical direction. In addition, the pickup mechanism 10111 or 13111, by use of the chip support pins 10111a or 13111h, supports a chip CP in such an attitude that the bonding surface CPf of the chip CP is parallel with a plane orthogonal to the vertical direction. Because of this configuration, the pickup mechanism 9111, 10111, 12111, or 13111 is capable of transferring a chip CP to the Bernoulli chuck 9711 while maintaining the chip CP in such an attitude that the bonding surface CPf of the chip CP is parallel with a plane orthogonal to the vertical direction. Therefore, when the pickup mechanism 9111, 10111, 12111, or 13111 transfers a chip CP to the Bernoulli chuck 9711, a handling error by the Bernoulli chuck 9711 caused by inclination of the attitude of the chip CP is prevented from occurring.

In addition, according to the present configuration, when the pickup mechanism 9111 transfers a chip CP to the Bernoulli chuck 9711, the pickup mechanism 9111 scrapes the portion of the sheet TE1 at which the chip CP facing the Bernoulli chuck 9711 is stuck by the tip portions of the chip support plates 9111a1 and 9111a2 or 12111a1 and 12111a2. In addition, when the pickup mechanism 10111 transfers a chip CP to the Bernoulli chuck 9711, the pickup mechanism 10111 presses the tip portions of the separation pins 10111b against the portion of the sheet TE1 at which the chip CP facing the Bernoulli chuck 9711 is stuck. Further, when the pickup mechanism 13111 transfers a chip CP to the Bernoulli chuck 9711, the pickup mechanism 13111 scrapes the portion of the sheet TE1 at which the chip CP facing the Bernoulli chuck 9711 is stuck by the heads 13111c and 13111d of the separation members 13111a1 and 13111a2. There is an advantage that, since this processing brings the chip CP facing the Bernoulli chuck 9711 into a state of being easily separated from the sheet TE1, the chip CP is smoothly transferred from the sheet TE1 to the Bernoulli chuck 9711.

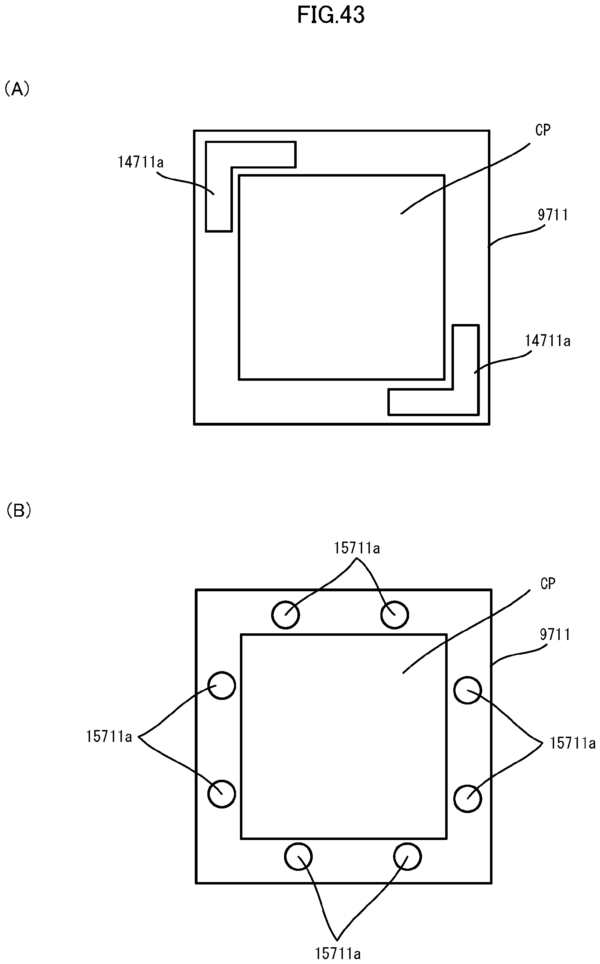

In addition, although, in the afore-described variation, an example in which the rectangular frame-shaped guide 9711a is disposed on the Bernoulli chuck 9711 was described, the shape of the guide is not limited thereto. For example, as illustrated in FIG. 43A, guides 12711a may be L-shaped guides in plan view that are disposed at portions of the Bernoulli chuck 9711 surrounding two corner portions of a chip CP with the chip CP held by the Bernoulli chuck 9711. Alternatively, as illustrated in FIG. 43B, guides 13711a may be pin-like guides that are disposed at a plurality of sites on a part of the Bernoulli chuck 9711 surrounding a chip CP with the chip CP held by the Bernoulli chuck 9711.

In addition, the afore-described chip mounting system 5 according to the variation described using FIGS. 26 to 32 may be a chip mounting system that includes, in conjunction with the first chip transporter 5039, a second chip transporter (not illustrated) to transport a chip CP fed from the chip feeder 5011 to a position at which the chip CP is transferred to the first chip holder 5393 of the first chip feeder 5039. In this case, since lengths of the plates 5391 and the arms 5394 of the first chip transporter 5039 can be reduced, the first chip transporter 5039 can be miniaturized.

In Embodiment 1, the chip feeder may be a chip feeder that includes the afore-described pickup mechanism 9111, 10111, 12111, or 13111. In this case, the pickup mechanism 9111, 10111, 12111, or 13111 may be a pickup mechanism that, at the time of transferring a chip CP to the first chip holder 512, moves the chip support pins 10111a or 13111h or the chip support plates 9111a1 and 9111a2 or 12111a1 and 12111a2 until the tip portions of the chip support pins 10111a or 13111h or the tip portions of the chip support plates 9111a1 and 9111a2 or 12111a1 and 12111a2 are arranged on the vertically upper side of the first chip holder 512. For example, it is only required to hold a portion of a chip CP on the outer side of the chip support pins 10111a or 13111h where the sheet TE1 is separated, by the first chip holder 512.

The chip feeder in each of the embodiments may have a configuration to cut out a chip CP upward or a configuration to cut out a chip CP downward.

In Embodiment 2, the chip feeder may be a chip feeder that holds the sheet TE on which the opposite side to the bonding surface CPf side of each of a plurality of chips CP is stuck in such an attitude that the bonding surfaces CPf face vertically upward. In this case, the second chip transporter may be a chip transporter that holds a chip CP cut out by the pickup mechanism by use of the second chip holder, which is a Bernoulli chuck, in a non-contact state with the bonding surface CPf of the chip CP and hands over the chip CP to the first chip transporter as it is without inverting the chip CP. In this configuration, the first chip transporter may be the first chip transporter 5039, which is a turret according to the variation described using, for example, FIGS. 26 and 27.

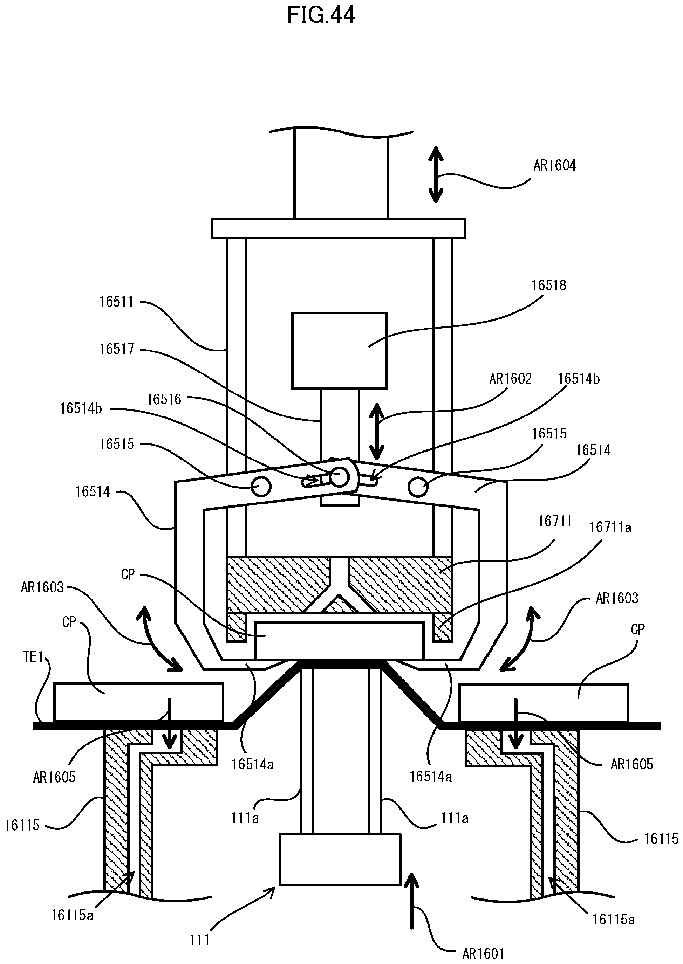

In the respective embodiments and the respective variations described using FIGS. 26 to 43, the chip feeding device may be a chip feeding device that includes a first chip transporter including a plurality of hooks that can be switched between a state of being hooked on a peripheral portion of a chip CP from the vertically lower side and a state of being detached from the chip CP. The first chip transporter according to the present variation includes, as illustrated in, for example, FIG. 44, a transporter body 16511, a Bernoulli chuck 16711 fixed to the transporter body 16511, and a body driver (not illustrated) to drive the transporter body 16511 in the vertical direction as illustrated by an arrow AR1604. Note that, in FIG. 44, the same reference signs as those in FIG. 1 are assigned to the same constituent components as those in Embodiment 1. On the Bernoulli chuck 16711, a guide 16711a to prevent misalignment of a chip CP is disposed. In addition, the first chip transporter includes two arms 16514 at the tip portions of which hooks 16514a are disposed and supports 16515 fixed to the transporter body 16511 and configured to respectively support the two arms 16514 in a freely rotatable manner. Further, the first chip transporter includes two arms 16514 at the tip portions of which hooks 16514a are disposed and supports 16515 fixed to the transporter body 16511 and configured to respectively support the two arms 16514 in a freely rotatable manner. In addition, the first chip transporter includes a moving member 16517 at the tip portion of which a pin 16516, which is inserted into elongated openings 16514b respectively bored in base end portions of the two arms 16514, is disposed and a hook driver 16518 to drive the moving member 16517 in the vertical direction.

In addition, a chip feeder according to the present variation includes suction units 16115 each of which includes a sucker 16115a to suck a portion of the sheet TE1 at which a chip CP adjacent to a chip CP facing the Bernoulli chuck 16711 is stuck. In addition, the chip CP facing the Bernoulli chuck 9711 is equivalent to a chip CP cut out by the pickup mechanism 111. Further, the chips CP adjacent to the chip CP facing the Bernoulli chuck 16711 are equivalent to chips CP other than the chip CP cut out by the pickup mechanism 111. Each of the suction units 16115 sucks a portion of the sheet TE1 at which a chip CP adjacent to the chip CP facing the Bernoulli chuck 16711 is stuck from the opposite side to the side of the sheet TE1 on which chips CP are stuck, as illustrated by an arrow 1605.

The hook driver 16518 moves the hooks 16514a by moving the moving member 16517 in the vertical direction as illustrated by an arrow AR1602 and thereby rotating the arms 16514 with the pins 16516 as a fulcrum as illustrated by arrows AR1603. When the pickup mechanism 111 cuts out one chip CP from among a plurality of chips CP as illustrated by an arrow AR1601, the hook driver 16518 rotates the arms 16514 and thereby hooks the hooks 16514a on a peripheral portion on the vertically lower side of the chip CP from the vertically lower side. On this occasion, the hooks 16514a of the arms 16514 are inserted between a surface on the sheet TE1 side of the chip CP and the sheet TE1. Because of this configuration, even when the sheet TE1 is stuck to the peripheral portion of the chip CP with the chip CP raised vertically upward, the sheet TE1 is separated from the peripheral portion of the chip CP by the hooks 16514a. When the chip CP is held by the Bernoulli chuck 16711, the hook driver 16518 rotates the arms 16514 and thereby detaches the hooks 16514a from the chip CP.

According to the present configuration, since the sheet TE1 can be separated from a peripheral portion of a chip CP even when, for example, adhesive force of the sheet TE1 is comparatively strong, occurrence of a chucking error of a chip CP by the Bernoulli chuck 16711 is prevented. In addition, according to the present configuration, the hooks 16514a are hooked on the peripheral portion on the vertically lower side of a chip CP from the vertically lower side with the Bernoulli chuck 16711 arranged vertically directly above the chip CP. Since, because of this configuration, even a chip CP having jumped up vertically upward at the time of, for example, cutting the chip CP out can be caught by the Bernoulli chuck 16711, there is also an advantage that flying-off of a chip CP is prevented.

Although, in the present variation, an example in which the above-described configuration is applied to the first chip transporter was described, the present disclosure is not limited thereto, and the above-described configuration may be applied to a second chip transporter that has the same configuration as the afore-described configuration and that transports a chip CP to the first chip transporter. In addition, in the present variation, the first chip transporter may have a configuration in which the Bernoulli chuck 16711 is not included. In this case, the first chip transporter is only required to transport a chip CP while holding the chip CP by use of the plurality of hooks 16514a.

In the case where the guide 16711a is disposed on the Bernoulli chuck 16711 as in the present variation, when the Bernoulli chuck 16711 is brought close to the sheet TE1 on which chips CP are stuck, the pickup mechanism 111 needs to raise a chip CP to be cut out to a height within a range that prevents the guide 16711a from coming into contact with chips CP adjacent to the chip CP. Since, on this occasion, the sheet TE1 is caused to protrude in a direction coming close to the Bernoulli chuck 16711 and is extended, a gap between chips CP adjacent to each other is preferably set to a length that, when the sheet TE1 is caused to protrude, does not allow chips CP adjacent to the chip CP to be cut out to come close to the Bernoulli chuck 16711. In addition, when the hooks 16514a are inserted to a peripheral portion on the vertically lower side of the chip CP, a wide gap between chips CP adjacent to each other is also advantageous.

In addition, as the sheet TE1, a sheet that, when being extended, causes a gap between chips CP adjacent to each other to be easily enlarged is preferably used. In addition, it may be configured such that, on the sheet TE1, chips CP are rearranged in such a way that a gap between chips CP adjacent to each other is enlarged. Alternatively, the chip feeder may be a chip feeder that includes a heater to, when the pickup mechanism 111 raises a chip CP vertically upward and cuts out the chip CP, heat the sheet TE1 from the vertically lower side of the sheet TE1 and make the sheet TE1 easily extendable. In this configuration, the heater is only required to be a heater that includes, for example, a mechanism to discharge hot air. Further, the chip feeder may be a chip feeder that includes a light source to irradiate the sheet TE1 with infrared light or ultraviolet light and thereby make the sheet TE1 easily extendable.

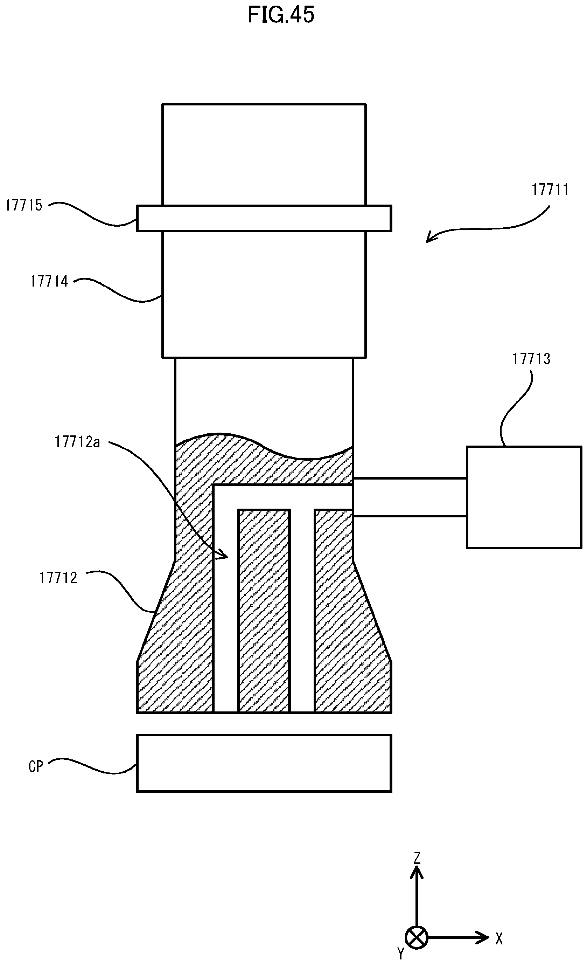

In Embodiment 2, the second chip holder 2114a of the second chip transporter 2114 may be a non-contact chuck 17711 as illustrated in, for example, FIG. 45. The non-contact chuck 17711 includes a chuck body 17712, a negative pressure generator 17713, an ultrasonic wave generator 17714, and a support member 17715 to support the ultrasonic wave generator 17714. The chuck body 17712 has a flow channel 17712a formed in the interior thereof, the flow channel 17712a communicating with the side on which a chip CP that the non-contact chuck 17711 holds is located (-Z-direction side). The negative pressure generator 17713 sucks a chip CP by generating a negative pressure of 8 kPa to 40 kPa inside the flow channel 17712a of the chuck body 17712. The ultrasonic wave generator 17714 generates ultrasonic waves in an interspace between the chuck body 17712 and a chip CP by vibrating the chuck body 17712 at a high frequency of several MHz and thereby compresses and diffuses gas existing in the interspace. This processing causes a thin gas film, that is, a squeezed film, to be formed on the -Z-direction side of the chuck body 17112. The chip CP is maintained in a state of floating on the squeezed film on the -Z-direction side of the chuck body 17712. In other words, the non-contact chuck 17711 holds a chip CP in a non-contact manner by using in combination suction force on the chip CP generated by the negative pressure generator 17713 and repulsive force against the chip CP induced by ultrasonic waves generated by the ultrasonic wave generator 17714.

Note that, although, in the present variation, an example in which the second chip holder of the second chip transporter is the non-contact chuck illustrated in FIG. 45 was described, the present disclosure is not limited thereto, and the first chip holder 4512 of the first chip transporter 4051, which was described using, for example, FIG. 18, may be the non-contact chuck illustrated in FIG. 45.

In the case of the afore-described Bernoulli chuck, the amount of exhaust air from the Bernoulli chuck is comparatively large. Thus, when air flow is generated in the bonding device 30 or 4030 or the chip feeding device 2010 or 4010 in order to, for example, remove particles having adhered to the wiring board WT or a chip CP, there is a possibility that the exhaust air from the Bernoulli chuck influences the air flow. In addition, the exhaust air may disperse particles on the chip CP.

In contrast, according to the present configuration, since no air is exhausted from the non-contact chuck 17711, it is possible to eliminate influence on air flow generated in the bonding device 30 or 4030 or the chip feeding device 2010 or 4010. In addition, according to the present configuration, a chip CP being sucked to the chuck body 17712 by the negative pressure generator 17713 causes occurrence of misalignment of the chip CP to be prevented. Therefore, there is an advantage that necessity to adjust the attitude of a chip CP before transferring the chip CP to the head 33H or 4033H of the bonder 30 or 4030 is eliminated. In addition, since particles having adhered to a chip CP are also sucked, the particles having adhered to the chip CP are removed. In addition, there is another advantage that the non-contact chuck 17111 according to the present configuration has higher suction force than a Bernoulli chuck.

In the respective embodiments, as the method for cutting out a chip CP from a sheet, any one of a method of pushing up the chip CP with needles, a method of reducing contact area by sucking a concave-convex surface, a method of separating the sheet by scraping a surface on the opposite side of the sheet to the bonding surface CPf side of the chip CP with a plate-shaped member, a method of reducing adhesion of the sheet by irradiating the sheet with ultraviolet light, a method of reducing adhesion of the sheet by heating the sheet, and the like may be employed. In addition, the above-described respective methods are effective for not only the method for cutting out a chip CP from a sheet but also the method for cutting out a chip placed on a tray. In addition, as the sheet, a sheet having an adhesive material, which, when being irradiated with ultraviolet rays, foams and has adhesive force reduced, applied on a surface having adhesion on the side on which a chip CP is stuck may be used. Further, in the case where adhesive force of a sheet is reduced by irradiating the sheet with ultraviolet rays, the chip feeder may be a chip feeder that includes an ultraviolet ray irradiator to, when the pickup mechanism cuts out at least one component from among a plurality of components stuck on the sheet, irradiate the sheet with ultraviolet rays. In addition, the pickup mechanism may be a pickup mechanism that includes a glass tool (not illustrated), which is transparent to ultraviolet rays, and in which the ultraviolet ray irradiator causes ultraviolet rays to be incident into the glass tool with the glass tool pushing up a portion of the sheet at which a chip CP is stuck. In this case, the sheet is irradiated with ultraviolet rays that propagate in the glass tool and are emitted from the sheet side of the glass tool, and adhesive force of the sheet is reduced. Note that it may be configured to cut out a chip CP by, after the pickup mechanism has irradiated a portion of the sheet TE at which the chip CP is stuck with ultraviolet rays, pushing up the portion with needles or scraping the portion with a separation member. In addition, it may be configured such that, after the pickup mechanism has irradiated a portion of the sheet TE at which the chip CP is stuck with ultraviolet rays, the first chip transporter or the second chip transporter holds the chip CP stuck on the portion by use of the first chip holder or the second chip holder and picks up the chip CP.

In other words, it may be configured such that, after the chip CP has been made easily separable from the sheet TE by irradiating a portion of the sheet TE at which the chip CP is stuck with ultraviolet rays, the chip CP is cut out by pushing up the portion with needles or scraping the sheet TE with a separation member. In addition, it may be configured such that, after the chip CP has been brought into a state of being easily separated from the sheet TE by irradiating a portion of the sheet TE at which the chip CP is stuck with ultraviolet rays, the chip CP is picked up as it is by the first chip transporter or the second chip transporter. Further, it may be configured to separate the chip CP from the sheet TE by, while pushing up a portion of the sheet TE at which the chip CP is stuck by use of a glass tool that is transparent to ultraviolet rays, irradiating the portion with ultraviolet rays through the glass tool. In addition, it may be configured such that a sheet TE having a material that foams when being irradiated with ultraviolet rays applied on a side thereof on which a chip CP is stuck is used and, after the chip CP has been made easily separable from the sheet TE by irradiating the sheet TE with ultraviolet rays, the chip CP is picked up as it is by the first chip transporter or the second chip transporter.

In addition, in the afore-described variation, timing at which holes are bored in the sheet TE1 does not have to be a timing before the sheet TE1 is input to the chip mounting system. For example, at a timing at which the afore-described separation pins 10111b are brought into contact with the sheet TE1 or a timing at which the separation members 13111a1 and 13111a2 are moved to the inner side, holes may be bored at positions on the sheet TE1 with which the chip support pins 10111a or 13111h on the outer side of the separation pins 10111b or separation members 13111a1 and 13111a2 come into contact. In addition, it may be configured to, while separating a peripheral portion of the chip CP from the sheet TE1, bore holes in the sheet TE1 in a similar manner, at a position other than a position at which the pickup mechanism is disposed or by a device other than the chip feeding device 10.

When, in the case where no hole is formed in the sheet TE1 as in Embodiment 1, the needles 111a penetrate the sheet TE1, there is a case where adhesive material contained in the sheet TE1 adheres to tip portions of the needles and the adhesive material adheres to the chip CP. This case is problematic because, at the time of transportation of the chip CP, the adhesive material sometimes adheres to the head 33H, the first chip holder, or the like or falls in the chip mounting system and becomes waste. Therefore, in Embodiment 1, it is preferable to, by forming recesses at portions on the head 33H, the first chip holder, or the like corresponding to positions on a chip CP with which the needles 111a come into contact, prevent the head 33H, the first chip holder, the respective stages, or the like from coming into contact with portions of a chip CP with which the tip portions of the needles 111a came into contact.

In the afore-described variation, the chip mounting system may have a configuration in which, in the cleaner 5037, a discharge hole (not illustrated) to discharge gas, such as water, nitrogen, and the air, to a portion of the chip stage 5036 at which a chip CP is to be placed is disposed. In this case, it may be configured such that the cleaner cleans the back surface of a chip CP having been transported to the cleaner with gas, such as water, nitrogen, and the air, discharged from the discharge hole.

In the respective embodiments, the head 33H may be a head that is configured to protrude a suction post from a central portion thereof and thereby transfer a chip CP to the head 33H and that incorporates, on the inside of the suction post, a pressing mechanism to press a central portion of a chip CP at the time of bonding the chip CP to the wiring board WT. This configuration is preferable because the configuration enables simultaneous establishment of a post pin and a center push mechanism.

Note that, in the afore-described embodiments and variations, examples of "cutting out" include feeding a chip CP by pushing out the chip CP by needles, feeding a chip CP by sucking an adhesive sheet, and feeding a chip CP by irradiating a sheet with ultraviolet rays.

The foregoing describes some example embodiments for explanatory purposes. Although the foregoing discussion has presented specific embodiments, persons skilled in the art will recognize that changes may be made in form and detail without departing from the broader spirit and scope of the invention. Accordingly, the specification and drawings are to be regarded in an illustrative rather than a restrictive sense. This detailed description, therefore, is not to be taken in a limiting sense, and the scope of the invention is defined only by the included claims, along with the full range of equivalents to which such claims are entitled.

### Industrial Applicability

The present disclosure is suitable for manufacturing of, for example, CMOS image sensors, memories, arithmetic elements, or MEMSes.

### Reference Signs List

1, 2, 3, 4, 5 Chip mounting system
10, 2010, 3010, 4010, 5010Chip feeding device
11, 2011, 3011, 5011 Chip feeder
30, 4030 Bonding device
31 Stage
32 Stage driver
33, 4033 Bonder
33H, 4033H Head
36 Head driver
51, 4051, 5039 First chip transporter
114 Cover
114a Hole
90, 2090, 3090, 4090 Controller
111, 2111, 3111, 9111, 10111, 12111, 13111 Pickup mechanism
111a, 2111a, 3111aNeedle
112 Sheet holding frame
113 Holding frame driver
119 Frame holder
2115 Inverter
411,4411,8411 Chip tool
411a, 411b, 411c, 2115f, 3114f, 8411b, 8411c Through-hole
413,4413,8413 Head body
431 Pressing mechanism
431a Pressing rod
431b Pressing driver
432a Chip support
432b Support driver
440 Holding mechanism
511, 4511 Main body
512, 4512, 5393 First chip holder
513 Chip cover
2114 Second chip transporter
2114a Second chip holder
2114b, 3114c Sliding body
2114c, 3114d Guide rail
2115 Inverter
2115a Suction head
2115b, 3114b, 16514 Arm
2115c Arm driver
2115e, 3114e, 9115a Sucker
2115g, 3114g Chip support
2115i, 3114i Support driver
3114 Third chip transporter
3114a Third chip holder
5036 Chip stage
5037 Cleaner
5037a Cleaning head
5038 Chip collector
5391 Plate
5392 Plate driver
5394 Arm
6116 Tray
6116a Tray body
6116b, 7116b Recess
6116c, 7116c Support
6116d Communication hole
6117, 7117 Sucker
7116 Chip feeding head
7116aHead body
7116d Suction hole
8111a, 8432a Suction post
8111b, 8432b Suction post driver
8440 Suction hole
8617, ATE1, ATE2 Adhesive sheet
8711, 9711, 16711 Bernoulli chuck
9111a1, 9111a2, 12111a1, 12111a2 Chip support plate
9111b, 13111b Main body
9111c, 9111d, 10111c, 10111d Head
9111e, 9111f Protrusion
9111g, 10111g, 12111g Support driver
9115 Suction unit
9711a, 14711a, 15711a Guide
10111b Separation pin
13111a Separation member
13111g Separation member driver
10111a, 13111h Chip support pin
16116 Suction unit
16115a Sucker
16511 Transporter body
16514a Hook
16514b Elongated opening
16516Pin
16517Moving member
16518Hook driver
16711a Guide
17711Non-contact chuck
17712 Chuck body
17712a Flow channel
17713 Negative pressure generator
17714Ultrasonic wave generator
17715 Support member
CP Chip
CPf Bonding surface
P61, P62 Contact portion
Pos1 Transfer position
Pos2 Receipt position
HA10 Hole
TE, TE1, TE10 Sheet
WT Wiring board
WTf Mounting surface

## Claims

1. A component mounting system to mount a component on a wiring board, comprising:
a component feeder to feed the component;
a head to hold, at a tip portion of the head, an opposite side to a bonding surface side of the component, the bonding surface being to be bonded to a mounting surface of the wiring board;
a first component transporter including a first component holder to hold, in a non-contact manner, the bonding surface side of the component fed from the component feeder and configured to, with the first component holder holding the component, transport the component to a transfer position at which the component is transferred to the head;
a wiring board holder to hold the wiring board; and
a head driver to mount the component on the mounting surface by, with the component, which has been transferred from the first component transporter, held at a tip portion of the head, moving the head relatively in a first direction, the first direction pointing from the head to the wiring board holder, and bringing a bonding surface of the component into contact with the mounting surface of the wiring board.

2. The component mounting system according to claim 1, wherein
the head has a component support disposed at a tip portion of the head, the component support being freely movable in a vertical direction while supporting a first part of the component on an opposite side to a bonding surface side of the component, the bonding surface being to be bonded to a mounting surface of the wiring board,
the component mounting system further comprises a support driver to, with the first component holder, which holds the component, located at the transfer position and supporting the first part of the component by the component support, transfer the component from the first component holder to the head by moving the component support relatively to the first direction side of the first component holder,
the first component transporter includes a first component holder to hold a second part on an opposite side to the bonding surface side of the component fed from the component feeder, the second part being different from a first part, and, with the first component holder holding the component, transports the component to a transfer position at which the component is transferred to the head, and
the head driver mounts the component on the mounting surface by, with the component, which has been transferred from the first component transporter, held at a tip portion of the head, moving the head relatively in a first direction, the first direction pointing from the head to the wiring board holder, and bringing a bonding surface of the component into contact with the mounting surface of the wiring board.

3. The component mounting system according to claim 2, wherein the first component transporter includes a component cover to cover the bonding surface side of the component with the component held by the first component holder.

4. The component mounting system according to claim 2 or 3, wherein
the component feeder includes a pickup mechanism to, from among a plurality of components, hold a third part on an opposite side to the bonding surface side of at least one component among the plurality of components, the third part being different from a first part, and cut out the component, and
the first component transporter receives the at least one component with the second part held by the first component holder.

5. The component mounting system according to claim 1, wherein
the component feeder includes a pickup mechanism to, from among a plurality of components, cut out at least one component among the plurality of components, and
the first component transporter receives the at least one component in a non-contact manner with the bonding surface side of the component.

6. The component mounting system according to claim 1 or 5, wherein the first component holder is a Bernoulli chuck.

7. The component mounting system according to claim 1 or 5, wherein the first component holder is a non-contact chuck including a chuck body in which a flow channel communicating with a side on which the first component holder holds the component is formed, a negative pressure generator to make pressure inside the flow channel negative, and an ultrasonic wave generator to generate ultrasonic waves between the chuck body and the component by vibrating the chuck body.

8. The component mounting system according to claim 1, wherein
the component feeder further includes a sheet holder to hold a sheet, the sheet being stuck on an opposite side to the bonding surface side of each of a plurality of components, and a pickup mechanism to cut out, from among a plurality of components, at least one component among the plurality of components, and
the pickup mechanism includes three or more component support pins or a plurality of long plate-shaped component support plates to support each of the at least one component in such an attitude that a bonding surface of each of the at least one component is parallel with a plane orthogonal to a vertical direction without supporting the bonding surface side of each of the at least one component and transfers the at least one component to the first component holder by pushing out a portion of the sheet at which the at least one component is stuck to the first component holder side by use of the component support pins or the component support plates.

9. The component mounting system according to claim 8, wherein, when the pickup mechanism transfers the at least one component to the first component holder, the pickup mechanism moves the three or more component support pins or the plurality of component support plates until tip portions of the three or more component support pins or the plurality of component support plates are arranged on a vertically upper side of the first component holder.

10. The component mounting system according to claim 8, wherein
the component feeder further includes a sheet holder to hold a sheet, the sheet being stuck on an opposite side to the bonding surface side of each of a plurality of components, and
the pickup mechanism includes three or more component support pins or a plurality of long plate-shaped component support plates to support each of the at least one component in such an attitude that a bonding surface of each of the at least one component is parallel with a plane orthogonal to a vertical direction and transfers the at least one component to the first component holder by pushing out a portion of the sheet at which the at least one component is stuck to the first component holder side by use of the component support pins or the component support plates.

11. The component mounting system according to any one of claims 8 to 10, wherein
the component feeder further includes
a suction unit to suck a portion of the sheet at which a component other than the at least one component, which is to be cut out by the pickup mechanism, is stuck from an opposite side to a side of the sheet on which the plurality of component is stuck, and
the pickup mechanism pushes out a portion of the sheet at which the at least one component is stuck to the first component holder side with a portion at which a component other than the at least one component is stuck sucked by the suction unit.

12. The component mounting system according to any one of claims 8 to 11, wherein the pickup mechanism, after separating the at least one component from the sheet by moving the three or more component support pins or the plurality of component support plates with tip portions of the three or more component support pins or the plurality of component support plates pressed against a portion of the sheet at which the at least one component is stuck, pushes out a portion of the sheet at which the at least one component is stuck to the first component holder side by use of the three or more component support pins or the plurality of component support plates.

13. The component mounting system according to claim 12, wherein the pickup mechanism includes the plurality of component support plates, and, after scraping the sheet by moving the plurality of component support plates in a direction in which the plurality of component support plates comes close to each other with tip portions of the plurality of component support plates pressed against a portion of the sheet at which the at least one component is stuck, moves the plurality of component support plates in a direction in which the plurality of component support plates separates away from each other and subsequently pushes out a portion of the sheet at which the at least one component is stuck to the first component holder side by use of the plurality of component support plates.

14. The component mounting system according to any one of claims 8 to 11, wherein the pickup mechanism includes, in conjunction with the three or more component support pins, a plurality of separation pins to make the component easily separable from the sheet, and, after pressing tip portions of the plurality of separation pins against a portion of the sheet at which the at least one component is stuck with tip portions of the three or more component support pins pressed against a portion of the sheet at which the at least one component is stuck, detaches tip portions of the three or more component support pins from the sheet and subsequently pushes out a portion of the sheet at which the at least one component is stuck to the first component holder side by use of the component support pins with tip portions of the three or more component support pins pressed against a portion of the sheet at which the at least one component is stuck.

15. The component mounting system according to claim 13 or 14, wherein, when the pickup mechanism pushes out a portion of the sheet at which the at least one component is stuck to the first component holder side, the pickup mechanism sucks a portion of the sheet at which the at least one component is stuck from an opposite side to a side of the sheet on which the at least one component is stuck.

16. The component mounting system according to any one of claims 8 to 11, wherein the pickup mechanism includes, in conjunction with the three or more component support pins, a plurality of separation members to make the component easily separable from the sheet and, after scraping the sheet by moving the plurality of separation members in a direction in which the plurality of separation members comes close to each other with tip portions of the plurality of separation members pressed against a portion of the sheet at which the at least one component is stuck, pushes out a portion of the sheet at which the at least one component is stuck to the first component holder side by use of the component support pins.

17. The component mounting system according to any one of claims 1 to 16, wherein
the component feeder or the first component transporter includes:
a plurality of hooks that is switched between a state of being hooked on a peripheral portion of the at least one component from a vertically lower side and a state of being detached from the at least one component; and
a hook driver to, when the component feeder feeds the component, cause the plurality of hooks to hold the at least one component by causing the plurality of hooks to be hooked on a peripheral portion on a vertically lower side of the at least one component from the vertically lower side.

18. The component mounting system according to any one of claims 1 to 3, wherein
the component feeder includes:
a sheet holder to hold a sheet, the sheet being stuck on an opposite side to the bonding surface side of each of a plurality of components; and
a pickup mechanism to, by cutting out at least one component among the plurality of components from an opposite side to a side of the sheet on which the plurality of components is stuck, bring the at least one component into a state of being detached from the sheet.

19. The component mounting system according to any one of claims 1 to 3, wherein
the component feeder includes:
a sheet holder to hold a sheet on which an opposite side to the bonding surface side of each of a plurality of components is stuck;
a pickup mechanism to, by cutting out at least one component among the plurality of components from an opposite side to a side of the sheet on which the plurality of components is stuck, bring the at least one component into a state of being detached from the sheet;
a second component transporter including a second component holder, which is a Bernoulli chuck, to hold the at least one component in a non-contact state with the bonding surface side and configured to transport the second component holder to a receipt position of the first component transporter with the second component holder holding the component; and
an inverter to hold an opposite side to the bonding surface side of the component held by the second component holder and invert the component in such a way that the component has such an attitude that the bonding surface faces the first direction.

20. The component mounting system according to any one of claims 1 to 3, wherein
the component feeder includes:
a sheet holder to hold a sheet on which the bonding surface side of each of a plurality of components is stuck in such an attitude that the bonding surface faces the first direction side; and
a third component transporter including a third component holder to hold at least one component among the plurality of components from a side of the sheet on which the plurality of components is stuck and from an opposite side to the bonding surface side of the component and configured to transport the third component holder to a receipt position of the first component transporter with the third component holder holding the component.

21. The component mounting system according to any one of claims 8 to 20, wherein the sheet is an adhesive sheet that holds the component on a surface having adhesion.

22. The component mounting system according to claim 21, wherein
on the surface having adhesion, a material that has adhesive force reduced when being irradiated with ultraviolet rays is applied, and
the pickup mechanism includes an ultraviolet ray irradiator to, when the pickup mechanism cuts out at least one component from among the plurality of components stuck on the sheet, irradiate the sheet with ultraviolet rays.

23. The component mounting system according to claim 18, wherein
the sheet is an adhesive sheet that holds the component on a surface having adhesion and has a hole formed in each of regions in which the plurality of components is to be stuck, and
the pickup mechanism includes a component support pin to support the component and, by inserting the component support pin into the hole from an opposite side to a side of the sheet on which the plurality of components is stuck, brings at least one component among the plurality of components into a state of being detached from the sheet.

24. The component mounting system according to claim 23, wherein the component support pin is a suction post.

25. The component mounting system according to any one of claims 1 to 3, wherein
the component feeder includes:
a chip feeding head including a head body in which a recess is disposed and a suction hole to suck gas existing inside the recess is disposed on a bottom of the recess and at least one support provided on a bottom of the recess in a protruding manner; and a sucker to, when the component feeder feeds the component, detach the component from an adhesive sheet that holds the component on a surface having adhesion by reducing contact area between the adhesive sheet and the component by sucking gas existing in a space inside the recess through the suction hole with the chip feeding head in contact with a position on the adhesive sheet corresponding to the component.

26. The component mounting system according to any one of claims 1 to 3, wherein
the component feeder includes:
a tray including: a tray body in which a recess on an inside of which the component is arranged is disposed; at least one support provided in a protruding manner on a bottom of the recess; an adhesive sheet stretched at a position separated from the bottom in the recess and configured to hold the component on a surface having adhesion on an opposite side to the bottom; and a communication hole communicating with a space between a bottom of the recess and the adhesive sheet; and
a sucker to, when the component feeder feeds the component with the component held to the adhesive sheet, detach the component from the adhesive sheet by reducing contact area between the adhesive sheet and the component by sucking gas existing in the space through the communication hole.

27. The component mounting system according to any one of claims 1 to 3, wherein
the component feeder includes:
a tray including a tray body in which a recess on an inside of which each of the plurality of components is arranged is disposed; and
a pickup mechanism to, by cutting out at least one component among the plurality of components from an opposite side to a side of the tray on which the plurality of components is arranged, bring the at least one component into a state of being detached from the tray,
in the tray body, a through-hole penetrating the tray body in a thickness direction from a bottom of the recess is formed, and
the pickup mechanism includes a component support pin to support the component and, by inserting the component support pin into the through-hole from an opposite side to the recess side of the tray, brings at least one component among the plurality of components into a state of being detached from the tray.

28. The component mounting system according to any one of claims 1 to 3, wherein
the component feeder includes:
a pickup mechanism to cut out at least one component among the plurality of components; and
a second component transporter including a second component holder to hold the at least one component in a non-contact state with the bonding surface and configured to transport the second component holder to a receipt position of the first component transporter with the second component holder holding the component.

29. The component mounting system according to claim 28, wherein the second component holder is a Bernoulli chuck.

30. The component mounting system according to claim 28, wherein the second component holder is a non-contact chuck including: a chuck body in which a flow channel communicating with a side on which the second component holder holds the component is formed; a negative pressure generator to make pressure inside the flow channel negative; and an ultrasonic wave generator to generate ultrasonic waves between the chuck body and the component by vibrating the chuck body.

31. The component mounting system according to claim 29 or 30, wherein
the component feeder further includes
a sheet holder to hold a sheet on which an opposite side to the bonding surface side of each of a plurality of components is stuck, and
the pickup mechanism includes three or more component support pins or a plurality of long plate-shaped component support plates to support each of the at least one component in such an attitude that a bonding surface of each of the at least one component is parallel with a plane orthogonal to a vertical direction and transfers the at least one component to the second component holder by pushing out a portion of the sheet at which the at least one component is stuck to the second component holder side by use of the component support pins or the component support plates.

32. The component mounting system according to claim 31, wherein
the component feeder further includes
a suction unit to suck a portion of the sheet at which a component other than the at least one component, which is to be cut out by the pickup mechanism, is stuck from an opposite side to a side of the sheet on which the at least one component is stuck, and
the pickup mechanism pushes out a portion of the sheet at which the at least one component is stuck to the second component holder side with a portion at which a component other than the at least one component is stuck sucked by the suction unit by use of the component support pins or the component support plates.

33. The component mounting system according to claim 31 or 32, wherein the pickup mechanism, after separating the at least one component from the sheet by moving the three or more component support pins or the plurality of component support plates with tip portions of the three or more component support pins or the plurality of component support plates pressed against a portion of the sheet at which the at least one component is stuck, pushes out a portion of the sheet at which the at least one component is stuck to the second component holder side by use of the three or more component support pins or the plurality of component support plates.

34. The component mounting system according to claim 33, wherein the pickup mechanism includes the plurality of component support plates, and, after scraping the sheet by moving the plurality of component support plates in a direction in which the plurality of component support plates comes close to each other with tip portions of the plurality of component support plates pressed against a portion of the sheet at which the at least one component is stuck, moves the plurality of component support plates in a direction in which the plurality of component support plates separates away from each other and subsequently pushes out a portion of the sheet at which the at least one component is stuck to the second component holder side by use of the plurality of component support plates.

35. The component mounting system according to claim 31 or 32, wherein the pickup mechanism includes, in conjunction with the three or more component support pins, a plurality of separation pins to make the component easily separable from the sheet, and, after pressing tip portions of the plurality of separation pins against a portion of the sheet at which the at least one component is stuck with tip portions of the three or more component support pins pressed against a portion of the sheet at which the at least one component is stuck, detaches tip portions of the three or more component support pins from the sheet and subsequently pushes out a portion of the sheet at which the at least one component is stuck to the first component holder side by use of the component support pins with tip portions of the three or more component support pins pressed against a portion of the sheet at which the at least one component is stuck.

36. The component mounting system according to claim 34 or 35, wherein, when the pickup mechanism pushes out a portion of the sheet at which the at least one component is stuck to the first component holder side, the pickup mechanism sucks a portion of the sheet at which the at least one component is stuck from an opposite side to a side of the sheet on which the at least one component is stuck.

37. The component mounting system according to claim 31 or 32, wherein the pickup mechanism includes, in conjunction with the three or more component support pins, a plurality of separation members to make the component easily separable from the sheet and, after scraping the sheet by moving the plurality of separation members in a direction in which the plurality of separation members comes close to each other with tip portions of the plurality of separation members pressed against a portion of the sheet at which the at least one component is stuck, pushes out a portion of the sheet at which the at least one component is stuck to the first component holder side by use of the component support pins.

38. The component mounting system according to any one of claims 29 to 37, wherein
the component feeder or the second component transporter includes:
a plurality of hooks that is switched between a state of being hooked on a peripheral portion of the at least one component from a vertically lower side and a state of being detached from the at least one component; and
a hook driver to, when the pickup mechanism cuts out, from a plurality of components, at least one component among the plurality of component, cause the plurality of hooks to hold the at least one component by causing the plurality of hooks to be hooked on a peripheral portion on a vertically lower side of the at least one component from the vertically lower side.

39. The component mounting system according to any one of claims 1 to 38, wherein the head further includes a pressing mechanism to, by pressing a central portion of the component, cause the component to be bent in such a manner that a central portion of the bonding surface of the component protrudes to the mounting surface side compared with a peripheral portion of the bonding surface of the component.

40. The component mounting system according to any one of claims 1 to 39, wherein at least one of the mounting surface of the wiring board and the bonding surface of the component is surface-activated.

41. The component mounting system according to any one of claims 1 to 40 further comprising
a cleaner to clean the component,
wherein the first component transporter transports the first component holder holding the component fed from the component feeder to a cleaner handover position at which the component is handed over to the cleaner and also transports the first component holder holding the component received at the cleaner handover position to a transfer position at which the component is transferred to the head.

42. The component mounting system according to any one of claims 1 to 40, wherein
the first component transporter includes:
a plate that is formed in a long plate shape and one end of which turns with the other end, which is located between the component feeder and the head, as a fulcrum; and
an arm disposed to the plate, and
the first component holder is disposed at a tip portion of the arm.

43. The component mounting system according to claim 42 further comprising a cleaner to clean the component,
wherein the cleaner is arranged between the component feeder and the head when viewed from the fulcrum of the plate.

44. The component mounting system according to claim 42 or 43 further comprising a component collector to collect a component that was not able to be mounted on the mounting surface,
wherein the component collector is arranged at a position succeeding the head in a turning direction of the plate when viewed from the fulcrum of the plates.

45. A component mounting system to mount a component on a wiring board, comprising:
a component feeder to feed the component;
a cleaner to clean the component;
a head to hold, at a tip portion of the head, an opposite side to a bonding surface side of the component, the bonding surface being to be bonded to a mounting surface of the wiring board;
a wiring board holder to hold the wiring board; and
a head driver to mount the component on the mounting surface by, with the component, which has been cleaned by the cleaner, held at a tip portion of the head, moving the head relatively in a first direction, the first direction pointing from the head to the wiring board holder, and bringing a bonding surface of the component into contact with the mounting surface of the wiring board.

46. A component feeding device comprising:
a sheet holder to hold a sheet, the sheet being stuck on an opposite side to a bonding surface side of each of a plurality of components, the bonding surface being to be bonded to a wiring board; and
a pickup mechanism to cut out, from among a plurality of components, at least one component among the plurality of components,
wherein the pickup mechanism includes three or more component support pins or a plurality of long plate-shaped component support plates and, after separating the at least one component from the sheet by moving the three or more component support pins or the plurality of component support plates with tip portions of the three or more component support pins or the plurality of component support plates pressed against a portion of the sheet at which the at least one component is stuck, pushes out a portion of the sheet at which the at least one component is stuck by use of the three or more component support pins or the plurality of component support plates.

47. The component feeding device according to claim 46, wherein the pickup mechanism includes the plurality of component support plates, and, after scraping the sheet by moving the plurality of component support plates in a direction in which the plurality of component support plates come close to each other with tip portions of the plurality of component support plates pressed against a portion of the sheet at which the at least one component is stuck, moves the plurality of component support plates in a direction in which the plurality of component support plates separate away from each other and subsequently pushes out a portion of the sheet at which the at least one component is stuck by use of the plurality of component support plates.

48. The component feeding device according to claim 46, wherein the pickup mechanism includes, in conjunction with the three or more component support pins, a plurality of separation pins to make the component easily separable from the sheet, and, after pressing tip portions of the plurality of separation pins against a portion of the sheet at which the at least one component is stuck with tip portions of the three or more component support pins pressed against a portion of the sheet at which the at least one component is stuck, detaches tip portions of the three or more component support pins from the sheet and subsequently pushes out a portion of the sheet at which the at least one component is stuck by use of the component support pins with tip portions of the three or more component support pins pressed against a portion of the sheet at which the at least one component is stuck.

49. The component feeding device according to any one of claims 46 to 48, wherein, when the pickup mechanism pushes out a portion of the sheet at which the at least one component is stuck, the pickup mechanism sucks a portion of the sheet at which the at least one component is stuck from an opposite side to a side of the sheet on which the at least one component is stuck.

50. The component feeding device according to any one of claims 46 to 49, wherein
the sheet is an adhesive sheet that holds the component on a surface having adhesion,
on the surface having adhesion, a material that has adhesive force reduced when being irradiated with ultraviolet rays is applied, and
the pickup mechanism includes an ultraviolet ray irradiator to, when the pickup mechanism cuts out at least one component from among the plurality of components stuck on the sheet, irradiate the sheet with ultraviolet rays.

51. A component mounting method for mounting a component on a wiring board, the method comprising:
a step of feeding the component;
a step of, with the component held by a first component holder to hold a second part on an opposite side to a bonding surface side of the fed component, the second part being different from a first part, the bonding surface being to be bonded to a mounting surface of the wiring board, transporting the first component holder to a transfer position at which the component is transferred to a head;
a step of transferring the component from the first component holder to the head by moving a component support, the component support being disposed at a tip portion of the head and being configured to support the first part of the component, relatively to a first direction side of the first component holder, the first direction pointing from the head to a wiring board holder to hold the wiring board, with the first component holder, which holds the component, located at the transfer position; and
a step of mounting the component on the mounting surface by, with the component, which has been transferred to the head, held at a tip portion of the head, moving the head relatively in the first direction and bringing a bonding surface of the component into contact with the mounting surface of the wiring board.

52. The component mounting method according to claim 51, wherein
in the step of feeding the component, from among a plurality of components, the method holds a third part on an opposite side to the bonding surface side of at least one component among the plurality of components, the third part being different from a first part, and cuts out the component, and
in the step of transporting the first component holder to the transfer position, the method, by holding the second part, receives the component.

53. A component mounting method for mounting a component on a wiring board, the method comprising:
a step of feeding the component;
a step of, with the component held by a first component holder to hold a bonding surface side of the fed component in a non-contact manner, the bonding surface being to be bonded to a mounting surface of the wiring board, transporting the first component holder to a transfer position at which the component is transferred to a head; and
a step of mounting the component on the mounting surface by, with the component, which has been transferred to the head, held at a tip portion of the head, moving the head relatively in a first direction, the first direction pointing from the head to a wiring board holder holding the wiring board, and bringing a bonding surface of the component into contact with the mounting surface of the wiring board.

54. The component mounting method according to claim 53, wherein
in the step of feeding the component, the method cuts out, from among a plurality of components, at least one component among the plurality of components, and
the first component holder is a Bernoulli chuck that holds the at least one component in a non-contact state with the bonding surface.

55. The component mounting method according to claim 53, wherein
in the step of feeding the component, the method cuts out, from among a plurality of components, at least one component among the plurality of components, and
the first component holder is a non-contact chuck including a chuck body in which a flow channel communicating with a side on which the first component holder holds the component is formed, a negative pressure generator to make pressure inside the flow channel negative, and an ultrasonic wave generator to generate ultrasonic waves between the chuck body and the component by vibrating the chuck body and configured to hold the at least one component in a non-contact state with the bonding surface.

56. The component mounting method according to any one of claims 53 to 55, wherein, in the step of feeding the component, with the component held by a second component holder to hold the at least one component in a non-contact state with the bonding surface, the method transports the second component holder to a position at which the first component holder receives the component.

57. The component mounting method according to claim 56, wherein the second component holder is a Bernoulli chuck that holds the at least one component in a non-contact state with the bonding surface.

58. The component mounting method according to claim 56, wherein the second component holder is a non-contact chuck including a chuck body in which a flow channel communicating with a side on which the second component holder holds the component is formed, a negative pressure generator to make pressure inside the flow channel negative, and an ultrasonic wave generator to generate ultrasonic waves between the chuck body and the component by vibrating the chuck body and configured to hold the at least one component in a non-contact state with the bonding surface.

59. The component mounting method according to any one of claims 51 to 58, wherein
in the step of feeding the component, the method cuts out, from among a plurality of components, at least one component among the plurality of components, and
the component mounting method further comprises:
a step of, before transporting the cut-out at least one component to the transfer position, cleaning the component at a cleaner to clean the component; and
a step of transporting the component after cleaning by the cleaner to the transfer position.

60. A component mounting method for mounting a component on a wiring board, the method comprising:
a step of feeding the component;
a step of cleaning the component at a cleaner to clean the component; and
a step of mounting the component on a mounting surface by, with the component, which has been cleaned by the cleaner, held at a tip portion of a head, moving the head relatively in a first direction, the first direction pointing from the head to a wiring board holder holding the wiring board, and bringing a bonding surface of the component into contact with the mounting surface of the wiring board.

61. The component mounting method according to any one of claims 51 to 60, wherein
the plurality of components is stuck on a sheet that holds the components on a surface having adhesion,
on the surface having adhesion, a material that has adhesive force reduced when being irradiated with ultraviolet rays is applied, and
in the step of feeding the component, when at least one component is cut out from among a plurality of components stuck on the sheet, the method irradiates the sheet with ultraviolet rays.
